(19) Europäisches Patentamt
European Patent Office
Office européen des brevets

(11) Veröffentlichungsnummer: **0 047 868**
**B1**

(12) # EUROPÄISCHE PATENTSCHRIFT

(45) Veröffentlichungstag der Patentschrift: **22.04.87**

(51) Int. Cl.⁴: **G 01 R 13/22**, G 01 R 13/20, G 09 F 9/00

(21) Anmeldenummer: **81106384.1**

(22) Anmeldetag: **17.08.81**

(54) **Verfahren und Vorrichtung zum Erzeugen von x,y,z-Koordinatensignalen für ein x-, y-, z-Darstellungsgerät.**

(30) Priorität: **12.09.80 US 186539**

(43) Veröffentlichungstag der Anmeldung: **24.03.82 Patentblatt 82/12**

(45) Bekanntmachung des Hinweises auf die Patenterteilung: **22.04.87 Patentblatt 87/17**

(84) Benannte Vertragsstaaten: **BE CH DE FR GB IT LI NL**

(56) Entgegenhaltungen:
**FR - A - 2 472 799**
**US - A - 3 636 551**
**US - A - 3 872 461**

(73) Patentinhaber: **Siemens Aktiengesellschaft Berlin und München, Wittelsbacherplatz 2, D-8000 München 2 (DE)**

(72) Erfinder: **Neumann, Leopold, 9 Woodpark Circle, Lexington Massachusetts 02173 (US)**
Erfinder: **Kline II, Richard B., 25 Dean Street, Stoneham Massachusetts 02180 (US)**
Erfinder: **McMorrow, Richard H., Jr., Trapelo Road, Lincoln Massachusetts 01773 (US)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

## Beschreibung

Die Erfindung bezieht sich auf ein Verfahren zum Erzeugen von x-, y- und z-Koordinatensignalen zur Darstellung von Analogsignalen und Zeichensignalen in verschiedenen Bildabschnitten eines x-, y-, z-Darstellungsgeräts, das an eine Übertragungsleitung angeschlossen ist, wobei das x-Koordinatensignal die Zeitablenkung auf dem Bildschirm, also die dortige x-Achse, das y-Koordinatensignal die Höhe der Ablenkung auf dem Bildschirm, also die dortige y-Achse, und das z-Koordinatensignal die Helligkeit der im x-, y-Koordinatensystem dargestellten Information bestimmen, sowie auf eine Vorrichtung zur Durchführung des Verfahrens.

Unter den Begriff x-, y-, z-Darstellungsgerät fallen insbesondere x-, y-, z-Oszilloskope. Es soll jedoch auch jede Art von x-, y-, z-Schreibern mitumfasst sein, die zur Aufzeichnung von Signalen mittels Schreibstift oder Schreibstrahl, insbesondere Tintenstrahl bei Tintenstrahlschreibern, im x-, y-, z-Mode geeignet sind.

Die Erfindung kann auf einem beliebigen Gebiet, auf dem Messsignale gewonnen werden und die gewonnenen Messsignale auf Darstellungsgeräten zur Darstellung gebracht werden sollen, angewendet werden. Von allen möglichen Anwendungsgebieten ist jedoch das bevorzugte Anwendungsgebiet für die Erfindung das Gebiet der Elektromedizin. Auf dem Gebiet der Elektromedizin werden einem Patienten über Messabnehmer in vielfältiger Form Körpersignale abgenommen, die Auskunft über das Befinden des Patienten geben. Solche Körpersignale, die auch als physiologische Signale bezeichnet werden, z.B. Signale für Elektrokardiogramm (EKG), Blutdruck, Atemsignale, Temperatur, $CO_2$-Gehalt (Kohlendioxid) im Blut oder Atemgas, etc., werden normalerweise auf einem geeigneten Darstellungsgerät, z.B. Oszilloskop oder Schreiber, dargestellt.

Die Darstellung von Messsignalen, insbesondere von Körpersignalen eines Patienten, auf einem x-, y-, z-Darstellungsgerät bringt an sich keine Probleme, wenn für jeden Messort, also z.B. für jeden einzelnen Patienten, ein eigenes Darstellungsgerät benutzt wird, das völlig unabhängig von Darstellungsgeräten anderer Messorte, also z.B. anderer Patienten, arbeitet.

Ein erstes Problem tritt jedoch bereits dann auf, wenn Darstellungsgeräte, die unterschiedlichen Messorten zugeordnet sind, in Verbindung mit einer Zentrale oder auch untereinander so gekoppelt sein sollen, dass es möglich ist, Signalbilder des einen Darstellungsgerätes zu einer Zentrale oder einem anderen Darstellungsgerät mit einem möglichst geringen technischen Aufwand und zudem noch verzerrungsfrei zu übertragen.

Zu diesem ersten Problem gesellt sich ein zweites Problem dann, wenn zusätzlich zu den üblicherweise in analoger Form anfallenden Messsignalen auch noch alphanumerische Zeichen (wie Zahlen, Buchstaben oder sonstige Symbole) zwischen einzelnen Darstellungsgeräten oder aber zwischen Darstellungsgeräten und einer Zentrale übertragen und sodann dargestellt werden sollen.

Bisher konnten derartige Signalgemische aus Analogsignalen und alphanumerischen Zeichensignalen ohne allzu grossen technischen Aufwand nur innerhalb von Ketten mit Fernsehmonitoren übertragen werden. Die Bildauflösung von Fernsehmonitoren ist jedoch bekanntlich gering. Sie genügt insbesondere im Medizinbereich nicht dem dort gewünschten Grad der Bildauflösung physiologischer Signale.

Eine hinreichend gute Bildauflösung gestatten hingegen bekanntlich einfache x-, y-, z-Darstellungsgeräte, insbesondere normale x-, y-, z-Oszilloskope. Hier wurden auch schon Analogsignale und Zeichensignale mit hohem Auflösungsgrad gemeinsam dargestellt. Die Darstellung erfolgte jedoch allein mit Einzelgerät. Eine Zusammenschaltung mit anderen Geräten mit der Möglichkeit einer Bildübertragung zwischen den Geräten verbot sich bisher aufgrund unüberwindbarer technischer Schwierigkeiten. Bekanntlich sind nämlich Helltastimpulse, wie sie für die z-Steuerung des x-, y-, z-Darstellungsgerätes zur Darstellung eines alphanumerischen Zeichens benötigt werden, sehr hochfrequent und breitbandig. Eine Übertragung socher Zeichen zwischen einzelnen Darstellungsgeräten war wegen der sehr unterschiedlichen Frequenzlaufzeiten, die aus den sehr unterschiedlichen Verzögerungszeiten in den Übertragungswegen zwischen den einzelnen Darstellungsgeräten resultieren, mit vertretbar niedrigem technischen Aufwand verzerrungsfrei kaum realisierbar.

Ein Verfahren und eine Vorrichtung der eingangs genannten Art sind aus der US-A-3 872 461 bekannt. Dort werden gleichfalls analoge Signale und Symbole oder Zeichen auf einem Bildschirm dargestellt. Doch erfolgt dort die Darstellung der beiden Signaltypen zwangsweise übereinander, was für viele Anwendungsfälle eine untragbare Beschränkung ist. Dem bekannten Gerät werden lediglich analoge Informationen zugeleitet. Diese werden in einem Verarbeitungskreis in entsprechende Zahlenwerte oder Symbole umgesetzt und zusammen mit letzteren dargestellt. Mit anderen Worten: Die Zahlenwerte und/oder Symbole werden zwangsläufig aus den analogen Signalen hergeleitet. Auch dies stellt für viele Anwendungsfälle eine unzumutbare Beschränkung der Signaldarstellung dar. Gewünscht ist eine wesentlich flexiblere Handhabung.

Ausgehend hiervon ist es Aufgabe der Erfindung, ein Verfahren und eine Vorrichtung anzugeben, mit denen sich für ein x-, y-, z-Darstellungsgerät mit hohem Grad der Bildauflösung x-, y- und z-Koordinatensignale so erzeugen lassen, dass sich am Darstellungsgerät in technisch einfacher Weise ein Signalbild ergibt, das sich in zeitlich gegliederten Abschnitten in überschaubarer Weise aus Analogsignalen und alphanumerischen Zeichen zusammensetzt.

Weitere Aufgabe der Erfindung ist es, das Verfahren für ein einzelnes x-, y-, z-Darstellungsgerät so zu gestalten, dass bei Zusammenschaltung einer Mehrzahl solcher Darstellungsgeräte in beliebiger Konfiguration, d.h. mit oder ohne Zentrale, eine Signalbildübertragung zwischen einzelnen Darstellungsgeräten oder aber zwischen Darstellungsgeräten und einer Zentrale möglich wird, die hohe Bildauflösung gewährleistet und die dennoch wenig technischen Aufwand erfordert.

Schliesslich ist es auch Aufgabe der Erfindung, eine technisch besonders einfache Vorrichtung anzugeben, die nach dem erfindungsgemässen Verfahren arbeitet.

Diese Aufgabe wird mit einem Verfahren gelöst, das erfindungsgemäss folgende Schritte aufweist:

a. Zunächst wird über die Übertragungsleitung zum Darstellungsgerät ein Startsignal gegeben,

b. dann wird in zeitlicher Abhängigkeit von diesem Startsignal das x-Koordinatensignal mit fest vorgegebener Form im Darstellungsgerät selbst erzeugt,

c. nach Auftreten des Startsignals wird ausserdem in zeitlicher Abhängigkeit von diesem Startsignal das y-Koordinatensignal erzeugt, das zeitabschnittsweise

c1. aus Signalen mit fest vorgegebener Form, die im Darstellungsgerät selbst erzeugt werden und die sich von der Form des x-Koordinatensignals unterscheiden, und

c2. aus Pausen zwischen diesen Signalen besteht, wobei in diese Pausen die Analogsignale über die Übertragungsleitung eingegeben werden,

d. nach Auftreten des Startsignals wird darüber hinaus in zeitlicher Abhängigkeit von diesem Startsignal das z-Koordinatensignal erzeugt, das zeitabschnittsweise

d1. aus Signalen mit fest vorgegebener Form, die im Darstellungsgerät selbst erzeugt werden und die sich von den Formen der x- und y-Koordinatensignale unterscheiden, sowie

d2. aus Pausen zwischen diesen Signalen besteht, wobei in diesen Pausen die Zeichensignale in die Übertragungsleitung eingegeben werden, und wobei die Pausen und Signale des z-Koordinatensignals gegenüber den Pausen und Signalen des y-Koordinatensignals zeitversetzt sind.

Eine Vorrichtung zur Durchführung des Verfahrens ist erfindungsgemäss gekennzeichnet durch

a. einen Startsignalgenerator ausserhalb des Darstellungsgerätes zur wiederholten Erzeugung eines Startsignals,

b. einen x-Spannungsgenerator innerhalb des Darstellungsgerätes zur Erzeugung des x-Koordinatensignals jeweils in zeitlicher Abhängigkeit vom Startsignal,

c. einen y-Spannungsgenerator innerhalb des Darstellungsgerätes zur Erzeugung des y-Koordinatensignals, das zeitabschnittsweise

c1. aus Signalen mit fest vorgegebener Form, die im Darstellungsgerät selbst erzeugt werden und die sich von der Form des x-Koordinatensignals unterscheiden, und

c2. aus Pausen zwischen diesen Signalen besteht,

d. einen z-Spannungsgenerator innerhalb des Darstellungsgerätes zur Erzeugung des z-Koordinatensignals, das zeitabschnittsweise d1. aus Signalen mit fest vorgegebener Form, die im Darstellungsgerät selbst erzeugt werden und die sich von den Formen der x- und y-Koordinatensignale unterscheiden, sowie

d2. aus Pausen zwischen diesen Signalen besteht,

e. einen ersten Signalgeber ausserhalb des Darstellungsgerätes, der die Analogsignale liefert,

f. einen zweiten Signalgeber ausserhalb des Darstellungsgerätes, der die Zeichensignale liefert, und

g. eine Signalsteuereinrichtung, g1. die in die Pausen zwischen den im Darstellungsgerät selbst erzeugten Signalen des y-Koordinatensignals die Analogsignale in die Signaldarstellung eingibt, und

g2. die in den zu diesen Pausen zeitversetzten Pausen zwischen den im Darstellungsgerät selbst erzeugten Signalen des z-Koordinatensignals die Zeichensignale in die Signaldarstellung eingibt.

Die Erfindung nutzt die Erkenntnis, dass die zu erzeugenden x-, y-, z-Koordinatensignale immer wenigstens teilweise solche Signalanteile beinhalten, die als sogenannte «geräteeigene» Signalgrössen im Darstellungsgerät selbst erzeugt werden können. So umfasst jedes Darstellungsgerät einen Generator («x-Spannungsgenerator») für die x-Ablenkung. Es reicht also aus, wenn lediglich zur Auslösung einer x-Ablenkung über die Übertragungsleitung ein Startsignal gegeben wird. Dasselbe gilt für «geräteeigene» Signalgrössen im y-Koordinatensignal und im z-Koordinatensignal. Auch hier kann jede dieser Grössen im Darstellungsgerät in geeigneter zeitlicher Abhängigkeit vom Startsignal selbst erzeugt werden. Übersendet zu werden braucht nur die jeweilige Informationsvariable (Analogsignal oder Zeichensignal) mit dem Zweck der Einspielung am Darstellungsgerät in den Pausen zwischen den im Darstellungsgerät selbst erzeugten «geräteeigenen» y- und z-Signalen.

Im Falle der Einspielung der Analogsignale kann das z-Koordinatensignal konstant ungleich Null sein, d.h. der Schreibstrahl des Darstellungsgerätes (z.B. der Elektronenstrahl beim x-, y-, z-Oszilloskop) ist während der Zeitdauer der Einspielung der Analogsignale dauernd aufgeblendet. Zusammen mit dem Analogsignal (oder bei Mehrkanal-Darstellungsgeräten zusammen mit mehreren Analogsignalen) werden auch noch alphanumerische Zeichen, wie insbesondere Grössenwerte oder Grenzwerte der Analogsignale oder auch Bettnummern von Patienten, in Form von Zahlen und/oder Buchstaben dargestellt. Diese brauchen bei Anwendung der Erfindung nicht selbst zum Darstellungsgerät übertragen zu werden. Es genügt vielmehr, wenn im jeweiligen Darstellungsgerät ein Zeichengenerator fest installiert ist. Dann brauchen in den Pausen der Analogsignalübertragung als Zeichensignale lediglich digitale Adress-Signale übertragen zu werden. Diese Adress-Signale sprechen im Zeichengenerator Zeichen-Adressen an; der Zeichengenerator erzeugt daraufhin entsprechend der angesproche-

nen Adresse Tastsignale für einen Helltastgenerator, der in Synchronität mit einem gleichzeitig erzeugten y-Raster am Darstellungsgerät Zeichen-Helltastsignale erzeugt. Das y-Raster ist dabei nichts anderes als jenes Signal innerhalb des y-Koordinatensignals, das in zeitlicher Abhängigkeit vom jeweiligen Startsignal erzeugt wird.

Die Erfindung erlaubt also den Aufbau eines Signalbildes aus Analogsignalen und Zeichensignalen über einen einzigen Signalweg praktisch ohne nennenswerten Zeitverlust und verzerrungsfrei. Die Darstellung der Signale einschliesslich der Zeichen erfolgt im x-, y-, z-Mode. Damit ergibt sich auch eine gute Signalauflösung bei der Signaldarstellung. Der Fluss aller Signale ist kontinuierlich. Demnach stehen in jedem einzelnen Gerät alle nötigen Signalkomponenten als sogenannter Video-Signalzug (Composite Video Signal) zur fliessenden Darstellung am geräteeigenen x-, y-, z-Oszilloskop zur Verfügung. Der Video-Signalzug (Composite Video Signal) kann aber auch einem speziellen Geräteausgang (Composite Video Output) zugeführt werden. Von dort kann er dann auf einen Composite Video Signal Bus gegeben werden. Soll dann z.B. bei Bedarf, d.h. insbesondere im Alarmfall an einem der Geräte, das Ausgangssignal des jeweiligen Gerätes auf ein anderes Gerät (z.B. direkt oder über eine Zentrale) gegeben werden, so braucht lediglich mittels Schalter oder dgl. der spezielle Geräteausgang (Composite Video Output) des einen (z.B. alarmgebenden) Gerätes über den entsprechenden Composite Video Signal Bus mit einem speziellen Geräteeingang (Composite Video Input) des anderen Gerätes verbunden zu werden. In einem solchen Fall erscheint dann im Aufzeichnungsteil des angeschalteten Gerätes jenes Signal, das gerade am anderen Gerät (also z.B. jenem des Alarmfalles) aufgezeichnet wird.

Besteht eine Geräte-Konfiguration dabei z.B. aus einer Vielzahl einzelner Bettseit-Geräte, die sternförmig mit einer Zentrale verbunden sind, so werden gemäss einer Ausgestaltung der Erfindung die speziellen Geräteausgänge (Composite Video Output) des Gerätes sternförmig zur Zentrale geführt, von der dann über einen zentralen Ausgang (Central Composite Video Output) ein zentraler Composite Video Signal Bus zu den speziellen Eingängen der einzelnen Geräte zurückgeführt wird. Im Falle einer Kettenschaltung ohne separate Zentrale liegen hingegen alle Bettseit-Geräte an einem einzigen Bus, wobei speziell dasjenige Gerät der Kette immer die Rolle einer Zentrale übernimmt, das gerade zur Übernahme der Aufzeichnung eines anderen Gerätes an den Bus angeschaltet wird.

In bevorzugter Ausgestaltung der Erfindung wird zum Starten einer x-Ablenkung jeweils ein Synchronisiersignal (x-Synchronizing Pulse) gegeben, auf das innerhalb einer vorgebbaren Zeitdauer, z.B. 80 µs, das y-Konfigurationssignal (y-sweep configuration word) folgt. Dieses y-Konfigurationssignal legt sämtliche folgenden y-Komponenten entsprechend dem abzubildenden Originalbild eines anderen Gerätes in orts-, form- und zeitgerechter Positionierung am angesteuerten Gerät fest. Die y-Konfigurationssignale sind digitale Signale, die eine Information über Wechsel- und Gleichanteil kodiert übertragen, während das angesteuerte Gerät die zugehörigen Gleichanteile und das Muster des jeweiligen y-Rasters entsprechend dem übertragenen Code von selbst erzeugt. Auf das y-Konfigurationssignal folgt dann in zweckmässiger Weise eine erste Folge von digitalen Zeichenadressen für eine erste Zeichendarstellung. Die digitalen Zeichenadressen werden also während jener Zeitdauer übertragen, in dem im Empfangsgerät gleichzeitig ein rasches y-Zeichenraster erzeugt wird. Die Adressen richten sich an einen Zeichengenerator, der in zeitlicher Synchronität mit dem Ablenkraster die Taktimpulse (insbesondere Helltastimpulse) zum Aufbau der Zeichen erzeugt. Während der Zeitdauer eines raschen y-Zeichenrasters können neben den zum Aufbau des Zeichens benötigten Zeichenadressen auch sonstige wichtige Informationen (betreffend z.B. Amplitudennormierung, statische Daten für Modulkonfiguration, Quelleninstruktionen, Bettennummern, Alarm, etc.) kodiert übertragen werden. Die Organisation des Systems ist vorzugsweise so gewählt, dass sich der Datenfluss modulkonform bei jedem Modulwechsel im sendenden Gerät automatisch mit dem neu eingesteckten Modul ändert.

Weitere Vorteile und Einzelheiten der Erfindung ergeben sich aus der nachfolgenden Beschreibung eines bevorzugten Ausführungsbeispiels anhand der Zeichnung in Verbindung mit den weiteren Patentansprüchen.

Es zeigen:

Figur 1 die Erfindung im Ablaufdiagramm für drei Koordinaten x, y, z, einer Signalkombination,

Figur 2 eine Aufzeichnung von Analogsignalen und Zeichensignalen gemäss der Erfindung auf dem Bildschirm eines x, y, z-Oszilloskops,

Figur 3 eine Aufzeichnung ähnlicher Art mit Grenzwerten,

Figur 4 den Zeitablauf der Signalfolge während einer x-Ablenkung,

Figur 5 die Anwendung der Erfindung auf ein elektromedizinisches Überwachungsgerät im Prinzipschaltbild,

Figur 6 die Erfindung im Prinzipschaltbild (als Detail eines Überwachungsgerätes gemäss Figur 5),

Figur 7 die Anwendung der Erfindung auf eine Anordnung von Einzelgeräten in Reihenschaltung ohne gemeinsame zusätzliche Zentrale,

Figur 8 die Anwendung der Erfindung auf eine Anordnung von Einzelgeräten in Sternschaltung zu einer gemeinsamen zusätzlichen Zentrale,

Figur 9 einen zentralen Multiplexer als Bestandteil der Zentrale der Sternschaltung gemäss Figur 8,

Figur 10 eine Steuereinrichtung für Daten- und Adress-Steuerung zwischen zentralem Multiplexer und einem zentralen Bildwiederholungsspeicher als Bestandteil der Zentrale der Sternschaltung gemäss Figur 8,

Figur 11 ein Diagramm für digitale Signalübertragung in der Rückführphase (retrace time) der x-Ablenkung (als weitere Ausgestaltung des Diagramms der Figur 4),

Figur 12 den mechanischen Prinzipaufbau eines elektromedizinischen Überwachungsgerätes mit vier Einschubmodulen, so wie es in Verbindung mit der Erfindung bevorzugt als Bettseit-Gerät eingesetzt wird, in perspektivischer Ansicht,

Figur 13 den prinzipiellen inneren Schaltungsaufbau eines Einschubmoduls (hier insbesondere kombinierter EKG/Blutdruck-Modul),

Figur 14 den prinzipiellen inneren Schaltungsaufbau des Kontroll- und Ankoppelboards, wie es den Einschüben zur Signal- und Energieankopplung auf der Seite des Gerätes gegenübersteht,

Figur 15 ein Pulsdiagramm der wichtigsten Pulsfolgen, so wie sie zwischen Einschubmodulen und Gerät in der einen und in der anderen Richtung übertragen werden,

Figur 16 das Zusammenspiel zwischen vorverarbeitendem Mikroprozessor (preprocessor), Hauptspeicher (shared memory) und zentralem Mikroprozessor (central processor) eines Gerätes gemäss Figur 5 im detaillierten Prinzipschaltbild,

Figur 17 die Signal- und Zeichendarstellung der Figur 2 mit wanderndem Vertikalbalken als Grenze zwischen neuer und alter Signalinformation bei fixed mode-Betrieb, und

Figur 18 das Prinzipschaltbild zur Erzeugung eines Vertikalbalkens gemäss Figur 17.

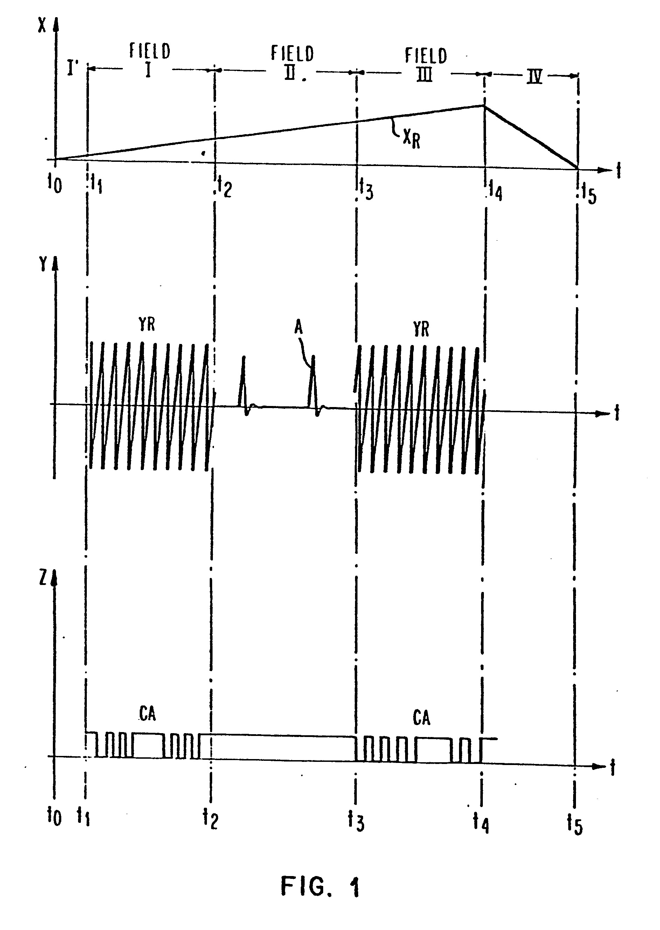

In der Figur 1 sind die drei Koordinateninformationen für jede Signalperiode in Abhängigkeit von der Zeit t übereinander als X(t), Y(t), Z(t) dargestellt. Jeder Koordinatenverlauf ist in Zeitabschnitte I′, I, II, III, IV (durch Ordinate und strichpunktierte Linien zu den Zeitpunkten $t_0$, $t_1$, $t_2$, $t_3$, $t_4$, $t_5$ angedeutet) unterteilt. Der Abschnitt I′ dient zur Übertragung eines später noch näher beschriebenen y-Konfigurationswortes im Anschluss an die Auslösung einer x-Ablenkung. Der Abschnitt IV ist die später ebenfalls noch näher erläuterte Rückführphase (retrace time) der z-Ablenkung eines Elektronenstrahles eines x-, y-, z-Oszilloskops im jeweiligen Gerät. Die Abschnitte I, II, III sind die Hauptabschnitte zur Aufzeichnung von alphanumerischen Zeichen und von Analogsignalen. Sie werden im folgenden auch als «Felder» (fields) für Analog- oder Zeichendarstellung bezeichnet. Gemäss dem Diagramm der Figur 1 beginnt also zum Zeitpunkt $t_0$ die x-Ablenkung mit der Sägezahn- oder Rampenspannung $X_R$. Nach Übertragung des y-Konfigurationswortes im Abschnitt I′ folgt zum Zeitpunkt $t_1$ ein schnelles y-Raster $Y_R$. Dieses Raster ist Grundlage für eine Zeichendarstellung. Die beiden Grössen x und y sind im Feld I als Sägezahn- oder Rampenspannungen systemeigene konstante Grössen, die im Gerät selbst erzeugt werden. Eine selbständige Übertragung solcher Raster zum einzelnen Gerät über eine gemeinsame Signalleitung (Signal Bus) erübrigt sich also. Es brauchen lediglich die zur Auslösung der Sägezahn- oder Rampenspannungen $X_R$ und $Y_R$ nötigen Auslösesignale in Form eines x-Synchronisiersignales bzw. eines y-Konfigurationssignales weitergereicht werden. Das Vorliegen zweier systemkonstanter Koordinaten x, y im Feld I kann jedoch dazu ausgenutzt werden, über eine gemeinsame Signalleitung (Signal Bus) Adress-Signale für einen Zeichengenerator zu übertragen, der sich im jeweiligen Gerät befindet. Aufgrund dieser Adress-Signale, die in Digitalform übertragen werden, bildet der Zeichengenerator im jeweils angesteuerten Gerät Helltastsignale, die in zeitlicher Synchronität mit dem gleichzeitig im Gerät erzeugten raschen y-Zeichenraster am Bildschirm eines x-, y-, z-Oszilloskops zu den gewünschten alphanumerischen Zeichen zusammengesetzt werden. Die im Informationsabschnitt I zu übertragenden Adress-Signale für den Zeichengenerator sind in Figur 1 für die Koordinate z als digitale Signale CA (Character Addresses) angegeben.

Signifikante Eigenschaft des Abschnittes I (Feld I) ist also, dass die Koordinaten x und y systemeigen konstant sind, während die Koordinate z systemfremd und variabel ist. Da jedoch zwei Koordinatengrössen konstante Grössen sind, kann die dritte variable Grösse z über die gemeinsame Signalleitung zum jeweiligen Gerät übertragen werden.

Im Informationsabschnitt II (Feld II) der Diagramme der Figur 1 ergibt sich hingegen eine geänderte Situation. Neben der dauernd systemkonstanten x-Koordinate ist jetzt die y-Koordinate als Übertragungsabschnitt eines Analogsignales A (z.B. EKG) systemfremd und variabel. Damit handelt es sich also bei der Koordinate y im Falle des Feldes II nicht um eine systemeigene konstante Grösse; um diese Grösse A übertragen zu können, muss neben der x-Koordinate im Feld II auch die z-Koordinate systemeigen und konstant sein. Dies ist sie auch, denn gemäss dem unteren Diagramm der Figur 1 zeigt die z-Koordinate im Informationsabschnitt II konstanten Spannungsverlauf.

Betreffend Feld III ergeben sich zwei Möglichkeiten: Hier kann einerseits bei Bedarf jener Signalverlauf, wie er sich für Feld II ergab, für alle drei Koordinaten x, y, z unverändert beibehalten werden. Dementsprechend würde also im Feld III bei konstanter Spannung der z-Koordinate die Analoggrösse A im Signalweg als y-Komponente fortgesetzt übertragen werden.

Andererseits kann jedoch auch auf Abbildung entsprechend dem Muster des Feldes I rückgeschaltet werden. In diesem Falle wird also im Feld III hinsichtlich der y-Koordinate wieder ein rasches y-Ablenkraster $Y_R$ für Zeichendarstellung erzeugt und im Signalweg zu den Geräten werden während dieser Zeitdauer als z-Komponente also wieder Adress-Signale CA zur korrekten Adressierung im Zeichengenerator übertragen.

Die Darstellung der Figur 1 ist lediglich beispielhaft. Es ist selbstverständlich, dass die einzelnen Felder I bis III beliebig variabel aneinandergereiht werden können. Ebensogut kann die Zahl sämtlicher Felder von drei abweichend vorgegeben werden. Dabei können in unterschiedlichen Feldern wahlweise Analogsignale zusammen mit Zeichen dargestellt werden. Es können aber in einer einzigen Spur auch nur Analogsignale oder nur Zeichen abgebildet werden. Wie eingangs schon angedeutet, kann der den Hauptfeldern I bis III vorangehende Abschnitt I′ allein zur Übertragung eines y-Konfigurationssignales verwendet werden. Es ist wieder selbstverständlich, dass zusätzlich zum Konfigurationssignal in diesem Abschnitt auch noch weitere beliebig gestaltete Befehlssignale übertragen werden können. Derartige zusätzliche Signale können aber auch, wie eingangs ebenfalls schon angedeutet, in jene Phase gelegt werden (z.B. Felder I und/oder III), in denen zur Zeichendarstellung rasche y-Raster erzeugt werden. Die zusätzlichen Befehlssignale werden dann zusammen mit den digitalen Adress-Signalen CA in zweckmässig gemischter Form über den gemeinsamen Signalweg übertragen. Darüber hinaus können derartige zusätzliche Signale auch in der Phase IV, d.h., in der Rückführphase des Elektronenstrahls nach einer x-Ablenkung, übertragen werden.

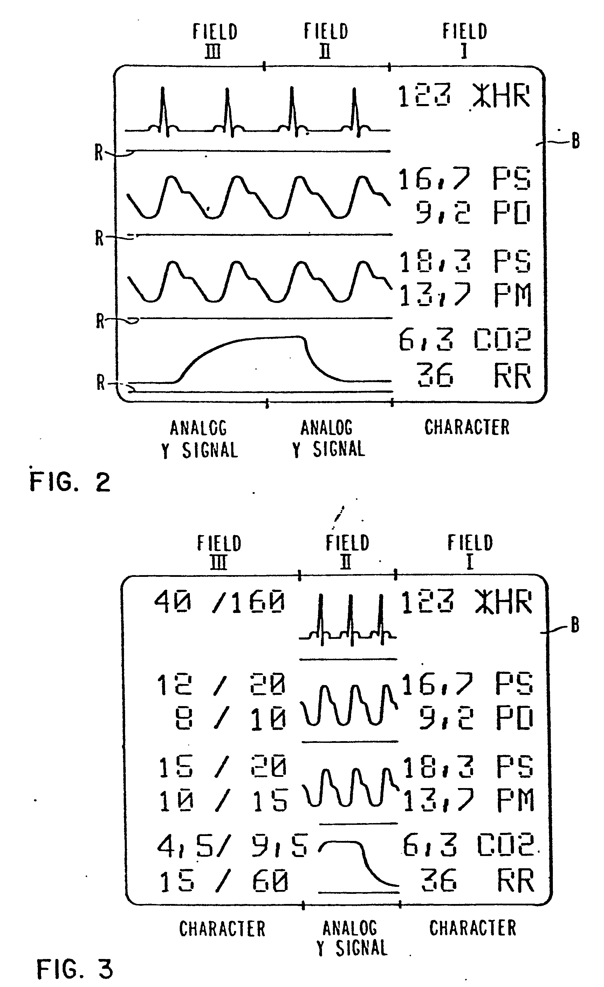

Die Zusammensetzung der einzelnen Informationsabschnitte von Analogsignalen und Zeichen zu einem Gesamtbild am Bildschirm eines x-, y-, z-Oszilloskops zeigen beispielsweise die Figuren 2 und 3. Hier ist der Bildschirm des Oszilloskops mit B bezeichnet. Man sieht sofort, dass sowohl in Figur 2 als auch in Figur 3 im Feld I am Bildschirm B alphanumerische Zeichen dargestellt werden. Im Feld II werden Abschnitte eines Analogsignales A aufgezeichnet. In Figur 2 wird im Feld III die Aufzeichnung dieses Analogsignales fortgesetzt. In Figur 3 werden hingegen in Feld III erneut alphanumerische Zeichen in Form von Grenzwerten (limits) eingeblendet.

Bei den Oszilloskopen der Figuren 2 und 3 erfolgt die Strahlablenkung des Elektronenstrahls zur Signalaufzeichnung in Draufsicht auf den Bildschirm B von rechts nach links. Auf der rechten Seite des Bildschirmes B erscheinen im Feld I also immer zuerst die alphanumerischen Zeichen. Daran schliesst sich das Feld II mit der Darstellung eines Analogsignales an. Das Feld III kann dann entweder zur Fortsetzung der Aufzeichnung des Analogsignales (Figur 2) oder zur erneuten Einblendung von alphanumerischen Zeichen (Figur 3) genutzt werden.

Aus den Figuren 2 und 3 ist auch zu ersehen, dass es sich bei den dargestellten Oszilloskopen beispielsweise um Vierkanal-Oszilloskope handelt. Diese Oszilloskope arbeiten also in der Weise, dass in zeitlicher Aufeinanderfolge in untereinander geschichteten Kanälen insgesamt bis zu vier unterschiedliche Analogsignale mit entsprechend zugeordneten Zeichen dargestellt werden können. In jedem Zeichenfeld I und/oder III können dabei durch geeignete geschichtete Adressenansteuerung im Zeichengenerator pro Kanal ein oder auch mehrere Zeichen (z.B. wie dargestellt bis zu zwei Zeichen) gleichzeitig einer einzelnen Signalkurve zugeordnet werden. In den vorliegenden Ausführungsformen der Figuren 2 und 3 sind also auf dem Bildschirm des jeweiligen Vierkanal-Oszilloskops im Kanal 1 z.B. das EKG eines Patienten zusammen mit Zeichen abgebildet, welche Zeichen für beide Figuren in Spalte I z.B. den Wert der Herzfrequenz und für Figur 3 in Spalte III speziell auch noch einen oberen und einen unteren Grenzwert der Herzfrequenz angeben. In den Kanälen 2 und 3 werden hingegen beispielsweise die Verläufe von zwei Blutdruckkurven dargestellt. Die in den Feldern I in beiden Figuren eingeblendeten Zeichen sind Wertangaben für den jeweiligen Blutdruckwert von Systole, Diastole oder Mitteldruck. Die in Figur 3 in Feld III abgebildeten Zeichen sind wieder Grenzwertangaben für die Blutdruckwerte. Der Kanal 4 zeigt schliesslich den Verlauf des $CO_2$-Gehaltes im Atemgas des Patienten mit eingeblendeten Grössen- bzw. Grenzwertangaben für den $CO_2$-Gehalt. Den aufzuzeichnenden Analogsignalen sind also im Sichtbild wahlweise nur reine Grössenangaben oder zusätzlich zu den reinen Grössenangaben auch noch Grenzwertangaben über maximal oder minimal zulässige Grenzwerte der physiologischen Messsignale in Form alphanumerischen Zeichen zuzuordnen. Durch Beigabe von Grenzwertinformationen können Grenzwertüberschreitungen und damit auch kritische Entwicklungen einer physiologischen Messgrösse sofort erkannt werden. Kritische Grenzwertüberschreitungen werden im vorliegenden Falle aber auch noch durch Abgabe eines entsprechenden Alarmsignales (insbesondere akustischer und/oder optischer Natur) angezeigt. Falls im Grundgerät der Bildinhalt eines Trendspeichers dargestellt ist, sind die in den Figuren 2 und 3 abgebildeten Analogkurven entsprechend durch Trendkurven ersetzt.

Für die Qualität des abzubildenden Systems ist es wesentlich, dass die Bilddarstellung aller abzubildenden Signale flackerfrei erfolgt. Um Flackerfreiheit der Bildaufzeichnung gewährleisten zu können, ist eine 50 Hz-Bildwechselfrequenz anzustreben. Die Gesamtzeit der Strahlablenkung über den Bildschirm des jeweiligen Oszilloskops ist demfolge 20 ms. Wird eine Aufzeichnung in vier Kanälen gewünscht, so darf die gesamte Ablenkzeit inklusive Rücklauf pro Kanal also höchstens 5 ms betragen.

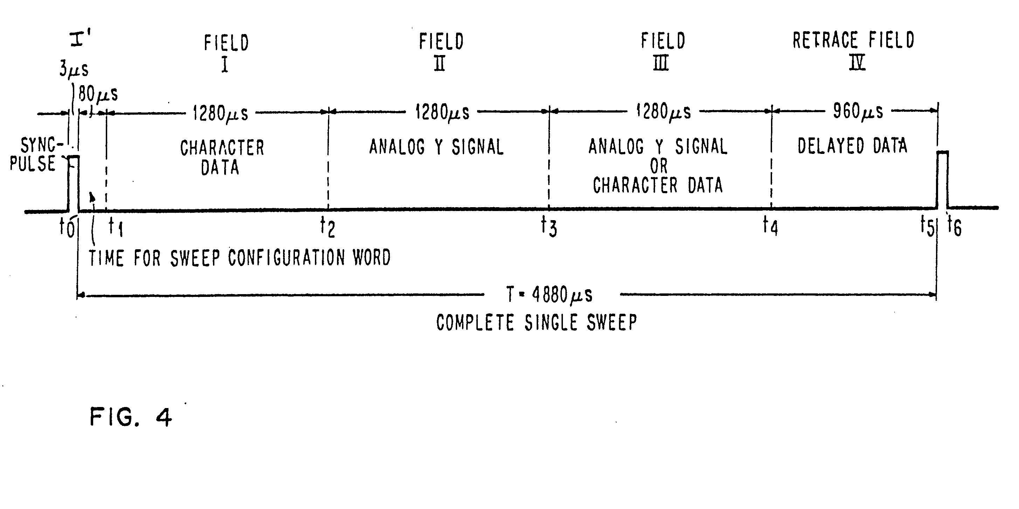

Einen in diesem Sinne angepassten Zeitplan zur Signalübertragung zeigt die Figur 4. Im Zeitplan der Figur 4 ist die Gesamtdauer T einer x-Ablenkung mit $T = 4.880\ \mu s$ angegeben. Diese Zeitdauer T ist unterteilt in insgesamt fünf Zeitabschnitte I′, I, II, III, IV. Wie vorstehend schon erwähnt, wird zu Beginn jeweils ein Synchronisierimpuls SP (3 Volt, 3 µs) gesetzt, der z.B. mit seiner Rückflanke zum Zeitpunkt $t_0$ den Beginn einer x-Ablenkung festlegt. Die Steuerung sämtlicher betroffener Geräte durch den Synchronisierimpuls ist so, dass immer der jeweils zuerst auftretende Synchronisierimpuls eines einzelnen Gerätes die x-Ablenkung sämtlicher anderer Geräte zeitlich miteinander synchronisiert, es sei denn, es wird von vornherein durch eine externe Zentrale ein Synchronisierimpuls allen anderen Geräten aufgedrückt. Auf den Synchronisierimpuls SP folgt nun zuerst das Zeitintervall I′, das im vorliegenden Falle 80 µs lang ist. Während der Dauer dieses Zeitintervalls I′, das zum Zeitpunkt $t_1$ endet,

wird an sämtliche anzusteuernden Geräte der Gerätekonfiguration ein Ablenk-Konfigurations-Signal (8 bit-sweep configuration word) als Digital-Signal übermittelt, das als Hinweissignal dafür dient, wie Beginn und/oder Ende sowie Art und Ort der momentanen y-Darstellung am Bildschirm eines gerade eingeschalteten Oszilloskops im Vergleich mit der zu übertragenden Signaldarstellung eines anderen Gerätes zu wählen sind. Das Ablenk-Konfigurations-Signal kann als 8 bit-Wort in den Stufen BIT 0 bis BIT 7 für vorliegendes Ausführungsbeispiel in der Anwendung auf ein Vierkanal-Oszilloskop wie folgt definiert sein:

| Bits | | Beschreibung | |
|---|---|---|---|
| BIT 0: | | Feld III Steuerung<br>Null = Analogsignaldarstellung (+0.75 V in CV)<br>Eins = Zeichendarstellung (−1.0 V in CV) | |
| BIT 1: | BOT 0 | Diese BIT's kontrollieren die | |
| BIT 2: | BOT 1 | vertikale Position der Grundlinie (BOT) der Spur für die Darstellung analoger Parameter gemäss folgender Aufstellung: | |
| BOT 1 | BOT 0 | | |
| 0 | 0 | Untere Position | |
| 0 | 1 | Mittlere Untere Position | |
| 1 | 0 | Mittlere Obere Position | |
| 1 | 1 | Obere Position | |
| BIT 3: | RT 0 | Diese BIT's kontrollieren die | |
| BIT 4: | RT 1 | vertikale Position der Zeichendarstellung und die Darstellung der Rückspur des Elektronenstrahls nach x-Auslenkung. Die definieren auch die jeweilige Spur und sind wie folgt kodiert: | |
| RT 1 | RT 0 | | |
| 0 | 0 | Kanal 4 | Unten |
| 0 | 1 | Kanal 3 | Mittel Unten |
| 1 | 0 | Kanal 2 | Mittel Oben |
| 1 | 1 | Kanal 1 | Oben |
| BIT 5: | G 0 | Diese BIT's kontrollieren die | |
| BIT 6: | G 1 | Y-Ablenkverstärkung für analoge Signalformen gemäss folgender Aufstellung: | |
| G 1 | G 0 | | |
| 0 | 0 | Verstärkung = 3 | |
| 0 | 1 | Verstärkung = 2 | |
| 1 | 0 | Verstärkung = 1 normal | |
| 1 | 1 | Verstärkung = 0 Austastung | |
| BIT 7: | | Intensität der Rückspur. Die Rückspur in der Position, wie sie durch RT 0, RT 1 definiert ist, wird aufgeblendet, wenn das BIT eine EINS ist. | |

Im Anschluss an den Abschnitt I′ folgt das erste Feld I. Die Dauer dieses Feldes ist 1.280 µs. Zum Zeitpunkt $t_2$ folgt auf das Feld I das Feld II, das wieder 1.280 µs lang ist. An das Feld II schliesst sich zum Zeitpunkt $t_3$ das Feld III an, das ebenfalls 1.280 µs andauert. Die x-Ablenkung wird anschliessend abgeschlossen durch den Abschnitt IV, der 960 µs lang ist und der die Rückführzeit für den Elektronenstrahl festlegt. In der Signaldarstellung der Figuren 2 und 3 wird der rückgeführte Elektronenstrahl durch Spezialwahl im Konfigurationswort jeweils als dünne Spur R in die Bildaufzeichnung mit eingeblendet. Die Rückspur R signalisiert den Verlauf der Null-Linie in jedem Kanal. Die Rückführphase IV für den Elektronenstrahl kann zur Übertragung von beliebigen zusätzlichen Befehlssignalen ausgenutzt werden. Ebensogut können zyklisch umlaufende Speicherwerte der Analogsignale während der retrace time aus dem Bildwiederholungsspeicher als jeweils älteste Werte entfernt und beispielsweise einem mitlaufenden Schreiber, Rekorder oder dergleichen als sogenannte verzögerte Daten (Delayed Data) zugeführt werden.

Darüber hinaus können bei Bedarf während der Phase IV auch Daten in beliebiger Weise in Speichern umgeschichtet bzw. auch endgültig gelöscht werden. Das Ende der Retrace Phase IV ist zugleich der Beginn einer neuen Ablenkperiode. Es wird zum Zeitpunkt $t_5$ also jeweils ein neuer Synchronisierimpuls SP erzeugt, der den Elektronenstrahl nach Umschaltung auf den jeweils nächstfolgenden Kanal eines Oszilloskops mit seiner Rückflanke zum Zeitpunkt $t_6 = t_0$ erneut zur x-Ablenkung triggert. Die Triggerung erfolgt immer in der Weise, dass der Elektronenstrahl des Oszilloskops unabhängig davon, wo er sich in der Rückphase gerade am Bildschirm befindet, sofort zu seiner Ausgangsstellung in der rechten äusseren Randposition des Bildschirms zurückgezogen wird. Die sich aufgrund der abrupten Unterbrechung der Rückführphase ergebende momentane Instabilität wird durch das sich an den Synchronimpuls anschliessende Zeitintervall I′ mit Übermittlung eines y-Konfigurationssignales, das ja selbst am Bildschirm nicht abgebildet wird, überbrückt.

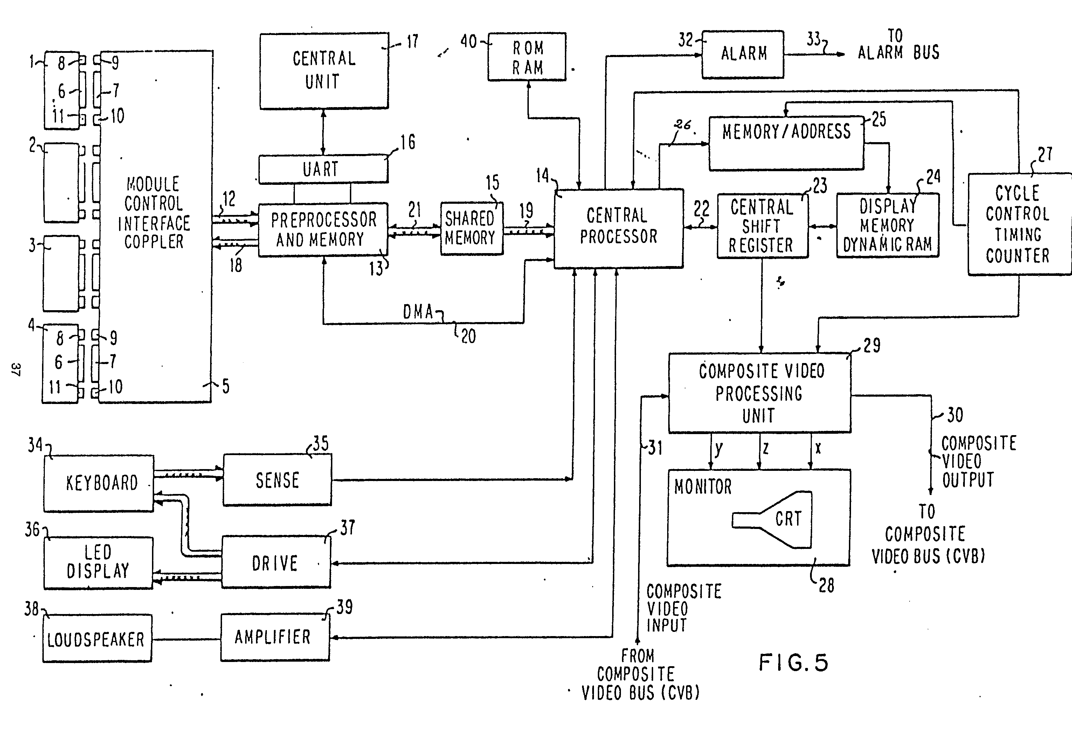

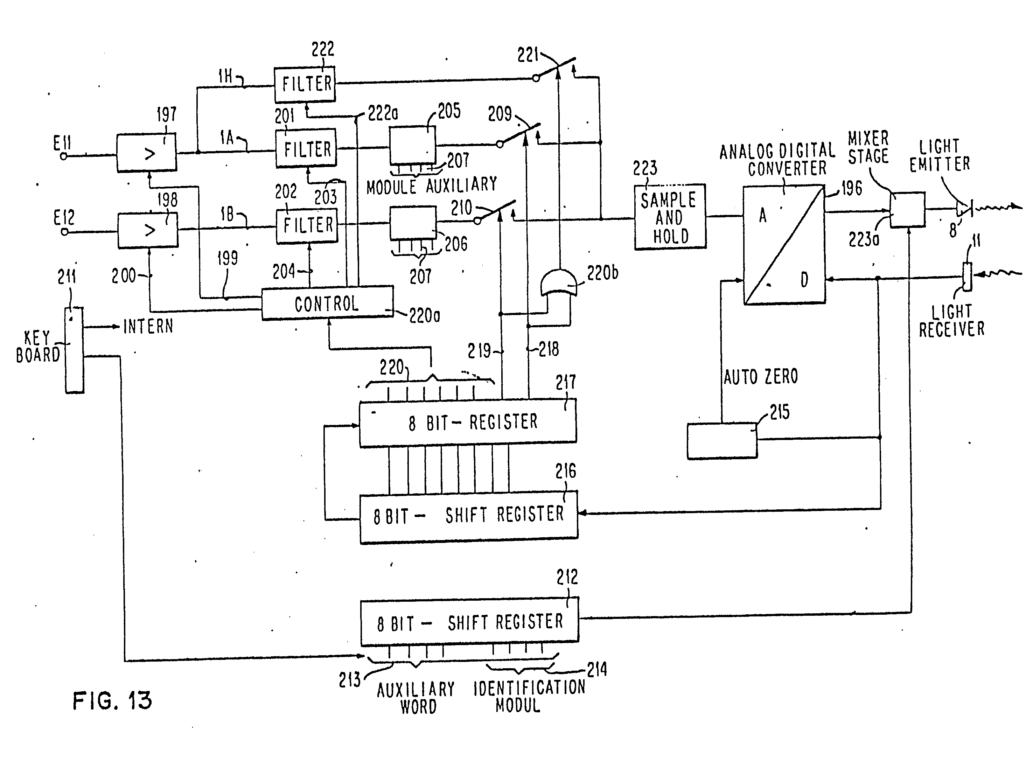

Die Erfindung findet ihre Anwendung insbesondere im Medizinbereich bei der Abnahme physiologischer Signale, wie insbesondere EKG, Blutdruck, Temperatur $CO_2$ etc. am Körper des Patienten. Ein einzelnes Gerät dieser Art ist beispielsweise in der Figur 5 im Prinzipschaltbild dargestellt. Dieses Gerät umfasst insgesamt vier Einschubmodule 1 bis 4 zur Aufnahme und Weiterleitung abgenommener physiologischer Signale zu einer Modul/Koppel- und Steuereinheit 5. Diese Einheit 5 ist mit jedem einzelnen Einschubmodul 1 bis 4 energiemässig über je ein Paar Energiekoppelspulen 6 und 7 zur Übertragung der zum Betrieb der Einschubmodule benötigten Energie von der Einheit 5 zum Modul 1 bis 4 gekoppelt. Die Übertragung der physiologischen Signale oder sonstigen empfangenen Signale von einem Einschubmodul zur Einheit 5 geschieht mittels Optokoppler 8, 9. Mit 8 ist dabei eine Sendediode, insbesondere Lumineszenzdiode für Infrarotlicht, bezeichnet. Die Kennziffer 7 deutet einen Lichtempfänger, insbesondere Fotodiode, an. Zur Übertragung von Signalen, z.B. Schaltsignalen, A/D-Taktsignalen oder sonstigen Steuersignalen von der Einheit 5 zu einem Einschubmodul 1 bis 4 ist ein weiterer Optokoppler 10, 11 vorhanden. Bei diesem Optokoppler befindet sich also eine Sendediode 10 an der Einheit 5 und eine Empfangsfotodiode am jeweiligen Modul 1 bis 4. Nähere Einzelheiten zum inneren prinzipiellen Schaltungsaufbau eines Moduls 1 bis 4 sowie der Modul/Koppel- und Steuereinheit 5 können der weiter unten folgenden Beschreibung zu den Figuren 13 bis 15 entnommen werden.

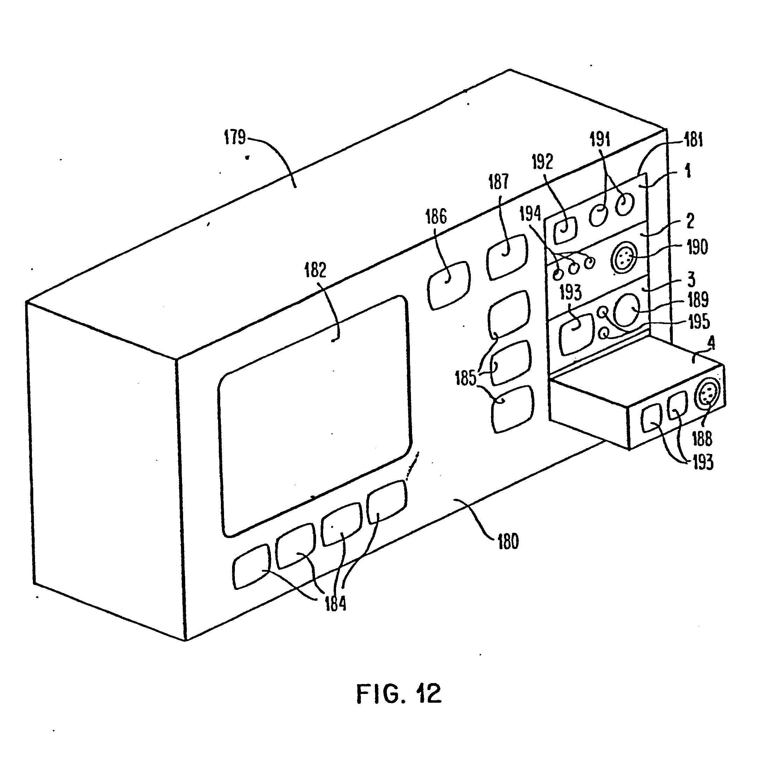

In praktischer Ausbildung der Anordnung (siehe hierzu auch die Figur 12) umfasst das Gerät im Gerätegehäuse eine Einbuchtung, in die die Einschubmodule 1 bis 4 etagenmässig übereinander einschiebbar sind. Die Einbuchtung umfasst eine Rückwand, an der die Einheit 5 mit den ersten Halbteilen der jeweiligen Energiekoppelstelle bzw. des jeweiligen Optokopplers montiert sind. Das jeweils andere Halbteil der Energiekoppelstelle bzw. des jeweiligen Optokopplers ist, wie in der Figur 5 angedeutet, an der Rückseite des jeweiligen Einschubmoduls 1 bis 4 angeordnet. Wird das Einschubmodul also in der Einbuchtung des Gerätegehäuses in seine Endstellung eingeschoben, so fügen sich die von ihm getragenen Halbteile jeder Kopplungsstelle mit den Halbteilen der Rückwand zu einer kompletten galvanisch trennenden Koppelstelle für Energie- und Signalübertragung zusammen. Die Einheit ist betriebsbereit.

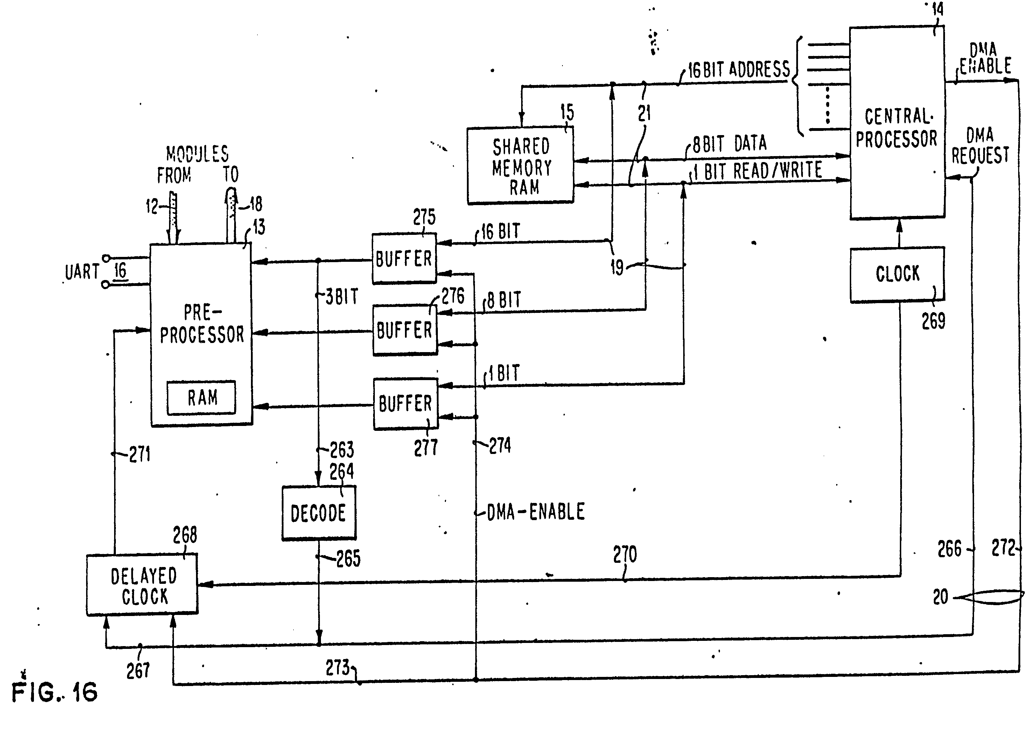

Die von der Einheit 5 aufgenommenen physiologischen oder sonstigen Signale werden nun über den Datenpfeil 12 einem Mikroprozessor 13 für Datenvorverarbeitung (Preprocessor), insbesondere Datenskalierung und Datenwichtung, zugeleitet. Wie später in der Beschreibung zu Figur 16 noch näher erläutert wird, transferiert dieser Mikroprozessor die vorverarbeiteten Daten in einen zentralen Mikroprozessor 14 via eines gemeinsamen adressierbaren Teils eines Hauptspeichers 15 (shared memory) unter Zuhilfenahme einer speziellen Hardware, die den direkten Zugriff DMA zu Speicherplätzen ermöglicht (DMA = Direct Memory Access). Zusätzlich beinhaltet der vorverarbeitende Mikroprozessor 13 auch noch einen On-Chip UART 16 (UART = Universal Asynchronous Receiver Transmitter) zur Kommunikation mit einer Zentrale 17. Der Mikroprozessor 13 für die Vorverarbeitung kann ausserdem gemäss Datenpfeil 18 Signaldaten, wie Taktsignale, Konfigurationssignale oder dergleichen, über die Einheit 5 unter Einschaltung des Signalweges über die Optokoppler 10, 11 zu den einzelnen Einschubmodulen 1 bis 4 übersenden. Der Speicher 15 ist normalerweise dem zentralen Mikroprozessor 14 fest zugeordnet (Datenpfeil 19). Der vorverarbeitende Mikroprozessor 13 hingegen ist abgeschaltet. Lediglich bei DMA-Anforderung seitens des vorverarbeitenden Prozessors (Leitung 20) trennt sich der zentrale Mikroprozessor 14 vom Speicher 15 und der vorverarbeitende Prozessor 13 übernimmt die Kontrolle über den Speicher (Datenpfeil 21).

Der zentrale Mikroprozessor 14 ist das Herzstück des Gerätes. Von ihm werden über eine Datenleitung 22 die anfallenden Signaldaten über ein zentrales Schieberegister 23 in einen dynamischen RAM-Speicher 24 unter der Kontrolle eines Adress-Rechners 25, der vom zentralen Mikroprozessor 14 über eine Adressleitung 26 Adressdaten erhält, eingelesen. Das zentrale Schieberegister 23 übernimmt dabei alle anfallenden Daten in paralleler Formation und liest sie seriell wieder aus. Die Taktfolge des Ein- und Auslesens von Daten wird von einem zentralen Taktgeber 27 vorgegeben. Die vom RAM-Speicher 24 zum Oszilloskop 28 zur Aufzeichnung weiterzuleitenden Daten werden in einer Verarbeitungsvorrichtung 29 vorverarbeitet und dann auf das Oszilloskop gegeben. Die Vorrichtung 29 beinhaltet dabei alle Bauelemente, die zur Erzeugung bzw. zur Weiterleitung der erfindungsgemässen Signalfolge (Composite Video Signal) gemäss der Figur 1 notwendig sind. Mittels der Vorrichtung 29 werden also Signale und Zeichen entsprechend den Figuren 1 bis 4 aufbereitet und dem geräteeigenen Monitor 28 zugeleitet. Gleichzeitig werden sämtliche in diesem Sinne aufbereiteten Signale auch über einen Ausgang 30 (Composite Video Output) auf eine für sämtliche Geräte einer beliebigen Gerätekonfiguration gemeinsame Übertragungsleitung (Composite Video Bus) gegeben. Darüber hinaus umfasst die Vorrichtung 29 aber auch noch einen entsprechenden Eingang 31 (Composite Video Input) über den das Gerät ebenfalls an der gemeinsamen Verbindungsleitung für alle Geräte anschaltbar ist. Von dort können also im Bedarfsfall, z.B. im Falle eines Alarmes, unter Abschaltung des eigenen Datenflusses zum Oszilloskop, von einem beliebigen anderen Gerät, insbesondere jenem des Alarmfalles, Composite Video Signale aus dem gemeinsamen Übertragungsweg zur Aufzeichnung auf dem geräteeigenen Oszilloskop 28 übernommen werden. Der Alarm wird von einem am zentralen Mikroprozessor 14 angeschalteten Alarmgeber 32 erzeugt und z.B. in Pfeilrichtung 33 auf einen Alarm Bus gegeben. Zur Eingabe besonderer Befehlsdaten in den zentralen Prozessor 14 dient ein Tastenfeld 34, z.B. an der Frontplatte des jeweiligen Gerätes, mit Sensor 35 für die richtige Eingabe. Zur Anzeige eingegebener oder während der Signalverarbeitung anfallender Daten dient eine LED-Anzeige 36 (Leuchtdioden) mit Treiberstufe 37. Ein Lautsprecher 38 mit Verstärker 39 dient zur akustischen Signalanzeige, z.B. für Alarm, für Tastklicks der Tasten eines Tastenfeldes bzw. Takt für anfallende QRS-Pulse oder auch Anzeige für unterbrochenen Programmablauf des zentralen Prozessors. Das Bauteil 40 ist ein ROM- und RAM-Zusatzspeicher für den zentralen Mikroprozessor.

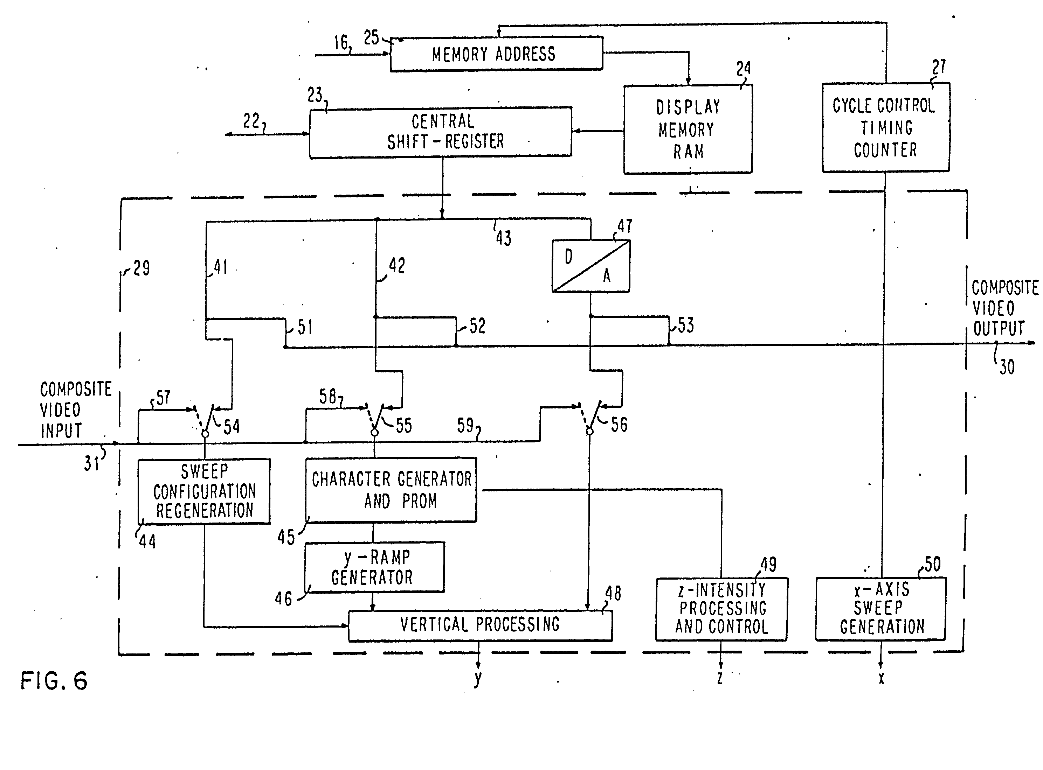

Die Vorrichtung zur Erzeugung und Weiterleitung bzw. auch des Empfangs von Composite Video Signalen ist als Bestandteil z.B. eines Gerätes gemäss der Figur 5 im Prinzipschaltbild der Figur 6 in Detail dargestellt. Demgemäss gabelt sich der Ausgang des zentralen Schieberegisters 23 in Richtung Signalverarbeitungsvorrichtung 29 in wenigstens drei Signalpfade 41, 42 und 43. In jedem dieser Signalpfade ist ein spezielles Signalverarbeitungsglied eingeschaltet. So befindet sich im Signalpfad 41 ein Decoder 44 für das y-Konfigurationswort. Im Signalpfad 42 liegen hingegen der Zeichengenerator 45 für die Zeichenbildung (lokales ROM für 2 × 7 Character Display im 8 bit code) und der Ramp-Generator 46 zur Erzeugung des schnellen y-Ablenkrasters (y-Sägezahn- oder Rampenspannung $Y_R$). Im Signalpfad 43 ist schliesslich der Digital-Analog-Umsetzer 47 zur Regenerierung der Analogsignale A eingeschaltet. Die Ausgänge des Decoders 44 für das y-Konfigurationssignal, des Generators 46 für das y-Ablenkraster und des Digital-Analog-Umsetzers 47 führen zu einer Einrichtung 48 für die Verarbeitung aller eingehenden Signale zum vertikalen Ablenksignal y für das nachgeschaltete Oszilloskop 28. Der Zeichengenerator 45 geht mit einem weiteren Ausgang auf die Helltasteinrichtung 49 des Oszilloskops, die die zum Zeichenaufbau nötigen Helltastimpulse liefert. Zur x-Ablenkung ist ein x-Sägezahngenerator 50 vorhanden, der direkt vom internen Taktgeber 27 des Gerätes über die Synchronimpulse SP getriggert wird.

Der beschriebene Signalgang ist der Gang für jenes Composite Video Signal, wie es sich das Gerät jeweils selbst erzeugt. Zur Weiterleitung dieses selbsterzeugten Signals dient, wie schon erwähnt, ein zusätzlicher Geräteausgang 30 (Composite Video Output), der zu einem für alle Geräte gemeinsamen Composite Video Bus führt. In der Figur 6 ist dieser zusätzliche Signalpfad durch Abgriffe 51, 52, 53 gekennzeichnet. Die Abgriffe 51 und 52 liegen dabei an den Signalpfaden 41 und 42 vor Schaltern 54 und 55, die dem Decoder 44 für das y-Konfigurationssignal und dem Zeichengenerator 45 vorgeschaltet sind. Der Abgriff 53 am Signalpfad 43 liegt hingegen am Ausgang des Digital-Analog-Umsetzers 47 vor einem Schalter 56. Die Schalter 54 bis 56 verbinden im Normalfall die Signalpfade 41, 42 und 43 unmittelbar mit den systemeigenen Bilderzeugern 44 bis 49. Sie besitzen jedoch auch noch eine zweite Schaltstellung, in der sie jeweils in der dargestellten Weise an die Signalpfade 57, 58 und 59 des Composite Video Input 31 umschaltbar sind. Bei Umschaltung auf den Input 31 wird also die Signalzuführung vom systemeigenen Signalerzeuger 23, 24 zu den Bauelementen 44 bis 49 unterbrochen. An Stelle des eigenen Composite Video Signals wird dem Oszilloskop jetzt das Composite Video Signal eines fremden (insbesondere alarmgebenden) Gerätes aufgeschaltet. Das systemeigene Componente Video Signal wird jedoch gleichzeitig davon ungehindert weiter dem Composite Video Output 30 zugeleitet.

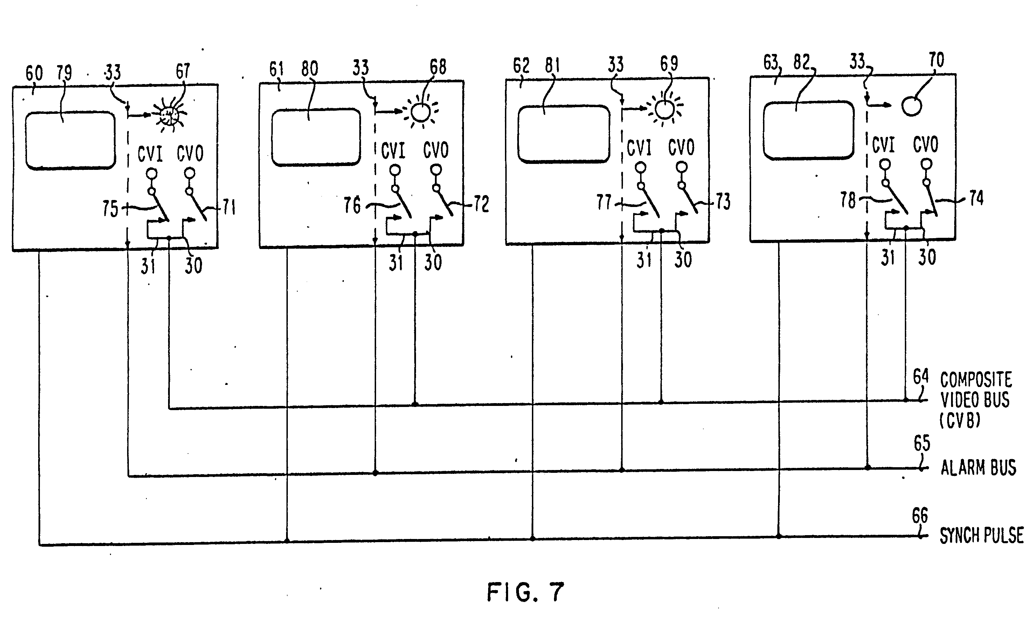

Eine typische Anwendung der Erfindung auf eine Kettenschaltung an einzelnen Überwachungsgeräten ohne eigene Zentrale zeigt die Figur 7. Hier sind beispielsweise insgesamt vier Bettseit-Geräte 60 bis 63 dargestellt, von denen jedes so aufgebaut ist und ein solches Composite Video Signal erzeugt, wie es in den Erläuterungen zu den vorhergegangenen Figuren 5 und 6 geschildert wurde. Alle vier Geräte dieser Gerätekette (die Zahl der Geräte kann noch beliebig erhöht werden) sind untereinander über insgesamt drei Leitungen 64, 65, 66 verbunden (bzw. über Schalter zusammenschaltbar, wie etwas weiter unten noch näher erläutert wird). So ist z. B. die Leitung 64 der gemeinsame Signal Bus (CVB) für das Composite Video Signal (CV). Die Leitung 65 ist der gemeinsame Alarm Bus und die Leitung 66 ist schliesslich die gemeinsame Übertragungsleitung für den Synchronimpuls SP zur Synchronisierung der x-Ablenkung aller Geräte 60 bis 63. Jedes der Geräte trägt an der Frontseite (schematisch angedeutet) je eine LED-Taste 67 bis 70.

In jeder dieser Tasten ist also eine Leuchtdiode (LED) integriert. Jede dieser Leuchtdioden steht wiederum schaltungsmässig mit dem Alarm Bus 65 in solcher Verbindung, dass sie innerhalb der Taste aufleuchtet, wenn von einem anderen Gerät der Kette ein Alarmsignal erzeugt und auf den Alarm Bus ausgegeben wird. Im alarmgebenden Gerät selbst wird allerdings die dortige LED nicht aktiviert. Hier wird die Alarmsituation optisch und akustisch mit gesonderten Anzeigemitteln angezeigt. Der Arzt oder die überwachende Schwester können dann sofort unterscheiden, ob das betreffende Gerät selbst Alarm gibt, d.h. ob der daran angeschlossene Patient selbst der Alarmpatient ist oder ob ein anderes Gerät der Kette mit dem dort angeschlossenen Patienten Gegenstand des Alarmes ist.

Was die Zuleitung von Composite Video Signalen von den Geräten 60 bis 63 zum Composite Video Bus 65 bzw. die Entnahme solcher Signale durch einzelne Geräte aus dem Composite Video Bus 65 betrifft, so sind in der Figur 7 innerhalb der Blocks, die die Geräte 60 bis 63 symbolisieren, wiederum nur rein symbolisch Schalter 71 bis 78 eingezeichnet. Die Schalter 71 bis 74 (CVO-Schalter) sind in den Leitungen 30 (siehe Figuren 5 und 6) der Video Signal Outputs (CVO) der Geräte angeordnet. Die Schalter 75 bis 78 (CVI-Schalter) liegen in den Leitungen 31 (siehe Figuren 5 und 6) der Video Signal Inputs (CVI). Ein geschlossener CVO-Schalter 71 bis 74 bedeutet also, dass das betreffende Gerät 60, 61, 62 oder 63 speziell sein Composite Video Signal, das es in diesem Moment auch gleichzeitig am Bildschirm des eigenen Oszilloskops 79, 80, 81 oder 82 abbildet, in den Composite Video Bus 64 einspeist. Ein geschlossener CVI-Schalter 75 bis 78 bedeutet, dass jenes Composite Video Signal, das gerade von einem anderen Gerät in den Composite Video Bus 65 eingespeist wird, vom betreffenden Gerät über dessen Video Signal Input aus dem CV-Bus übernommen und am Bildschirm des Oszilloskops 79, 80, 81 oder 82 dieses Gerätes anstelle der Abbildung des eigenen Composite Video Signals abgebildet wird.

Im Ausführungsbeispiel der Figur 7 gibt z. B. das Gerät 63 Alarm. Dieser Alarm teilt sich über den Alarm Bus 65 den Geräten 60, 61 und 62 (oder allen weiteren Geräten, falls solche zusätzlich noch in der Kette angeschlossen sind) mit. Die LED-Tasten 67, 68 und 70 dieser Geräte leuchten also, was in der Figur 7 durch symbolische Lichtstrahlen am Rand der Tasten angedeutet ist. Gemäss der vorhergehenden Ausführungen ist ausserdem der CVO-Schalter 74 des Gerätes 63 im Augenblick der Alarmgebung geschlossen worden. Die CVO-Schalter 71, 72 und 73 der Geräte 60, 61 und 63 bleiben hingegen geöffnet, da in diesen Geräten ja kein Alarm erzeugt wurde. Demnach wird also in den Composite Video Bus 64 das Composite Video Signal des alarmgebenden Gerätes 63 eingespeist. Dieses Composite Video Signal kann nun von einem beliebigen Gerät 60 bis 63 durch Drücken der LED-Taste 67 bis 69 aus dem CVB 64 entnommen werden. Das Drücken einer leuchtenden LED-Taste führt dazu, dass das Dauerleuchten in ein Blinken übergeht. Damit wird angezeigt, dass auf dem Bildschirm des Oszilloskops des betreffenden Gerätes nicht mehr das eigene, sondern ein fremdes Signalbild abgebildet wird. Das Blinken einer Taste wird in Figur 7 symbolisch durch Strahlen angedeutet, die radial in das Tastenzentrum laufen.

Im Ausführungsbeispiel der Figur 7 wurde z.B. die LED-Taste 67 des Gerätes 60 gedrückt. Der CVI-Schalter 75 dieses Gerätes wurde demnach geschlossen und das CV des alarmgebenden Gerätes 63 gelangt somit über den Composite Video Input des Gerätes 60 in den CV-verarbeitenden Signalteil dieses Gerätes und von diesem entsprechend zum Bildschirm des Oszilloskops 79.

Die beschriebenen Schaltabläufe der Schalter 71 bis 78 sind von rein exemplarischem Charakter. Es gibt hier beliebige Modifikationen, die eingesetzt werden können, ohne dass der prinzipielle Ablauf der CV-Ausgabe durch ein Gerät in den CV-Bus bzw. der Aufnahme von CV-Signalen aus dem CV-Bus durch ein anderes oder mehrere andere Geräte massgeblich geändert wird. So ist es also durchaus möglich, dass abweichend von vorstehend beschriebener Weise z.B. über ständig geschlossene CVO-Schalter ständig alle CV-Signale aller Geräte in den CV-Bus eingespeist werden. Erst mit Auftreten eines Alarmsignals im gemeinsamen Alarm Bus werden sämtliche CVO-Schalter geöffnet, bis auf jenen des alarmgebenden Gerätes. Es wird dann also im Alarmfall, wie erwünscht, in den CV-Bus nur noch das alarmbehaftete CV eingespeist.

Im Vergleich mit dem Prinzipschaltbild der Figur 6 kann der jeweilige COI-Schalter 75, 76, 77 oder 78 die drei Umschalter 54, 55, 56 symbolisieren. Ein offener COI-Schalter der Figur 7 entspräche also der ersten Schaltposition der Schalter 54, 55, 56 in Figur 6, in der die geräteeigenen CV-Erzeuger 23, 24 etc. über die Leitungen 41, 42, 43 direkt mit den bildaufbauenden Bausteinen 44 bis 49 verbunden sind. Ein geschlossener COI-Schalter der Figur 7 gäbe hingegen die zweite Schaltposition wieder, in der diese direkten Verbindungen unterbrochen und dafür die bildaufbauenden Bausteine (bis auf den A/D-Umsetzer 47) mit den Signalleitungen 57, 58, 59 des CVI verbunden sind. Der jeweilige COI-Schalter kann jedoch z.B. auch als zusätzlicher Steuerschalter für die Schalter 54, 55, 56 ausgebildet sein, der die Schalter 54, 55, 56 umschaltet, sobald er mit dem Drücken der LED-Taste geschlossen wird. In besonderer Ausbildung und unabhängig von vorstehend beschriebenen Funktionsmöglichkeiten kann der COI-Schalter auch integrales Schaltkontaktteil der LED-Taste sein.

Was die Priorität von Alarmen betrifft, so sind die Schalter auch wie folgt gesteuert: Sofern von einem einzelnen Gerät ein Alarm gegeben wird, so ergibt sich der vorstehend beschriebene Funktionsablauf. Wird hingegen von zwei oder noch mehr Geräten Alarm gegeben, so tritt der vorstehend beschriebene Funktionsablauf grundsätzlich nur für jenes Gerät ein, das von allen alarmgebenden Geräten zuerst Alarm erzeugt hat. Nur für dieses Gerät schliesst sich also der betreffende CVO-Schalter; die CVO-Schalter der anderen alarmgebenden Geräte bleiben hingegen geöffnet, solange bis der Alarm des ersten Gerätes zurückgesetzt wurde, z.B. durch Drücken einer Alarm-Rücksetztaste. Sobald dies geschehen ist, tritt an die Stelle des Gerätes, das zuerst Alarm gegeben hat, ein nächstfolgendes Gerät, das Alarm gibt (bei mehreren gleichzeitig alarmgebenden Geräten z.B. das Gerät mit der niedrigsten Bettnummer, dann das mit der nächsthöheren Bettnummer etc.).

Signifikante Eigenschaft einer Kettenschaltung, wie sie im Prinzip in der Figur 7 dargestellt ist, ist also, dass jedes Gerät innerhalb der Kette die Funktion eines Zentralgerätes übernehmen kann, das in der Zentralfunktion dann also von einem beliebigen anderen Gerät, das z.B. gerade Alarm erzeugt, dessen Composite Video Signal zur Aufzeichnung auf dem Bildschirm des eigenen Oszilloskops abrufen kann. Wesentlich ist nur, dass zur Übernahme der Zentralfunktion am entsprechenden Gerät eine LED-Taste gedrückt wird.

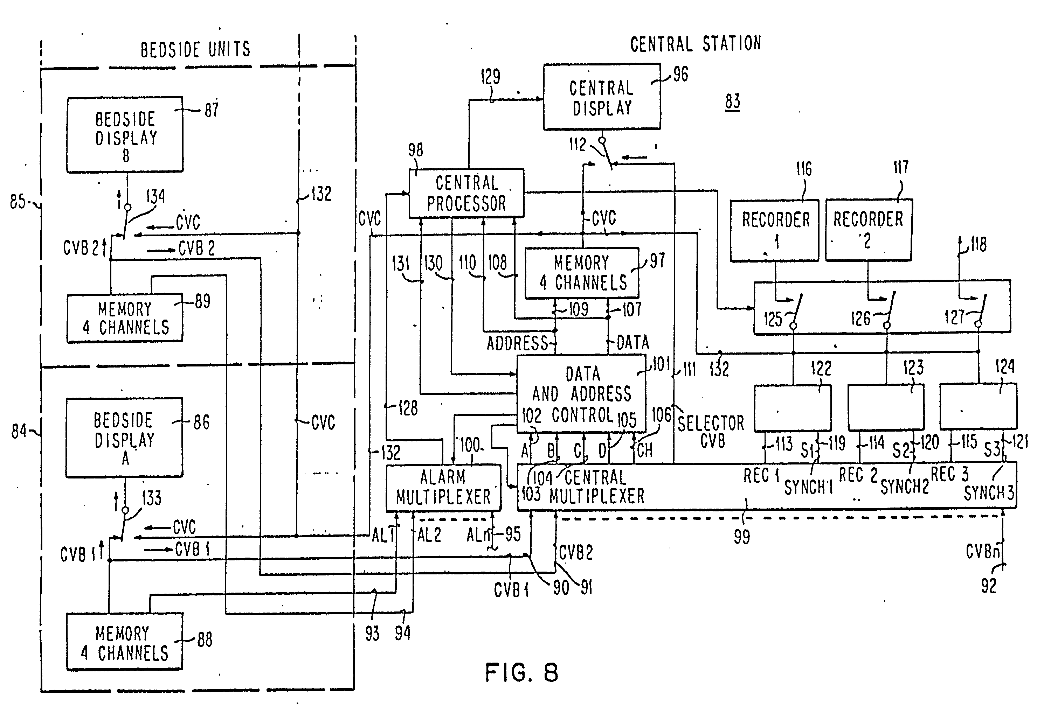

Nach einem etwas modifizierten Prinzip funktioniert hingegen eine Anordnung aus Bettseit-Geräten, für die von vornherein zur Steuerung des Gesamtablaufes eine Zentraleinheit vorgesehen ist. Eine solche Anordnung ist in der Figur 8 im Prinzipschaltbild dargestellt. In dieser Anordnung sind einer Zentrale 83 insgesamt n Einzelgeräte (Bedside-Units) zugeordnet, die mit der Zentrale sternförmig über geräteseitige Composite Video Busse für geräteseitige Composite Video Signale CVB 1 bis CVB n und Alarm Busse für geräteseitige Alarme AL 1 bis AL n verbunden sind. Ein einzelner zentraler Composite Video Bus (Composite Video Central) für ein zentrales Composite Video Signal CVC führt von der Zentrale zu den Bettseit-Geräten zurück. In kleinster Einheit sind in Sternschaltung einer Zentrale 83 vorzugsweise n=4 Einzelgeräte zugeordnet. Die vorliegende Schaltung der Figur 8 beinhaltet jedoch z.B. n=16 Einzelgeräte in Sternschaltung mit der Zentrale 83, von denen jedoch lediglich die beiden ersten Geräte der insgesamt 16 Bettseit-Geräte dargestellt sind. Diese beiden Geräte sind mit den Kennziffern 84 und 85 angedeutet. Die n=16 Einzelgeräte können bei Bedarf in Untergruppen (cluster) von wieder vorzugsweise 4×4 Bettseit-Geräten unterteilt sein. Jeder Gruppe ist dann z.B.

ein eigener Wandanschluss (Wall-Terminal) in Richtung Zentrale zugeordnet. Jedes der Bettseit-Geräte der Sternformation mit Zentrale ist im Prinzip genauso aufgebaut und es funktioniert hinsichtlich der Erzeugung seines CVB 1 bis CVB n genauso wie es für die Figuren 5 und 6 beschrieben wurde. Die Blocks 86 und 87 innerhalb der Geräteblocks 84 und 85 symbolisieren also im wesentlichen die Zusammenfassungen jener Bauelemente 41 bis 56 des Bildverarbeitungs- und Bildaufzeichnungsteils der Geräte, wie sie insbesondere in Figur 6 detailliert sind. Die Blocks 88 und 89 deuten hingegen den Bildwiederholungsspeicher 24 mit zugehörigem Schieberegister 23, Adressrechner 25, Taktgeber 27 etc. an, so wie diese Bauelemente im Prinzip in der Figur 6 ebenfalls erläutert sind.

Auch was die Alarmgebung und Alarmbenachrichtigung betrifft laufen vom Prinzip her dieselben Mechanismen ab, wie sie für die Kettenschaltung der Figur 7 beschrieben wurden. Der einzige, hier jedoch sehr wesentliche Unterschied besteht darin, dass allen Einzelgeräten 84, 85 etc. bereits eine Zentrale 83 zugeordnet ist, die von vornherein und allein die Zentralfunktion übernimmt. Eine Übernahme der Zentralfunktion durch ein beliebiges Bettseit-Gerät, wie es bei der Schaltung von Bettseit-Geräten in Kettenformation (Figur 7) möglich ist, ist bei der Sternschaltung also nicht möglich. Daraus resultiert, dass also nicht nur sämtliche Composite Video Signale CVB 1 bis CVB n der einzelnen Bettseit-Geräte über einzelne Composite Video Busse 90, 91 (für die beiden ersten Busse), 92 (für den 16-ten Bus) sternförmig zur Zentrale 83 geführt werden; dasselbe geschieht auch mit Alarmen, da jedes einzelne Bettseit-Gerät 84, 85 der Sternformation ebenfalls in Sternform direkt über einen geräteeigenen Alarmbus mit der Zentrale 83 verbunden ist. Von den insgesamt sechzehn Alarmbussen sind die beiden ersten Busse mit 93, 94 und der 16-te Bus mit 95 angedeutet. Wird als von einem der sechzehn Bedside-Geräte 84, 85 etc. ein Alarm erzeugt, so wird dieser Alarm der Zentrale 83 zugeführt.

Die Zentrale selbst ist, was den zentralen Bildverarbeitungs- und Bildaufbauteil 96 betrifft, im Prinzip genauso aufgebaut wie ein Bettseit-Gerät. Sie umfasst entsprechend einem Bettseit-Gerät auch einen Wiederholungsspeicher 97 und einen zentralen Mikroprozessor 98. Anstelle von Einschubmodulen mit entsprechendem Datenverkehr sind jedoch in der Zentrale auf passenden Ergänzungskarten ein zentraler Signal- und Daten-Multiplexer 99, ein Alarmmultiplexer 100 und eine Steuereinrichtung 101 für Daten- und Adress-Steuerung zwischen zentralem Multiplexer 99 und zentralem Bildwiederholungsspeicher 97 eingefügt. Der zentrale Signal- und Daten-Multiplexer 99 besitzt die Eingangsleitungen 90, 91 etc. bis 92 für die insgesamt sechzehn Composite Video Signale CVB 1 bis CVB 16 der sechzehn einzelnen Bettseit-Geräte. Er ist ausgangsseitig über Leitungen 102 bis 106 für Signale A, B, C, D, CH mit der Steuereinrichtung 101 verbunden, die wiederum ausgangsseitig über Datenbusse 107 und 108 sowie über Adressenbusse 109 und 110 mit dem zentralen Bildwiederholungsspeicher 97 und dem zentralen Mikroprozessor 98 in Verbindung steht. Darüber hinaus führt eine weitere Ausgangsleitung 111 des zentralen Multiplexers 99 über einen Schalter 112 direkt zum Signaleingang des Bildverarbeitungs- und Bildaufzeichnungsteils 96 der Zentrale. Über diese Schaltleitung empfängt das Bildteil 96 der Zentrale das komplette Composite Video Signal CVB eines beliebig anwählbaren Bettseit-Gerätes der Sternkonfiguration. Schliesslich besitzt der zentrale Multiplexer 99 auch noch drei Ausgänge 113, 114 und 115 für Recordersignale REC 1, REC 2, REC 3, die bei Bedarf auf zwei in der Zentrale integrierten Signalrecordern 116, 117 sowie einem extern anzuschliessenden Signalrecorder (Anschliesspfeil 118) registrierbar sind. Zur Synchronisierung der Recorder dienen Synchronisiersignale Synch 1, Synch 2, Synch 3, die an die Ausgangsleitungen 119, 120 und 121 des zentralen Multiplexers 99 anfallen. Die Signale REC 1, REC 2, REC 3 werden zusammen mit den Synchronisiersignalen Synch 1, Synch 2, Synch 3 in Decodierern 122, 123, 124 decodiert und dann mittels Schalter 125, 126, 127 den Recordern aufgeschaltet. Der Alarmmultiplexer 100 besitzt einen Ausgangsalarmbus 128 zum zentralen Prozessor 98. Der zentrale Prozessor 98 steht über eine Daten- und Adress-Leitung 129 mit dem Bildteil 96 der Zentrale in Verbindung und er steht ausserdem über Leitungen 130, 131 in ständiger Kommunikation mit der Steuereinrichtung 101. Ein weiterer, sehr wesentlicher Bestandteil ist der zentrale Composite Video Bus 132. Über diesen zentralen Bus wird das Composite Video Signal CVC der Zentrale zu den Bettseit-Geräten zurückgeführt (bzw. auch in Richtung auf die Recorder 116, 117 etc. gegeben). Bei Bedarf (wieder durch Drücken einer LED-Taste wie bei Kettenschaltung gemäss Figur 7) kann das zentrale Composite Video Signal jederzeit aus dem zentralen Bus 132 in ein Bettseit-Gerät abgerufen werden. Hierzu muss lediglich wieder ein Schalter 133, 134 etc. (LED-Taste) umgelegt werden. Das CVC gelangt dann über den Composite Video Input des betreffenden Gerätes in den Bildverarbeitungsteil. Das eigene Signalbild wird dann durch das Zentralbild ersetzt.

Signifikante Eigenschaft der Sternkonfiguration ist also, dass die Composite Video Signale CVB 1 bis CVB n der Bettseit-Geräte 84, 85 etc. sternförmig zur Zentrale 83 geführt werden. Im Normalfall umfasst die Zentrale jedoch ebenfalls nur ein einziges Oszilloskop mit maximal vier Kanälen. Damit lassen sich am Bildschirm des zentralen Oszilloskops also höchstens die vier Kanäle eines einzigen Darstellungsgerätes 86 oder 87 etc. als ausgewähltes CVB über die Leitung 111 übernehmen. Ein zeitgestaffeltes Umschalten des zentralen Anzeigegerätes 96 auf andere Darstellungsgeräte ist durch den Zeitmultiplex des Multiplexers 91 zwar möglich und wird so auch durchgeführt; Schwierigkeiten bereitet jedoch die Durchführung eines Abbildungsverfahrens, bei dem in gemischter Form Signale bestimmter Kanäle von Bildgeräten 86, 87 etc. unterschiedlicher Bettseit-Geräte 84, 85 auf dem zentralen Bildgerät 96 dargestellt werden sollen. In unterschiedlichen Bettseit-Geräten können die verschiedenen Bildgeräte mit sehr unterschiedlichen Ablenkgeschwindigkeiten der x-Ablenkung arbeiten. So gibt es z.B. Geräte, die mittels Geschwindigkeits-Wahlschalter auf eine höchste Ablenkgeschwindigkeit von z.B. 50 mm/s, und andere, die auf eine geringste Ablenkgeschwindigkeit von z.B. 12,5 mm/s geschaltet sind. Jedes Gerät kann zumindest zwischen diesen beiden Ablenkgeschwindigkeiten umgeschaltet werden. Die gleichzeitige Abbildung von Signalspuren mit unterschiedlicher Ablenkgeschwindigkeit ist jedoch praktisch kaum durchführbar.

Die Sternschaltung der Figur 8 bewältigt jedoch auch diese Situation und zwar durch einen besonderen Trick. Dieser Trick ist durch folgende Aspekte gekennzeichnet: Der erste Aspekt berücksichtigt den Umstand, dass an jedem Bildwiederholungsspeicher im Bildverarbeitungsteil eines einzelnen Bettseit-Gerätes mit jeder Eingabe eines neuen Messwertes ein ältester Messwert anfällt, der aus der Signaldarstellung eliminiert wird. Der Zeitpunkt des Rauswurfes dieses jeweils ältesten Messwertes wird nun mit der Periode einer Signaldarstellung so synchronisiert, dass er in die Rückführphase (retrace time) der x-Ablenkung fällt (zweiter Aspekt). Der älteste Messwert wird damit also nicht mehr im Signalbild abgebildet; er steht jedoch als verzögerter Messwert (delayed data) zur Abbildung auf einem anderen Bildgerät zur Verfügung, falls eine solche verzögerte Abbildung gewünscht wird. Diesen Umstand macht sich nun die Zentrale 83 in der Sternschaltung der Figur 8 zunutze (dritter Aspekt). Diese Zentrale umfasst einen Bildwiederholungsspeicher 97, der über den Multiplexer 99 von allen Geräten im Zeitmultiplex verzögerte Messwerte A, B, C und D erhält. Die verzögerten Messwerte werden von der Steuereinrichtung 101 zusammen mit den Charakteradressen CA im Bildwiederholungsspeicher eingeschrieben. Von dort können sie zu beliebiger Zeit und in beliebiger Mischung der Signalspuren wieder abgerufen und auf dem zentralen Darstellungsgerät 96 als Mischbild dargestellt werden.

Der beschriebene Trick macht es also möglich, dass an einem zentralen Oszilloskop innerhalb der Zentrale 83, das z.B. vier Kanäle aufweist, in beliebig wechselnder Reihenfolge insgesamt vier unterschiedliche Kanäle aus Oszilloskopen von vier unterschiedlichen Bettseit-Geräten dargestellt werden können.

Tritt nun an einem der externen Geräte ein Alarm auf, so gelangt dieser Alarm über den entsprechenden Alarm Bus AL 1 bis AL n zum Alarmmultiplexer 100 und von dort zum zentralen Prozessor 98. Der zentrale Prozessor 98 steuert nun den Signaltransfer zwischen Bildwiederholungsspeicher 97 und Darstellungsgerät 96 in der Weise, dass die verzögerten Werte der alarmgebenden Signalspur (z.B. alarmgebendes EKG) anstelle einer vorherigen Signalwertaufzeichnung in den Kanal mit der höchsten Nummer, d.h. also in den vierten Kanal, eingeschrieben wird. Tritt eine zweite alarmgebende Signalspur auf, so wird diese entsprechend in den nächstniedrigeren Kanal, d.h. also in den dritten Kanal, etc eingeschrieben. Gleichzeitig mit der Darstellung der alarmgebenden Signalspur wird vom Bildwiederholungsspeicher die Nummer des Bettes überspielt, an dem das alarmgebende Gerät steht. Die Bettnummer wird am zentralen Bildschirm durch Blinken hervorgehoben, so dass die überwachende Person an der Zentrale sofort erkennt, dass ein Alarmfall an einem Bettseit-Gerät mit bestimmter Bettnummer vorliegt.

Der Alarmfall kann von der Zentrale 83 über den zentralen Bus 132 auch anderen nicht alarmgebenden Bettseit-Geräten mitgeteilt werden. Hier leuchtet dann z.B. wieder entsprechend vorhergehender Beschreibung eine LED-Taste auf. Durch Drücken einer solchen Taste kann dann das zentrale Composite Video Signal CVC auf den Bildschirm des Oszilloskops des betreffenden Gerätes unter Abschaltung der eigenen Bilddarstellung übernommen werden.

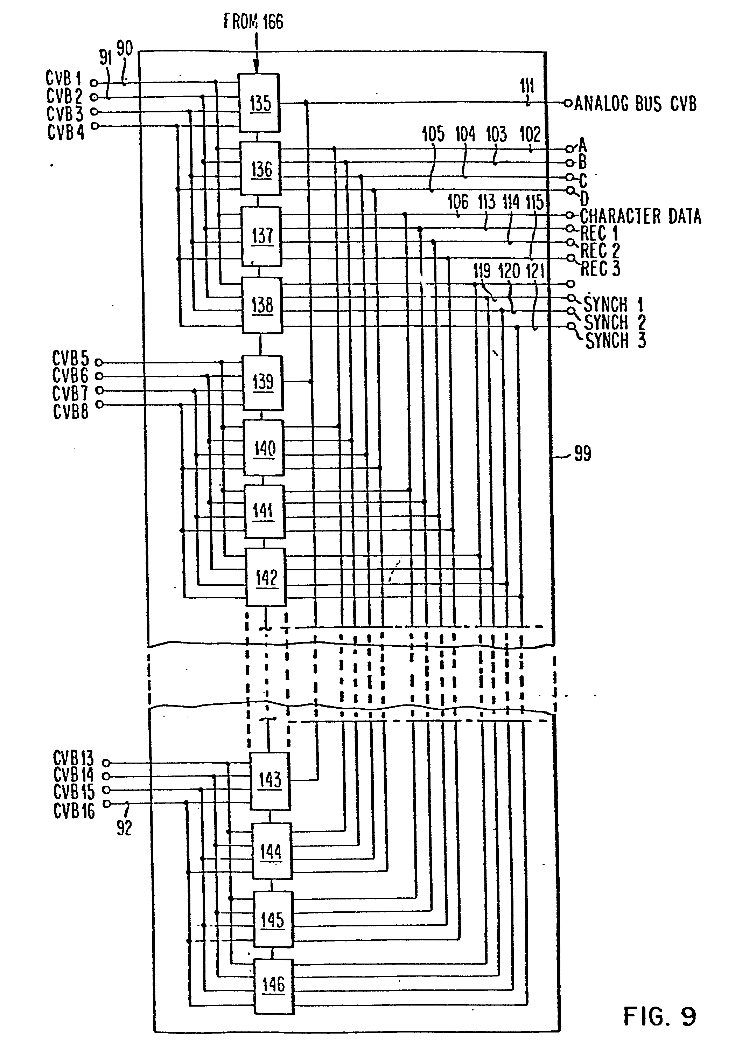

Die Figur 9 zeigt in detaillierter Darstellung den inneren prinzipiellen Aufbau des Multiplexers 99, so wie er nach Aufbau und Funktionsweise im Zusammenhang mit der Sternschaltung der Figur 8 vorher schon erläutert wurde. Die Verteilung der verschiedenen Signale im Multiplexbetrieb auf die unterschiedlichen Ausgangsleitungen übernehmen gebräuchliche Analogschalter 135 bis 146 im Innern des Multiplexers.

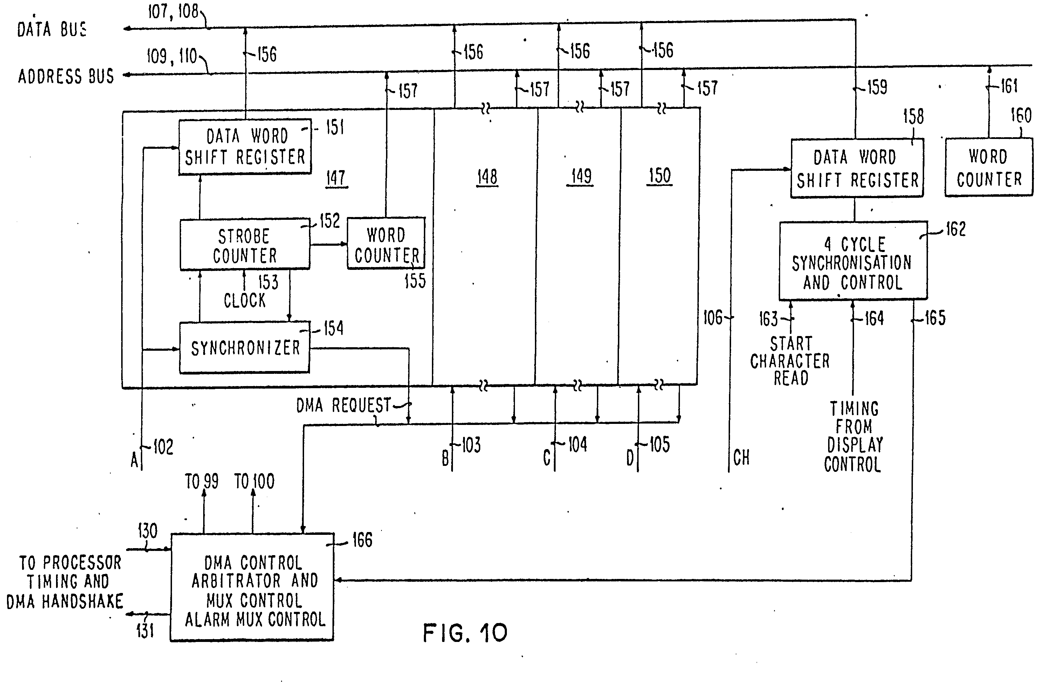

Die Figur 10 zeigt den inneren Aufbau der Steuereinrichtung 101 gemäss Figur 8 in der Verschaltung zwischen Multiplexer 99 einerseits und Bildwiederholungsspeicher 97 und zentralem Prozessor 98 andererseits. Die Steuereinrichtung umfasst, was die orts- und zeitgerechte Weiterleitung der verzögerten Daten A bis D betrifft, vier Einzelblöcke 147 bis 150, von denen jeder im Prinzip im Innern so aufgebaut ist, wie es für den Block 147 im Detail dargestellt ist. Jeder der Blöcke 147 bis 150 umfasst also ein Schieberegister 151 für Datenwörter (data word shift register), einen Zähler 152 (strobe counter) zum Takten des Schieberegisters, der einen Clock-Eingang 153 beinhaltet, einen Synchronisierer 154 (synchronizer) für den Zähltakt und einen Wort-Zähler 155 (word counter) für die Adressen. Die Ausgangsdaten des Daten-Schieberegisters 151 gehen über einen Ausgang 156 auf die Datenbusse 107, 108 für Bildwiederholungsspeicher 97 und zentralen Prozessor 98. Die Ausgangsadressen des Wort-Zählers 155 gehen entsprechend über einen Ausgang 157 zu den Adress-Bussen 109, 110 für Bildwiederholungsspeicher und zentralen Prozessor.

Die Steuereinrichtung 101 umfasst darüber hinaus für die Weiterleitung von Zeichenadressen CH wieder ein Schieberegister 158 für Datenwörter mit Ausgang 159 zu den Daten-Bussen 107, 108 und einen Wort-Zähler 160 mit Ausgang 161 zu den Adress-Bussen 109, 110. Der Block 162 umfasst wieder eine Synchronisier- und Steuereinrichtung (four cycle synchronization and control) mit Starteingang 163 zum Starten des Lesens eines Zeichens (start character read) und Eingang 164 für den Zeittakt, der den Bildaufbau des Zeichens kontrolliert (timing from display control, siehe hierzu nochmals die Figur 6 in Verbindung mit Figur 5). Ein Ausgang 165 führt zu einer Kontrolleinheit 166 (DMA Control Arbitrator and Multiplexer Control), die über die Leitungen 130 und 131 in Kommunikation mit dem zentralen Prozessor steht.

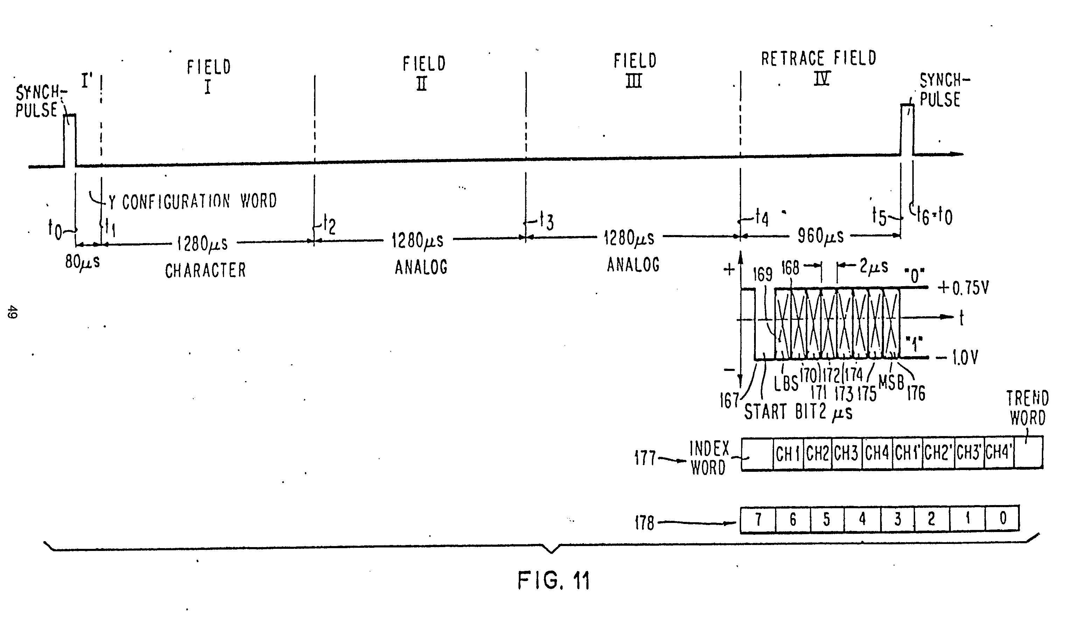

Wie schon erwähnt, werden zum Mischen von Signalspuren verzögerte Daten (delayed data) verwendet, die in den jeweiligen Rückführphasen (retrace time) der x-Ablenkung anfallen. Die Zeitdauer dieser Rückführphase beträgt 960 µs, was in der Figur 11 oben zur Erinnerung an Figur 4 nochmals belegt wird. Abweichend von der Figur 4 ist in der Figur 11 unterhalb des schon beschriebenen Zeitdiagrammes jedoch noch ein Impulsplan eingezeichnet, der rein schematisch die Datenübertragung im Feld IV während der Rückführphase der x-Ablenkung abhandeln soll. Die Datenübertragung erfolgt in digitaler Form. Wie schon beim y-Konfigurationswort des Phase I′ wird auch bei den digitalen Signalen der Retrace time IV der Zustand NULL («0») durch das Auftreten des Spannungsniveaus +0,75 V und der Zustand EINS («1») durch das Auftreten des Spannungsniveaus −1 V im Composite Video Signal belegt. In der Rückführphase IV können nun bis zu zehn Digitalworte übertragen werden, von denen jedes 8 bit aufweist. In der Rückführphase IV wird bis auf die Zeiten der Übertragung digitaler Worte eine NULL («0») übermittelt, d.h. das Composite Video Signal befindet sich auf dem Niveau +0,75 V. Jeweils etwa 50 µs nach Beginn der Rückführphase wird mit der Übermittlung von digitalen Worten begonnen. Jedes zu übermittelnde Wort wird mit einem Startbit 167 eröffnet, das 2 µs lang ist und das eine EINS («1») signalisiert. Auf dieses Startbit folgt dann jeweils ein Wort 168, das aus 8 bit's 169 bis 176 besteht, von denen jedes ebenfalls 2 µs lang ist. Die einzelnen bit's 169 bis 176 können NULL oder EINS-Status aufweisen, je nach Gehalt des Wortes. In der Figur 11 sind diese Wechselmöglichkeiten zwischen NULL und EINS schematisch durch je zwei Diagonalen in jedem bit angedeutet. In jedem Wort ist das jeweils erste bit mit LSB und das jeweils letzte bit mit MSB bezeichnet. LSB steht für «Least Significant Bit» und MSB für «Most Significant Bit». Damit ist für jedes Wort die Richtung festgelegt, in der die bit's dieses Wortes zu lesen sind. Innerhalb der Rückführphase IV von insgesamt 960 µs werden also bis zu zehn derartiger 8-bit-Worte übermittelt, wobei jedes neue Wort durch ein neues Startbit angekündigt und eingeleitet wird. Zwischen Ende des letzten Wortes einer solchen Folge und Ende der Rückführphase liegen darüber hinaus noch ca. 60 µs an Reservezeit.

In der Figur 11 ist eine solche Folge von z.B. zehn Worten zu je 8 bit mit der Kennziffer 177 angedeutet. Das jeweils erste Wort einer solchen Folge, das immer übermittelt wird, ist ein Index Wort. Dieses Index Wort, das in Figur 11 im Detail in der untersten Darstellung unter der Kennziffer 178 in seine 8 bit's aufgegliedert dargestellt ist, gibt Information über Ablaufgrössen für die Aufzeichnung, wie z.B. über Aufzeichnungsgeschwindigkeit (speed), die Kanalauswahl (channel CHAN 1 to CHAN 4 bzw. CHAN 1′ to CHAN 4′), das Vorhanden- oder Nichtvorhandensein von Trendwerten (trend points), das Vorliegen von aktuellen und/oder verzögerten Messwerten (real time data, delayed data) etc. Die auf das Index Wort folgenden weiteren ersten vier Worte definieren verzögerte Signalwerte für die vier Kanäle CHAN 1, CHAN 2, CHAN 3 und CHAN 4 und sind in dieser Bezeichnung in der Wortgruppe 177 auch eingetragen. Bei niedrigster Signalübertragungsgeschwindigkeit fällt pro Rückführphase normalerweise nur je ein ältester Messwert an. Bei höchster Geschwindigkeit können jedoch bis zu zwei älteste Messwerte anfallen. Diese zuletzt genannte Möglichkeit berücksichtigt eine Wortgruppe 177 durch vier weitere Worte, die in der Figur 11 mit CHAN 1′, CHAN 2′, CHAN 3′, CHAN 4′ gekennzeichnet sind. Sofern als pro Rückführphase insgesamt zwei verzögerte Messwerte anfallen, so findet sich das jeweilige Paar in den Wortpaaren CHAN 1 und CHAN 1′, CHAN 2 und CHAN 2′ etc. Das zehnte und letzte Wort der Wortgruppe 177 ist schliesslich ein Wort für einen Trendwert, sofern ein solcher Trendwert vorher von einem Trendverwerter, insbesondere Trendrecorder, über das Indexwort angefordert worden war.

Zusammen ergibt sich also das folgende Schema einer Wortgruppe mit z.B. zehn Worten:

| | | |
|---|---|---|
| Wort 1: | Index Wort | wird immer übermittelt |
| Wort 2: | CHAN 1 | belegt bei niedrigster Anfallrate 1 Wort/9,778 ms (12,5 mm/s) und bei höchster Anfallrate 2 Worte/ 4,884 ms (50 mm/s) |
| Wort 3: | CHAN 2 | |
| Wort 4: | CHAN 3 | |
| Wort 5: | CHAN 4 | |
| Wort 6: | CHAN 1′ | nicht belegt ausser bei höchster Anfallrate von 2 Worten/4,884 ms (50 mm/s) |
| Wort 7: | CHAN 2′ | |
| Wort 8: | CHAN 3′ | |
| Wort 9: | CHAN 4′ | |
| Wort 10: | Trendpunkt | nur übermittelt bei Anforderung durch Trendrecorder |

Das 8 bit-Indexwort setzt sich beispielsweise wie folgt zusammen:

BIT's 7 und 6

Sie legen die Rate für neueste Messwerte nach folgender Tabelle fest.

| BIT 7 | BIT 6 | |
|---|---|---|
| 0 | 0 | es liegt kein Messwert vor |
| 0 | 1 | 1 Messwert pro Kanal und pro 9,778 ms |
| 1 | 0 | 1 Messwert pro Kanal und pro 4,884 ms |
| 1 | 1 | 2 Messwerte pro Kanal und pro 4,884 ms |

BIT's 5 und 4

Sie legen die Kanalnummer nach folgender Tabelle fest:

| BIT 5 | BIT 4 | |
|---|---|---|
| 0 | 0 | Oberer Kanal CHAN 1 |
| 0 | 1 | Mittlerer Oberer Kanal CHAN 2 |
| 1 | 0 | Mittlerer Unterer Kanal CHAN 3 |
| 1 | 1 | Unterer Kanal CHAN 4 |

BIT 3

Dieses BIT legt fest, ob ein Trendwort für den nächsten Kanal vorhanden ist.

| | | |
|---|---|---|
| BIT 3 | = 0 | kein Trendwort vorhanden |
| BIT 3 | = 1 | Trendwort vorhanden |

BIT's 2 und 1

Sie legen fest, ob die Daten verzögerte Daten (delayed data) oder Echtzeitdaten (real time data) sind.

| BIT 2 | BIT 1 | |
|---|---|---|
| 0 | 0 | normal, alle Daten sind verzögerte Daten (delayed data) |
| 0 | 1 | Kanal 4 gestoppt, Aufzeichnung von Echtzeitdaten (Transfer mode) |
| 1 | 0 | Kanal 4 in Cascade Mode |
| 1 | 1 | alle Kanäle gestoppt, Aufzeichnung von Echtzeitdaten (real time data) |

| BIT 0 | |
|---|---|
| 1 | Übertragung ist gültig |
| 0 | Übertragung ist ungültig |

Wie schon erwähnt, wird ein Trendwort nur dann übermittelt, wenn die Übermittlung angefordert wurde. Diese Anforderung kann von einem Recorder kommen, der dem Bettseit-Gerät beigeordnet ist. Sie kann aber auch via UART durch einen zentralen Recorder der Zentralstation kommen (siehe hierzu nochmals Beschreibung zu Figur 5).

Die Figur 12 zeigt den mechanischen Prinzipaufbau eines elektromedizinischen Überwachungsgerätes mit vier Einschubmodulen, so wie es in Verbindung mit der Erfindung bevorzugt als Bettseit-Gerät eingesetzt wird. Das Gerät umfasst also ein Gerätegehäuse 179 mit der Frontfläche 180. Auf der rechten Seite der Frontfläche ist eine Öffnung für eine Ausnehmung im Innern des Gerätegehäuses mit 181 angedeutet. Durch diese Öffnung 181 können in die Ausnehmung insgesamt vier Einschubmodule eingeschoben werden, die hier in Übereinstimmung mit dem Geräteprinzipschaltbild der Figur 5 wieder mit 1, 2, 3 und 4 beziffert sind. Das Gerät ist mit einem x-, y-, z-Oszilloskop ausgerüstet, dessen Bildschirm mit 182 angedeutet ist. Die Elemente 184, 185 an der Frontplatte sind Bedien- und Anzeigeelemente, wie Tastenschalter, LED-Anzeigefelder etc. Ihre Anordnung ist rein schematisch dargestellt. Das Element 186 deutet die früher schon beschriebene LED-Leuchttaste für die Anzeige und Übernahme des fremden Alarmes an. Das Element 187 kennzeichnet z.B. die Rücksetztaste für einen Alarm im eigenen Gerät.

Das in der Figur 12 dargestellte Gerät ist wieder speziell ein elektromedizinisches Gerät. Die Einschubmodule 1 bis 4 sind also Teil des Signalübertragungssystems für physiologische Signale, die mittels geeigneter Abnehmer am Körper eines Patienten abgenommen werden. Zu diesem Zwekke werden also (nicht dargestellte) Abnehmer am Körper des Patienten positioniert und über ein Signalkabel (ebenfalls nicht dargestellt) am jeweiligen Einschub angekoppelt. Die Einschübe umfassen zu diesem Zweck also Ansteckbuchsen 188 bis 191 für entsprechende Stecker der Signalkabel. Die restlichen Elemente 192 bis 195 sind in wieder nur rein schematischer Andeutung Datentasten oder LED-Anzeigefelder der Einschubmodule. Im Beispiel der Figur 12 ist beispielsweise der unterste Einschub 4 ein $CO_2$-Einschub, die beiden mittleren Einschübe sind z.B. Einschübe für Blutdruck- und Temperaturmessung und der obere Einschub 1 dient z.B. zur EKG-Messung. Das abgebildete Gerät kann zusammen mit weiteren gleichartigen Geräten zu einer Kette mit Aufbau und Funktionsweise, wie sie in der Figur 7 dargestellt ist, zusammengeschaltet werden. Ebensogut kann das beschriebene Gerät mit einer entsprechenden Zahl weiterer Geräte zusammen mit einer Zentrale zu einer Sternschaltung zusammengefügt werden, wie sie in der Figur 8 dargestellt ist.

Die Reihenfolge, in der im Gerät der Figur 12 die einzelnen Einschubmodule 1 bis 4 angeordnet sind, ist völlig beliebig.

Dies wird in einfachster Weise gemäss den Figuren 13 bis 15 dadurch gewährleistet, dass dem vorverarbeitenden Mikroprozessor im Gerät auf der Seite der Einschubmodule 1 bis 4 in Signalübertragungsrichtung vor jeder Koppelstelle 8, 9 wenigstens je ein Analog-Digital-Konverter 196 pro Einschub 1 bis 4 zugeordnet ist. Völlig unabhängig davon, von welcher Art die Einschubmodule sind und in welcher Reihenfolge bzw. räumlicher Zuordnung zueinander die Einschubmodule in der Einbuchtung des Gerätes eingesteckt sind, werden nun von der Seite des Gerätes her die einzelnen Analog-Digital-Konverter 196 sämtlicher eingesteckter Module 1 bis 4 nach einem fest vorgegebenen Rhythmus zur Konversion getaktet. Die Zuordnung einzelner konvertierter Signalwerte zu einem Modul erfolgt auf der Seite des Verarbeitungsteiles in einfachster Weise durch ein Identifikationssignal für jeden einzelnen Modul 1 bis 4, das zeitverschachtelt zusammen mit den konvertierten Signalwerten übermittelt wird.

Im Gesamtschema dieser Übermittlungsweise soll nun der Analog-Digital-Konverter 196 eines jeden Einschubmodules 1 bis 4 möglichst preiswert sein und dazu auch noch gleichzeitig mit möglichst hoher Effektivität arbeiten. Gemäss dem vorliegenden Ausführungsbeispiel der Figuren 13 bis 15 wird dies dadurch gewährleistet, dass Analog-Digital-Konverter 196 eingesetzt werden, die bei einer relativ niedrig vorgegebenen Konversionsrate pro Zeiteinheit hinsichtlich der unterschiedlichen Frequenzen einzelner Signale in den unterschiedlichen Frequenzkanälen mit entsprechend unterschiedlicher Häufigkeit abgetastet werden. Die Figur 13 zeigt beispielsweise im Prinzipschaltbild den wesentlichen Innenaufbau eines EKG-Einschubes mit drei Kanälen 1H, 1A, 1B. Der Kanal 1H ist dabei ein Höchstgeschwindigkeitskanal; dieser Kanal, der sich nur im EKG-Einschub befindet, wird 2400mal in der Sekunde abgetastet. Durch diese hohe Abtastfrequenz werden im EKG solche Vorgänge, die überdurchschnittlich hochfrequent sind, z.B. arhythmische Ereignisse oder Pacemaker-Impulse, erfasst und angezeigt. Der Höchstgeschwindigkeitskanal 1H arbeitet also nur in Verbindung mit einem zusätzlichen Arhythmie-Verarbeitungsteil (z.B. Arhythmie-Computer). Der Kanal 1A ist hingegen der Hauptdatenkanal für das EKG. Dieser Kanal 1A wird insgesamt 400mal in der Sekunde abgetastet. Der Kanal 1B kann als zweiter Datenkanal für eine weitere Messgrösse dienen. Dieser Kanal wird nur 200mal in der Sekunde abgetastet. Das für die Kanäle 1A und 1B Gesagte gilt im Prinzip entsprechend auch für die restlichen drei Einschubmodule 2 bis 4. In diesen Einschubmodulen sind entsprechende Kanäle 2A, 3A und 4A bzw. 2B, 3B und 4B vorhanden.

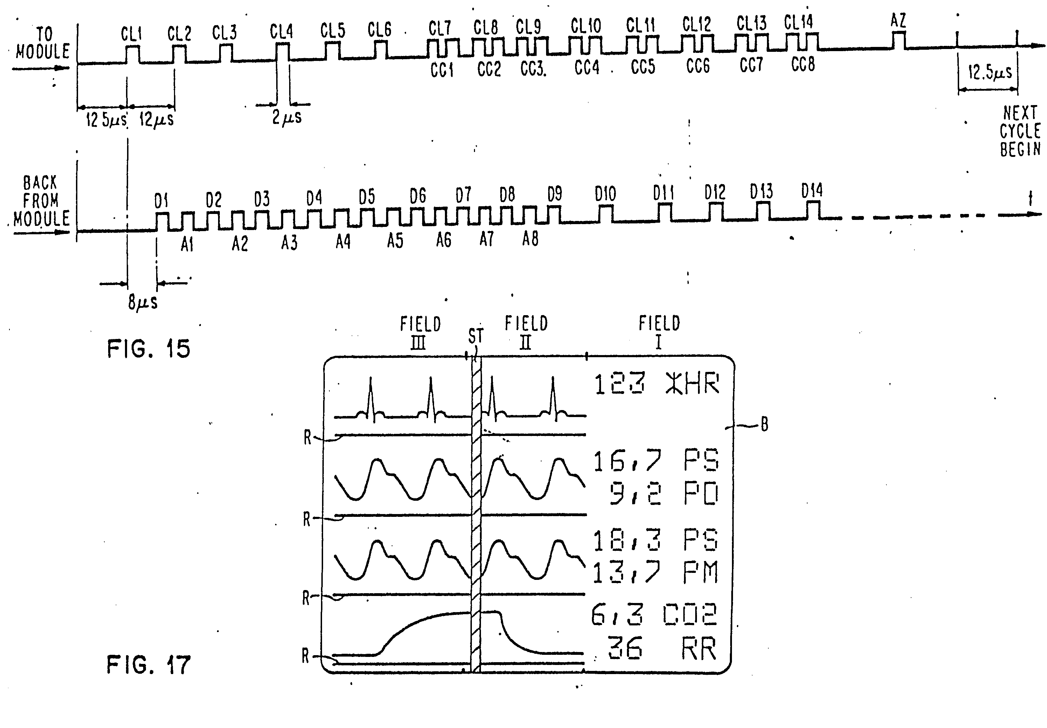

Wie schon angedeutet, sind sämtliche vier Einschübe, was die Kanäle A und B betrifft, gleichartig aufgebaut. Entsprechend der Darstellung der Figur 13 umfassen sie also alle die Signaleingänge E11 und E12. Auf diese Signaleingänge folgen je ein Vorverstärker 197 und 198. Jeder der Vorverstärker hat einen Steuereingang 199 bzw. 200, an dem durch Steuersignal der Verstärkungsgrad reguliert werden kann. Die Einstellung kann anhand von Bit-Kombinationen vorgenommen werden, die zusammen mit einem Konfigurationswort für die Konversion zum signalverarbeitenden Teil auf der Geräteseite zum jeweiligen Modul übertragen werden. Dasselbe gilt z.B. auch für die Durchlassfrequenzen von Frequenzfiltern 201 und 202, die über entsprechende Steuereingänge 203 bzw. 204 des jeweiligen Filters ebenfalls in Abhängigkeit von entsprechenden Bit-Kombinationen im Konversions-Konfigurationswort einstellbar sind. Auf die Filter 201 und 202 folgen Zustandsmelder 205 und 206, die an Ausgängen 207 und 208 durch entsprechende Bit-Signale den jeweiligen Zustand melden, in dem sich der Modul im betreffenden Kanal befindet. Die Zustandsmelder 205 und 206 umfassen in bekannter Weise z.B. solche Messglieder, die feststellen, ob die Abnehmer für die einzelnen Signale am Patientenkörper richtig positioniert sind und ob die Signalaufnahme und Übertragung in den Kanälen selbst in Ordnung ist. Diese Daten werden zusammen mit Identifikationssignalen für den jeweiligen Modul und z.B. auch noch zusammen mit weiteren Daten, die beispielsweise über ein Tastenfeld eines Moduls eingegeben wurden, als sogenanntes Hilfswort (Auxiliary Word) vom Modul in Richtung Verarbeitungsteil des Gerätes übertragen. In der Figur 13 ist das Tastenfeld eines Moduls mit der Ziffer 211 schematisch angedeutet. Zur Übermittlung des Hilfswortes dient ein 8 Bit-Schieberegister 212, das an vier Eingängen 213 zu je 1 Bit Hilfsdaten von den Signalgebern 205 und 206 und gegebenenfalls vom Tastenfeld 211 entgegennimmt. Die vier Bits der restlichen vier Eingänge 214 des Schieberegisters 212 formulieren das Identifikationssignal für den jeweiligen Modul. Diese vier Eingänge 214 für das Identifikationssignal sind also in entsprechender Modifikation für jeden Modul unterschiedlich fest verdrahtet. Das Hilfswort (Auxiliary Word) des Schieberegisters 212 eines jeden Einschubmoduls wird zusammen mit den digitalen Messdaten des Analog-Digital-Konverters 196 über die Sendediode 8 dem zugehörigen Fotoempfänger 9 im Signalverarbeitungsteil des Gerätes übermittelt. Die Signalfolge aus digitalen Daten, die also vom jeweiligen Modul 1 bis 4 in das Gerät gesendet wird, ist in der Figur 15 unten dargestellt. Die Pulse D1 bis D14 sind die digitalen Messdaten des Analog-Digital-Konverters 196. Die dazwischen gelagerten acht Pulse A1 bis A8 sind die Hilfsdaten; sie formen also das Hilfswort (Auxiliary Word) und sie beinhalten die Identifikationssignale zur Identifikation des jeweils sendenden Moduls.

Die Pulsfolge, die von einem jeweiligen Lichtsender 10 auf der Seite des Gerätes zu einem Lichtempfänger 11 auf der Seite des jeweiligen Moduls 1 bis 4 übertragen wird und die den Konversionstakt für den jeweiligen Analog-Digital-Konverter 196 vorgibt, ist in der Figur 15 oben angedeutet. Diese Pulsfolge umfasst pro Konversions-Zyklus insgesamt vierzehn Pulse CL1 bis CL14. Die dazwischen gelagerten Pulse CC1 bis CC8 sind die jeweils 8 Bit, die als Konfigurationswort zur Einstellung der Filter und Verstärker aufgrund von Befehlen dienen, die von der Geräteseite her übermittelt werden. Diese Befehle können durch den jeweiligen Mikroprozessor auf der Geräteseite selbst erzeugt werden. Es können jedoch auch solche Befehle sein, die z.B. durch Tastendruck zuvor vom Einschub her eingegeben und als Bestandteil des Hilfswortes (Auxiliary Word) vom Modul zum Gerät übertragen worden waren und von dort nach entsprechender Umsetzung im jeweiligen Mikroprozessor als Bestandteil des Konfigurationswortes wieder zum Einschub zurückgesendet worden waren. Die Einschubmodule selbst beinhalten keine aktiven Steuerelemente, wie z.B. moduleigene Mikroprozessoren oder dergleichen. Eine Befehlseingabe am Modul über Tasten wirkt also niemals direkt auf den Modul; sie nimmt vielmehr immer den Umweg über den jeweiligen Mikroprozessor im Signalverarbeitungsteil des Gerätes. Dementsprechend umfasst also jeder Zyklus von Konversionspulsen auch entsprechende Pulse eines Konfigurationswortes, mit deren Hilfe im jeweiligen Einschub Befehle ausgeübt werden können.

Wie schon erwähnt, beinhaltet jeder Konversionszyklus insgesamt vierzehn Taktpulse für entsprechend vierzehn Konversionen am Analog-Digital-Konverter 196. Die Taktpulse sind jeweils 2 µs lang und ihr Abstand untereinander beträgt je 12 µs. Im Abstand von 24 µs auf den jeweils vierzehnten Taktpuls CL14 folgt in jedem Zyklus schliesslich auch noch ein letzter Puls AZ. Dieser Puls AZ ist ein sogenannter Auto Zero Puls, der über ein Pulsformglied 215 (z.B. Monoflop) den Analog-Digital-Konverter 196 automatisch auf NULL setzt. Berücksichtigt man, dass der jeweils erste Taktpuls CL1 erst 12,5 µs nach Beginn eines Zyklus erzeugt wird und der jeweilige Zyklus erst 12 µs nach Auftreten des AZ Pulses beendet ist, so ergibt sich die Gesamtdauer eines Zyklus zu jeweils 204,5 µs. Jeweils weitere 12,5 µs nach Ende eines Zyklus beginnt dann ein neuer Zyklus, wie in der Figur 15 oben auch schematisch im Pulsdiagramm angedeutet ist.

Im Prinzipschaltbild der Figur 13 gehen die anfallenden Taktimpulse CL1 bis CL14 für den Konversionstakt direkt auf den Analog-Digital-Konverter 196. Die acht Pulse CC1 bis CC8 des Konfigurationswortes werden hingegen in ein 8 Bit-Schieberegister 216 eingeschrieben. Während der Zeitdauer der Einschreibung des jeweiligen Wortes eines Zyklus in das Schieberegister 216 läuft jedoch noch der Konversionstakt des vorhergehenden Zyklus. Das Konversionswort des vorhergehenden Zyklus befindet sich in einem 8 Bit-Schieberegister 217. Während also ein normaler Konversions-Zyklus noch läuft, ist im Schieberegister 216 Information für den nächstfolgenden Zyklus bereits gespeichert. Der jeweilige Modul ist also bereits auf die Forderungen des nächstfolgenden Zyklus eingestellt, obgleich dieser Zyklus noch gar nicht begonnen hat. Durch diese besonders trickreiche Art der Vorabspeicherung eines Konfigurationswortes mit Befehlsdaten für einen nächstfolgenden Zyklus wird zusätzlich Zeit bei der Konversion gewonnen. Jedes im Schieberegister 216 eingespeicherte Konfigurationswort wird mit Eingang des letzten Impulses CC8 direkt parallel vom zweiten Schieberegister 217 übernommen. Damit steht am Ausgang des zweiten Schieberegisters 217 das Konfigurationswort für den nächstfolgenden Zyklus zur Verfügung.

Das 8 Bit-Schieberegister 217 liefert, wie vorher schon erwähnt, an sechs Ausgängen 220 zu einer Steuereinheit 220a insgesamt sechs Bit Einstellinformation für z.B. Verstärker und Filter. Die beiden restlichen Bits an den Ausgängen 218 und 219 sind Schaltbits für die Abtastschalter 209 und 210 der Kanäle 1A und 1B. Aus diesen wird mittels UND-Glied 220b auch noch ein drittes Schaltsignal für einen Abtastschalter 221 im Hochgeschwindigkeitskanal 1H erzeugt, welcher Kanal 1H ein Filter 222 mit Steuereingang 222a für Hochfrequenzkomponenten umfasst. Die beiden Bits der Ausgänge 218 und 219 des Schieberegisters 217 legen also fest, mit welcher Rate die einzelnen Kanäle 1H, 1A bis 4A, 1B bis 4B der einzelnen Einschubmodule 1 bis 4 abgetastet werden. Gemäss bevorzugter Ausführung der Erfindung ist die Abtastrate über eine Periodendauer von 4880 µs mit folgender Sequenz festgelegt:

1H, 1A, 1H, 2A, 1H, 3A, 1H, 4A, 1H, 1B, 1H, 2B
1H, 1A, 1H, 2A, 1H, 3A, 1H, 4A, 1H, 3B, 1H, 4B

Der in der Figur 13 dargestellte Analog-Digital-Konverter 196 kann im Prinzip so aufgebaut sein, wie er in der US-PS 3 588 881 beschrieben ist. Das Glied 223 zwischen den Abtastschaltern 209, 210, 221 und dem Analog-Digital-Konverter 196 ist ein übliches Sample and Hold-Glied. Am Ausgang des Analog-Digital-Konverters 196 sitzt eine Puls-Mixstufe 223a.

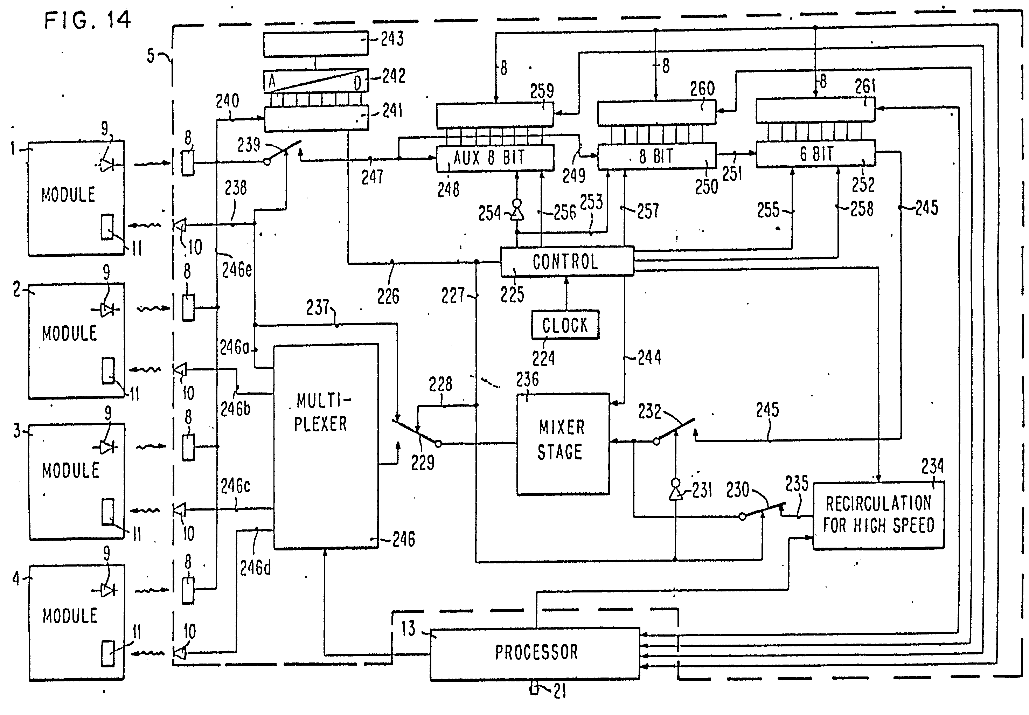

Die Figur 14 zeigt den prinzipiellen inneren Schaltungsaufbau des Kontroll- und Ankoppelboards 5, so wie es den Einschüben zur Signal- und Energieankoppelung auf der Seite des Gerätes gegenübersteht. Im Vergleich mit Figur 5 ist der vorarbeitende Mikroprozessor (Preprocessor) wieder mit 13 bezeichnet. Der Pfeil 21 führt in Richtung Hauptspeicher 15 (shared memory).

Der Grundtakt für die Pulse eines Konversionszyklus wird von einem Taktgeber 224 (Zähler) geliefert, der vom vorverarbeitenden Prozessor 13 synchronisiert wird. Die Pulse des Taktgebers gehen in ein Steuerwerk 225. In diesem Steuerwerk läuft über entsprechende Pulsschalter der vorstehend beschriebene Abtaktzyklus 1H, 1A, 1H, 2A, etc. Jeder Taktpuls für 1H geht auf eine Taktleitung 226 und auf eine Taktleitung 227. Der Taktpuls der Leitung 226 taktet ein Schieberegister eines Arhythmie-Zusatzes.

In der Leitung 227 steuert derselbe Taktpuls hingegen über die Leitung 228 einen Schalter 229 in die gezeichnete Schaltstellung. Gleichzeitig wird ein Schalter 230 geschlossen und über ein Invertierglied 231 ein Schalter 232 geöffnet. Mit jedem Taktpuls für 1H wird aber auch über eine Steuerleitung 233 ein Abrufsignal für ein Umlaufregister 234 (recirculation register for high speed) erzeugt, in dem ständig Konversionspulse 1H im Umlauf sind. Das Abrufsignal bewirkt die Ausgabe eines Pulses 1H am Ausgang 235 des Umlaufregisters 234. Von dort gelangt der Puls 1H über den zu dieser Zeit geschlossenen Schalter 230 zu einer Überlagerungsstufe 236, die ihn über den Schalter 228 zur Leitung 237 und von dort über die Leitung 238 zur Sendediode 10 des Sendekanals für den obersten Einschubmodul 1 weiterleitet. Die Sendediode 10 sendet den Puls 1H in Richtung Fotoempfänger 11 im Modul 1, der ihn dann als 1H-Tastimpuls einerseits zum Analog-Digital-Wandler 196 und andererseits zur Formation der Schieberegister 216, 217 weiterleitet. Der Puls 1H öffnet ausserdem noch einen Schalter 239. Dadurch werden Abtastwerte des 1H-Kanals, die in diesem Augenblick vom Analog-Digital-Konverter des Moduls 1 geliefert werden, nur zum Schieberegister 241 eines Arhythmie-Zusatzes 241 bis 243 geleitet. Von diesem Schieberegister 241 gelangt der jeweilige 1H-Messwert zu einem Digital-Analog-Konverter 242, der ihn zu seinem Analogwert rückwandelt. Der Analogwert kann auf einen Recorder 243 gegeben werden. Das Ergebnis ist dann eine Analogsignalkurve, die über Ereignisse im EKG Auskunft gibt, die übernormal hochfrequent sind.

Die Überlagerungsstufe 236 ist eine Pulsmischstufe, in der den Pulsen 1H in der vorgegebenen Sequenz die restlichen Tastpulse für die Kanäle 1A bis 4A und 1B bis 4B über eine Leitung 244 zugemischt werden. Diesen Pulse werden schliesslich über eine Leitung 245 auch noch die acht Pulse CC1 bis CC8 des Konfigurationswortes, das in den jeweiligen Modul rückübertragen werden soll, beigefügt. Die Beimischung erfolgt jeweils über den geschlossenen Schalter 232. Die so gemischte Pulsfolge wird über den ausserhalb der Takte 1H in die gestrichelte Stellung gesteuerten Schalter 228 einem Multiplexer 246 zugeführt. Dieser Multiplexer taktet dann, gesteuert vom vorverarbeitenden Prozessor 13, die Sendedioden 10 über Leitungen 246a, 246b, 246c und 246d. Von diesen werden entsprechend der erwünschten Taktfolge Lichtimpulse zu den Fotoempfängern 11 auf der Seite der Einschubmodule 1 bis 4 übermittelt, von wo sie dann schliesslich als Konversionstakt zu den Analog-Digital-Konvertern 196 bzw. als Konfigurationswort zu den Schieberegistern 216, 217 gelangen.

Im Fall der Figur 14 ist der Hochgeschwindigkeitkanal für die 1H-Abtastung einem Einschub in oberster Position fest zugeordnet. Relativ hochfrequente Ereignisse treten in der Praxis jedoch höchstens in Verbindung mit der EKG-Messung auf. Damit wird also ein High Speed Signal praktisch nur dann empfangen, wenn der EKG-Modul in die erste Position gesteckt ist. Sitzt in dieser Position hingegen ein Einschub für niederfrequentere Signale, so läuft die Hochgeschwindigkeitsabtastung 1H leer. Wird also High Speed Abtastung gewünscht, so muss der EKG-Einschub in die Position 1 gesteckt werden. Alle andere Positionen sind jedoch beliebig frei wählbar.

Wie in der Figur 15 unten dargestellt ist, empfängt das Gerät vom jeweiligen Modul 1 bis 4 Messwerte D1 bis D14 zusammen mit einem Hilfswort A1 bis A8. In diesem Hilfswort steckt auch das Identifikationssignal für den jeweiligen Einschubmodul. Gemäss der Figur 14 werden nun alle von den Fotoempfängern 9 auf der Seite des Gerätes empfangenen Pulse auf eine Pulsleitung 246c gegeben, von wo sie über den Schalter 239, der zum Zeitpunkt des Anfallens solcher Pulse immer geschlossen ist, zur Leitung 247 gelangen. Von dort werden sie einerseits zum Eingang eines ersten 8 Bit-Schieberegisters 248 weitergereicht. Andererseits gelangen sie über eine Leitung 249 auch auf den Eingang eines zweiten 8 Bit-Schieberegisters 250. Pulse, die im Überlauf das zweite Schieberegister 250 verlassen, werden über eine Leitung 251 in ein drittes Schieberegister 252 eingetaktet, das zwar prinzipiell ebenfalls ein 8 Bit-Schieberegister ist, das jedoch lediglich nur 6 Bit Daten übernimmt.

Die Schieberegister 248, 250 und 252 werden vom Steuerwerk über Taktleitungen 253, 254 und 255 getaktet. Dabei laufen die Schieberegister 250 und 252 im Gegentakt zum Schieberegister 248, das über ein Invertierglied 254 angesteuert wird. Die Leitungen 256, 257 und 258 sind Enable-Steuerleitungen für das jeweilige Schieberegister.

Der Gegentakt am Schieberegister 248 hat zur Folge, dass von diesem Register nur solche Daten der anfallenden Pulsfolge eingeschrieben werden, die in Pausen der Messwertdaten D1 bis D14 anfallen. Solche Daten sind jedoch Daten A1 bis A8 des Hilfswortes (Auxiliary Word). Damit erfasst also das 8 Bit-Schieberegister 248 die Daten des Hilfswortes. Das in Gegentakt arbeitende zweite 8 Bit-Schieberegister 250 taktet hingegen Messwertdaten. Sobald die ersten acht Einzeldaten angefallen sind, erfolgt Überlauf zum Schieberegister 252. Am Ende eines jeden Konversionszyklus beinhaltet das 8 Bit-Schieberegister 248 also das Hilfswort, während im 8 Bit-Register 250 die Messdaten D14 bis D7 und im Register 252 die Messdaten D6 bis D1 gespeichert sind. Die gespeicherten Daten können nun gruppenweise durch Zwischenspeicher (latches) 259, 260 und 261 zum vorverarbeitenden Prozessor überführt werden. Von dort können sie dem Hauptspeicher zugeleitet und zur weiteren Verarbeitung dem Hauptprozessor überlassen werden. Der Zwischenspeicher 261 und das Schieberegister 252 dienen auch zur Übertragung des Konfigurationswortes vom Preprocessor 13 zur Leitung 245 in solchen Zeiten, in denen im Schieberegister 252 gerade keine Messdaten gespeichert werden.

Die Figur 16 zeigt das Zusammenspiel zwischen vorverarbeitendem Mikroprozessor (preprocessor), Hauptspeicher (shared memory) und zentralem Mikroprozessor (central processor) eines Gerätes gemäss Figur 5 im detaillierten Prinzipschaltbild.

Wie eingangs schon erwähnt wurde, ist der Vorprozessor 13 nicht DMA-fähig. Der zentrale Mikroprozessor 14 ist hingegen DMA-fähig, d.h. dieser Prozessor steht in fester Zugriffsordnung zum Hauptspeicher 15. Durch besonderen Schaltungstrick wird nun der an sich nicht DMA-fähige vorverarbeitende Mikroprozessor 13 so präpariert, dass er DMA-fähig wird.

Der Trick ist dabei folgender:

Der Vorprozessor 13 erlässt in bestimmten Zeitabständen an den Hauptprozessor 16 eine DMA-Anforderung. Dies geschieht in der Weise, dass am Ausgang des vorverarbeitenden Prozessors 13 eine bestimmte Adresse erscheint. Im vorliegenden Ausführungsbeispiel der Figur 16 besteht diese Adresse z.B. aus drei binären Einsen. Diese Adresse gelangt über eine Adressleitung 263 auf einen Dekoder 264. Dieser Dekoder 264 erkennt die ausgewählte Adresse immer dann, wenn sie anfällt. Er erzeugt daraufhin an seinem Ausgang 265 einen DMA-Puls. Dieser Puls gelangt nun über eine erste Zweigleitung 266 zum zentralen Mikroprozessor 14. Gleichzeitig wird er über eine zweite Zweigleitung 267 auf ein Taktverzögerungsglied 268 gegeben.

Der am zentralen Mikroprozessor 14 eintreffende DMA-Puls löst dort eine DMA-Anforderung aus. Der zentrale Prozessor 14 führt also lediglich noch diejenigen Operationen zu Ende, die er vor dem Eintreffen der DMA-Anforderung in Angriff genommen und noch nicht zu Ende geführt hatte. Der zentrale Mikroprozessor wird also im Augenblick des Eintreffens einer DMA-Anforderung nicht sofort abgeschaltet; bis zur Abschaltung (sämtliche Ausgangspuffer des zentralen Prozessors nehmen einen hochohmigen Widerstandswert ein) vergeht noch eine gewisse Zeit. Während dieser Zeitdauer, während der also der zentrale Prozessor 14 mit dem Hauptspeicher 15 noch in Kommunikation steht, muss gewährleistet sein, dass der vorverarbeitende Mikroprozessor 13 vom Zugriff zum Hauptspeicher 15 noch abgeschaltet bleibt.

Dies geschieht in einfachster Weise durch das Taktverzögerungsglied 268. Bei diesem Taktverzögerungsglied handelt es sich um einen Frequenzuntersetzer, der die Taktfrequenz, mit der der vorverarbeitende Prozessor 13 im normalen Zustand getaktet wird, auf einen gegenüber dem Normalwert sehr viel geringeren Wert herabsetzt. Im vorliegenden Ausführungsbeispiel liegt der Normalwert der Taktfrequenz bei etwa 4 MHz, was einem Pulsabstand der Taktpulse von 0,25 µs entspricht. Wird das Taktverzögerungsglied 268 durch den DMA-Puls angestossen, so verringert es die Taktfrequenz auf einen Wert von etwa 0,333 MHz. Der Abstand zwischen den Taktpulsen liegt jetzt also bei etwa 3 µs.

Der Normalwert der Taktfrequenz wird von einem Taktgeber 269 vorgegeben, der sowohl für den zentralen Prozessor 14 als auch für den vorverarbeitenden Prozessor 13 die Arbeitstakte liefert. Die Taktpulse des Taktgebers 269 gelangen über die Taktleitung 270 zum Frequenzuntersetzer 268. Solange dieser auf Normalbetrieb geschaltet ist, werden die Taktimpulse der Leitung 270 unverzögert über die Leitung 271 dem vorverarbeitenden Prozessor 13 als Arbeitstakte zugeleitet. Liegt hingegen ein DMA-Puls am Frequenzuntersetzer an, so tritt der vorstehend schon beschriebene Arbeitsgang ein; es werden also die Taktimpulse der Taktleitung 270 in der beschriebenen Weise in der Taktfrequenz untersetzt. Zum vorverarbeitenden Mikroprozessor 13 gelangen dann über die Leitung 271 also nur noch Taktpulse der untersetzten Frequenz. Der vorverarbeitende Prozessor 13 wird hierdurch in seinem Arbeitsablauf verzögert; er ist trotz bereits ergangener DMA-Anforderung noch nicht kommunikationsbereit. Dies ändert sich in dem Augenblick, in dem vom zentralen Prozessor 14 ein Rückmeldesignal abgegeben wird, mit dem der zentrale Prozessor bestätigt, dass seine eigene Kommunikation mit dem Hauptspeicher 15 abgeschlossen ist.

In der Figur 16 erscheint dieses Rückmeldesignal als DMA-Enable Signal in der Ausgangsleitung 272 des zentralen Prozessors. Von hier aus wird es über einen Leitungszweig 273 einerseits auf das Taktverzögerungsglied 268 gegeben; andererseits wird es auch gleichzeitig über einen zweiten Leitungsweg 274 den Ausgangspuffern (Buffer) 275, 276 und 277 des vorverarbeitenden Prozessors 13 zugeleitet. Das Enable-Signal bewirkt am Taktverzögerungsglied 268, dass dieses in seine normale Arbeitslage zurückgesetzt wird. Das Glied 268 lässt ab diesem Augenblick also wieder Taktimpulse des Taktgebers 269 mit Normalfrequenz über die Ausgangsleitung 271 zum vorverarbeitenden Prozessor 13 passieren. Der vorverarbeitende Prozessor 13 arbeitet demnach wieder mit seiner normalen Arbeitsfrequenz. Das DMA-Enable Signal schaltet ausserdem die vorher hochohmigen Ausgangspuffer 275 bis 277 des vorverarbeitenden Prozessors 13 auf Durchlass. Damit sind alle Voraussetzungen der DMA-Fähigkeit erfüllt; der vorverarbeitende Prozessor 13 kann jetzt also über die niederohmigen Ausgangspuffer 275 bis 277 mit dem Hauptspeicher 15 in Kommunikation treten.

Damit ist also ein an sich nicht DMA-fähiger Vorprozessor so geschaltet, als ob er DMA-fähig ist. Der beschriebene Schaltungstrick arbeitet mit einfachsten technischen Mitteln; eine zusätzliche Software-Unterstützung des Vorprozessors zur Erzeugung der DMA-Anforderung ist nicht nötig. Alle wichtigen Arbeitsgänge werden durchgeführt, ohne dass der Vorprozessor selbst davon Kenntnis nimmt.

Bei der Signalwiedergabe mit Hilfe von dynamischen Wiederholungsspeichern gibt es bekanntlich zwei Möglichkeiten der Signaldarstellung:

Bei der ersten Möglichkeit handelt es sich um jene, bei der älteste Information im Speicher jeweils kontinuierlich durch neueste Information ersetzt wird. Am Bildschirm des Darstellungsgerätes führt dies zu einem kontinuierlichen Signalzug aus jeweils ältesten und neuesten Messwerten. Diese Darstellungsart, die wandernde Signalzüge erzeugt, wird üblicherweise als «paper mode» bezeichnet.

Eine zweite Darstellungsart ist jene des sogenannten «fixed mode». Hier läuft die einmal in den Speicher eingegebene Signalinformation zyklisch um, ohne dass älteste Information durch neueste Information ersetzt wird. Es entsteht am Bildschirm des Darstellungsgerätes ein eingefrorenes Signalbild. Damit nun am ständig umlaufenden eingefrorenen Bild erkannt werden kann, wo sich im Signalzug Anfang und Ende befinden, wird in üblicher Technik bei Übergang auf «fixed mode» in die Aufzeichnung ein Vertikalbalken eingeblendet, der zusammen mit der Information ständig über den Bildschirm wandert. Der wandernde Vertikalbalken gibt die Grenze zwischen neuer und alter Signalinformation im Speicher an. Er lässt somit erkennen, wo das umlaufende Signal seinen Anfang hat und wo es endet.

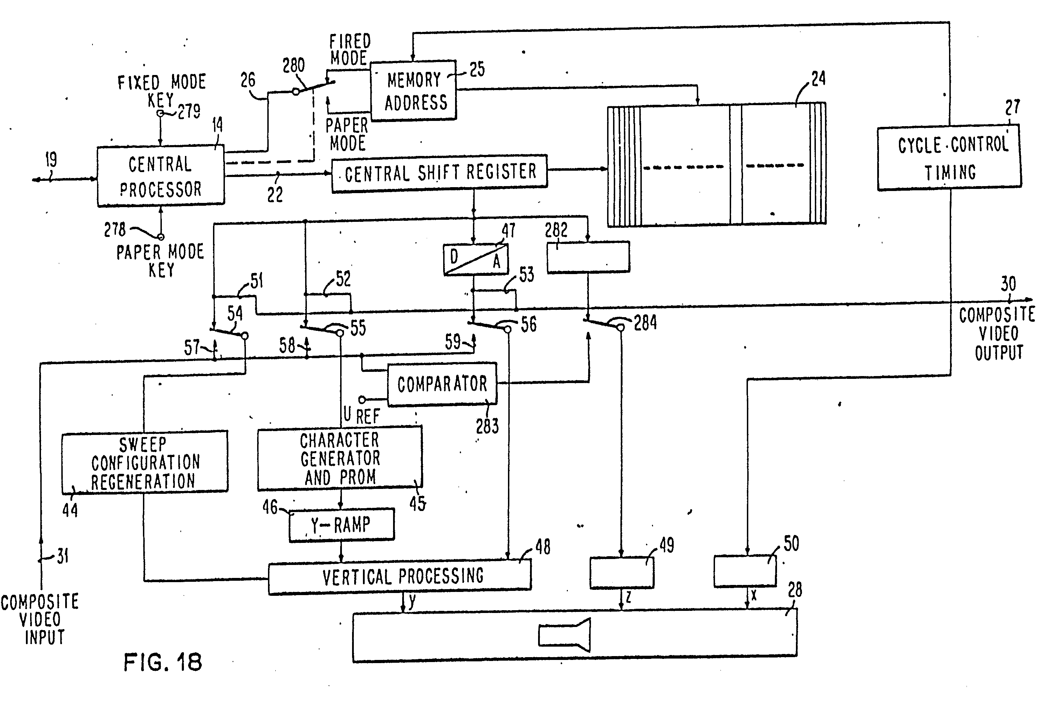

Die Figur 17 zeigt die Signal- und Zeichendarstellung der Figur 2 im «fixed mode» mit wanderndem Vertikalbalken ST. Die Erzeugung eines Vertikalbalkens für «fixed mode» bereitet keine Schwierigkeiten für den normalen bekannten Anwendungsfall, dass nämlich die vom Bildwiederholungsspeicher zyklisch ausgegebene Information direkt auf das eigene Darstellungsgerät gegeben wird.

Probleme entstehen jedoch bei Anwendung des «fixed mode» auf Composite Video Darstellung. Eine direkte Übertragung eines Dunkeltastimpulses, der Grundlage für eine Balkenanzeige ist, zwischen einzelnen Geräten einer Ketten- oder Sternkonfiguration ist nicht möglich.

Die Figur 18 zeigt ein Prinzip, wie besonders trickreich und ohne grossen zusätzlichen Schaltungsaufwand auch für Composite Video die Anwendung der Balkendarstellung möglich ist, so dass auch hier eine wahlweise Darstellung im «paper mode» oder im «fixed mode» erfolgen kann. Das Prinzipschaltbild der Figur 18 ist dem Prinzipschaltbild der Figur 6 sehr ähnlich. Es ist lediglich noch durch solche Bauelemente ergänzt, die zur Balkenerzeugung notwendig sind. Demgemäss besitzt also das Gerät des Prinzipschaltbildes der Figur 18 zwei Wahltasten 278 und 279. Mittels der Taste 278 kann der Betriebszustand «paper mode» gewählt werden; mit der Taste 279 kann auf «fixed mode» geschaltet werden.

Das Drücken einer Wähltaste 278 oder 279 wird vom zentralen Mikroprozessor 14 als Wahl einer bestimmten Betriebsart registriert.

Im Normalfall steht der Schalter 280 am Eingang des Adressrechners 25 in der Schaltstellung «paper mode». Mit Betätigung der Taste 278 ist die Betriebsart «paper mode» also bereits angewählt. Die Schaltung arbeitet so, wie es in den vorausgegangenen Passagen geschildert wurde.

Wird hingegen die Wähltaste 279 gedrückt, so erzeugt der zentrale Mikroprozessor 14 ein Umschaltsignal für den Schalter 280. Der Schalter 280 wird also in die Schaltstellung «fixed mode» gesteuert.

Damit ergibt sich im Unterschied zu «paper mode» der folgende Funktionsablauf:

Der Zugang von neuer Messwert-Information zum Bildwiederholungsspeicher 24 wird vom zentralen Mikroprozessor 14 gesperrt. Seitens des Adressrechners 25 wird jedoch ein Adress-Streifen aus z.B. insgesamt 16 × 8 EINSEN erzeugt. Dieser Adress-Streifen wird nun vom Adressrechner an jene Stelle im Bildwiederholungsspeicher 24 eingeschrieben, an der im Speicher älteste Signalinformation auf jeweils neueste Signalinformation trifft. Der Adress-Streifen 281 aus binären EINSEN grenzt also im Speicher den Signalanfang gegenüber dem Signalende ab.

Der Adress-Streifen 281 aus 16 × 8 EINSEN wird nun zusammen mit der ständig umlaufenden gespeicherten Signalinformation zyklisch vom Bildwiederholungsspeicher 24 über das zentrale Schieberegister 23 in Richtung Darstellungsgerät ausgegeben. Dabei gelangen die EINSEN auf ein logisches Gatter 282, das dem z-Helltastgenerator des x-, y-, z-Oszilloskops vorgeschaltet ist. Das logische Gatter erkennt das Vorliegen eines Adress-Streifens aus EINSEN; es erzeugt daraufhin während der Zeitdauer des Anfallens der EINSEN ein Dunkeltastsignal für den z-Helltastgenerator 49, das diesem über den in der dargestellten Schaltstellung befindlichen Schalter 284 zugeleitet wird. Der Helltastgenerator 49 bleibt also während der Zeitdauer des Dunkeltastsignals ausgeschaltet.

Jeder Adress-Streifen 281 aus EINSEN, der vom Bildwiederholungsspeicher 24 über das Schieberegister 23 ausgegeben wird, trifft gleichzeitig aber auch auf den Eingang des Analog-Digital-Konverters 47. Der Analog-Digital-Konverter 47 erzeugt daraufhin einen Ausgangsimpuls, dessen Amplitude wegen der nur aus EINSEN bestehenden Eingangsinformation sehr viel höher ist als normale anfallende Signalamplituden. Diese hochamplitudige Ausgangsimpuls gelangt auf die Vertikalablenkeinrichtung 48 des Oszilloskops 28. Er führt dort zu einer Übersteuerung. Der Elektronenstrahl des Oszilloskops wird sehr rasch und sehr weit über den Bildschirm ausgelenkt. Die Flanken des Impulses sind wegen der sehr raschen Strahlablenkung nicht sichtbar. Der gleichzeitig eintreffende Dunkeltastimpuls führt zur Dunkeltastung in den Grenzen des Ablenkimpulses. Am Bildschirm des Oszilloskops wird also ein Dunkelstreifen für «fixed mode» sichtbar. Dieser Dunkelstreifen wandert zusammen mit der ständig umlaufenden Signalinformation des eingefrorenen Bildes über den Bildschirm des Oszilloskops. Es ist damit also immer eine eindeutige visuelle Aussage möglich darüber, wo sich im wandernden Bild gerade der Anfang der abgebildeten Signale befindet und wo das Ende.

Der am Ausgang des Analog-Digital-Konverters 47 anfallende Ausgangsimpuls sehr hoher Amplitude gelangt jedoch nicht nur zum geräteeigenen Oszilloskop; er wird auch immer gleichzeitig über den Leitungsanschluss 53 als Bestandteil des normalen Composite Video Signals dem Composite Video Output 30 des Gerätes zugeführt. Von dort gelangt er auf den Composite Video Bus, sofern der Ausgang 30 am Bus angeschaltet ist.

Was den Empfangsteil eines Gerätes betrifft, so ist dort folgende Abänderung vorgesehen:

Im Empfangsteil ist an der Leitung 59, die vom Composite Video Input 31 zum Schalter 56 für das Analogsignal führt, ein Komparator 283 angeschaltet. Dieser Komparator 283 besitzt einen Referenzspannungseingang, an dem eine Referenzspannung $U_{ref}$ liegt. Ist also ein beliebiges Gerät auf «fixed mode» geschaltet und soll dieses Gerät Composite Video Signale eines anderen Gerätes empfangen, das ebenfalls im «fixed mode» arbeitet, so werden der Composite Video Output des sendenden Gerätes und der Composite Video Input des empfangenden Gerätes miteinander verbunden. Dies kann bei Kettenschaltung der Geräte über den gemeinsamen Composite Video Bus oder bei Sternschaltung der Geräte über den zentralen Composite Video Bus der Zentrale geschehen.

Das empfangende Gerät erhält jetzt ein Composite Video Signal, das im Analogteil einen Ausgangsimpuls hoher Amplitude als Streifensignal enthält. Das Auftreten des hochamplitudigen Impulses wird vom Komparator 283 als schwellwertüberschreitendes Ereignis erkannt. Der Komparator 283 erzeugt daraufhin während der Zeitdauer der Schwellwertüberschreitung ein Ausgangssignal. Dieses Ausgangssignal dient jetzt speziell als Austastsignal für den Helltastgenerator 49. Es wird dem Helltastgenerator 49 über den jetzt in die gestrichelte Schaltstellung gesteuerten Schalter 284 zugeführt. Der Helltastgenerator 49 bewirkt wieder Strahldunkeltastung während der Auftrittsdauer des fremden Streifenpulses. Am Bildschirm des empfangenden Gerätes erscheint jetzt also das «fixed mode»-Signalbild des fremden sendenden Gerätes mit eingeblendetem Vertikalbalken als Grenzangabe für Signalanfang und Signalende.

**Patentansprüche**

1. Verfahren zum Erzeugen von x-, y- und z-Koordinatensignalen zur Darstellung von Analogsignalen (A) und Zeichensignalen (CA) in verschiedenen Bildabschnitten (I, II, III) eines x-, y-, z-Darstellungsgeräts (28, 29), das an eine Übertragungsleitung angeschlossen ist, wobei das x-Koordinatensignal die Zeitablenkung auf dem Bildschirm, also die dortige x-Achse, das y-Koordinatensignal die Höhe der Ablenkung auf dem Bildschirm, also die dortige y-Achse, und das z-Koordinatensignal die Helligkeit der im x, y-Koordinatensystem dargestellten Information bestimmen, dadurch gekennzeichnet, dass das Verfahren folgende Schritte aufweist:

a. Zunächst wird über die Übertragungsleitung zum Darstellungsgerät (28, 29) ein Startsignal (SP) gegeben,

b. dann wird in zeitlicher Abhängigkeit von diesem Startsignal (SP) das x-Koordinatensignal [X(t)] mit fest vorgegebener Form ($X_R$) im Darstellungsgerät (28, 29) selbst erzeugt,

c. nach Auftreten des Startsignals (SP) wird ausserdem in zeitlicher Abhängigkeit von diesem Startsignal (SP) das y-Koordinatensignal [Y(t)] erzeugt, das zeitabschnittsweise

c1. aus Signalen ($Y_R$) mit fest vorgegebener Form, die im Darstellungsgerät (28, 29) selbst erzeugt werden und die sich von der Form des x-Koordinatensignals [X(t)] unterscheiden, und

c2. aus Pausen zwischen diesen Signalen ($Y_R$) besteht, wobei in diese Pausen die Analogsignale (A) über die Übertragungsleitung eingegeben werden,

d. nach Auftreten des Startsignals (SP) wird darüber hinaus in zeitlicher Abhängigkeit von diesem Startsignal (SP) das z-Koordinatensignal [Z(t)] erzeugt, das zeitabschnittsweise

d1. aus Signalen mit fest vorgegebener Form, die im Darstellungsgerät (28, 29) selbst erzeugt werden und die sich von den Formen der x- und y-Koordinatensignale [X(t), Y(t)] unterscheiden, sowie

d2. aus Pausen zwischen diesen Signalen besteht, wobei in diesen Pausen die Zeichensignale (CA) in die Übertragungsleitung eingegeben werden, und wobei die Pausen und Signale des z-Koordinatensignals [Z(t)] gegenüber den Pausen und Signalen des y-Koordinatensignals [Y(t)] zeitversetzt sind.

2. Verfahren nach Anspruch 1, dadurch gekennzeichnet, dass die Signale (Z = konstant) und Pausen des z-Koordinatensignals [Z(t)] gegenüber den Signalen ($Y_R$) und Pausen des y-Koordinatensignals [Y(t)] so zeitversetzt sind, dass während der Zeitdauer (z.B. Feld I und Feld III gemäss Figur 1), in der im Darstellungsgerät (28, 29) selbst die in der Form fest vorgegebenen Signale ($Y_R$) des y-Koordinatensignals [Y(t)] erzeugt werden, eine Pause im z-Koordinatensignal [Z(t)] vorliegt, innerhalb derer die Zeichensignale (CA) über die Übertragungsleitung eingegeben werden.

3. Verfahren nach Anspruch 2, dadurch gekennzeichnet, dass während der Zeitdauer (z.B. Feld II gemäss Figur 1), in der im Darstellungsgerät (28, 29) selbst die in der Form fest vorgegebenen Signale (Z = konstant) des z-Koordinatensignals [Z(t)] erzeugt wird, eine Pause im y-Koordinatensignal [Y(t)] vorliegt, innerhalb derer die Analogsignale (A) über die Übertragungsleitung eingegeben werden.

4. Verfahren nach einem der Ansprüche 1 bis 3, dadurch gekennzeichnet, dass die x-, y- und z-Koordinatensignale [X(t), Y(t), Z(t)] für ein x-, y-, z-Darstellungsgerät (28, 29) erzeugt werden, das mit den Signalgebern (23 bis 27) für jene Signale, die nicht im Darstellungsgerät (28, 29) selbst erzeugt werden, in einem gemeinsamen Gerätegehäuse (z.B. 179 gemäss Figur 12) untergebracht ist.

5. Verfahren nach einem der Ansprüche 1 bis 3, dadurch gekennzeichnet, dass die x-, y- und z-Koordinatensignale [X(t), Y(t), Z(t)] für ein x-, y-, z-Darstellungsgerät (28, 29) erzeugt werden, das in einem ersten Gerätegehäuse sitzt, das in räumlicher Entfernung zu einem zweiten Gerätegehäuse angeordnet ist, in dem die Signalgeber (23 bis 27) für jene Signale sitzen, die nicht im Darstellungsgerät (28, 29) erzeugt werden.

6. Verfahren nach Anspruch 4 und 5, dadurch gekennzeichnet, dass die x-, y- und z-Koordinatensignale erzeugt werden sowohl für ein x-, y-, z-Darstellungsgerät, das mit den Signalgebern (1 bis 27) in einem gemeinsamen Gerätegehäuse untergebracht ist, als auch für eine beliebige Zahl weiterer x-, y-, z-Darstellungsgeräte, die in anderen, davon räumlich getrennten Gerätegehäusen untergebracht sind.

7. Verfahren nach einem der Ansprüche 4 bis 6, dadurch gekennzeichnet, dass sämtliche Signale, die in einem x-, y-, z-Darstellungsgerät nicht selbst erzeugt werden, als kontinuierlicher Video-Signalzug (Composite Video Signal) ständig auch einem speziellen Signalausgang (Composite Video Output 30) zugeführt werden.

8. Verfahren nach Anspruch 7, dadurch gekennzeichnet, dass der Video-Signalzug (Composite Video Signal) von dem speziellen Signalausgang (Composite Video Output 30) in einen Bus (Composite Video Bus 64) einspeisbar ist.

9. Verfahren nach Anspruch 7 oder 8, dadurch gekennzeichnet, dass für jedes einzelne Darstellungsgerät (28, 29) auch ein spezieller Signaleingang (Composite Video Input 31) vorhanden ist, in den aus einem Bus (Composite Video Bus 64) fremde Video-Signalzüge (Composite Video Signal) eingespeist werden können.

10. Verfahren nach Anspruch 8 oder 9, dadurch gekennzeichnet, dass die Video-Signalzüge beliebiger Darstellungsgeräte (60 bis 63) über einen gemeinsamen Composite Video Bus (64) zueinander übertragen werden können (Kettenschaltung der Figur 7).

11. Verfahren nach Anspruch 8 oder 9, dadurch gekennzeichnet, dass die Video-Signalzüge (CVB 1 bis CVB n) beliebiger Darstellungsgeräte (84, 85, etc.) über je einen eigenen Composite Video Bus (90, 91, 92, etc.) zu einer Zentrale (83) übertragen werden können, die einen zentralen Video-Signalzug (CVC) erzeugt (Sternschaltung der Figur 8).

12. Verfahren nach Anspruch 11, dadurch gekennzeichnet, dass der zentrale Video-Signalzug (CVC) über einen zentralen Composite Video Bus (132) zu den anderen Darstellungsgeräten (84, 85, etc.) zurückgespeist werden kann.

13. Verfahren nach einem der Ansprüche 1 bis 12, dadurch gekennzeichnet, dass das Startsignal (SP) ein Synchronisier-Impuls ist, der mit einer seiner beiden Impulsflanken im Darstellungsgerät (28, 29) das x-Koordinatensignal [X(t)] auslöst.

14. Verfahren nach Anspruch 13, dadurch gekennzeichnet, dass der Synchronisier-Impuls das x-Koordinatensignal [X(t)] mit seiner Rückflanke auslöst.

15. Verfahren nach einem der Ansprüche 1 bis 14, dadurch gekennzeichnet, dass das Startsignal (SP) im x-, y-, z-Darstellungsgerät einen x-Spannungsgenerator (50) zur Erzeugung einer x-Rampenspannung ($X_R$) als x-Koordinatensignal [X(t)] anstösst.

16. Verfahren nach einem der Ansprüche 1 bis 15, dadurch gekennzeichnet, dass das y-Koordinatensignal [Y(t)] gegenüber dem Startsignal (SP) um eine vorgebbare Zeitdauer ($t_1$–$t_0$) verzögert erzeugt wird.

17. Verfahren nach Anspruch 16, dadurch gekennzeichnet, dass das y-Koordinatensignal [Y(t)] gegenüber dem Zeitpunkt ($t_0$), zu dem das impulsförmige Startsignal (SP) mit einer seiner beiden Flanken im Darstellungsgerät (28, 29) das x-Koordinatensignal [X(t)] auslöst, um eine vorgebbare Zeitdauer verzögert erzeugt wird.

18. Verfahren nach Anspruch 16 oder 17, dadurch gekennzeichnet, dass das y-Koordinatensignal [Y(t)] zu einem Zeitpunkt ($t_1$) erzeugt wird, der 80 µs später liegt als der Zeitpunkt ($t_0$), zu dem das impulsförmige Startsignal (SP) mit seiner Rückflanke das x-Koordinatensignal ($X_R$) auslöst.

19. Verfahren nach einem der Ansprüche 1 bis 18, dadurch gekennzeichnet, dass das z-Koordinatensignal [Z(t)] gegenüber dem Auftrittszeitpunkt des Startsignals (SP) um eine vorgebbare Zeitdauer ($t_1$–$t_0$) verzögert erzeugt wird.

20. Verfahren nach Anspruch 16 und 19, dadurch gekennzeichnet, dass diese vorgebbare Zeitdauer jener Zeitdauer ($t_1$–$t_0$) entspricht, um die das y-Koordinatensignal [Y(t)] verzögert erzeugt wird.

21. Verfahren nach einem der Ansprüche 1 bis 20, dadurch gekennzeichnet, dass die Signale ($Y = Y_R$) des y-Koordinatensignals [Y(t)], die im Darstellungsgerät (28, 29) selbst erzeugt werden, schnelle y-Raster sind.

22. Verfahren nach Anspruch 21, dadurch gekennzeichnet, dass die schnellen y-Raster ($Y = Y_R$) in Verbindung mit Tastsignalen eines Zeichengenerators (45), der im Darstellungsgerät (28, 29) sitzt, Grundlage für die Darstellung alphanumerischer Zeichen sind.

23. Verfahren nach Anspruch 22, dadurch gekennzeichnet, dass die Tastsignale des Zeichengenerators (45) an einer Helltasteinrichtung (49) des x-, y-, z-Darstellungsgerätes (28, 29) in Helltastimpulse umgesetzt werden.

24. Verfahren nach Anspruch 16 oder einem der Ansprüche 17 bis 23 bei Rückbeziehung auf Anspruch 16, dadurch gekennzeichnet, dass in der Zeitdauer ($t_1$–$t_0$) zwischen der Abgabe des Startsignals (SP) und der Erzeugung des y-Koordinatensignals [Y(t)] über die Übertragungsleitung zum Darstellungsgerät ein y-Konfigurationswort gegeben wird, dass zur orts-, form- und zeitgerechten Positionierung von y-Komponenten entsprechend einem Vorbild dient.

25. Verfahren nach Anspruch 24, dadurch gekennzeichnet, dass das Vorbild ein Signalbild eines ersten Darstellungsgerätes (z.B. 82 innerhalb 63 oder 8 innerhalb 84) ist, das auf ein zweites, davon räumlich getrenntes Darstellungsgerät (z.B. 79 innerhalb 60 oder 96 innerhalb 83) oder jedes beliebige weitere Darstellungsgerät übertragbar ist.

26. Verfahren nach einem der Ansprüche 1 bis 25, dadurch gekennzeichnet, dass die Analogsignale (A) benachbart zwischen den Zeichensignalen (CA) in die Übertragungsleitung eingegeben werden (Figur 1).

27. Verfahren nach einem der Ansprüche 1 bis 26, dadurch gekennzeichnet, dass die Analogsignale (A) physiologische Signale eines Patienten, insbesondere EKG-Signale, Blutdrucksignale, Atemsignale, $CO_2$-Signale oder dgl., sind.

28. Verfahren nach einem der Ansprüche 21 bis 27, dadurch gekennzeichnet, dass die Zeichensignale (CA) digitale Adress-Signale für einen Zeichengenerator (45) im Darstellungsgerät (28, 29) sind, der entsprechend dieser Adress-Signale in Übereinstimmung mit den raschen y-Rastern z-Tastsignale an einem Helltastgenerator (49) bewirkt.

29. Verfahren nach Anspruch 28, dadurch gekennzeichnet, dass durch wechselweise Adressansteuerung eines Zeichengenerators (45) pro Kanal in einem einzelnen Zeichenfeld (Feld I und/oder III in Figur 1) ein oder auch mehrere Zeichen, vorzugsweise bis zu zwei Zeichen, gleichzeitig einem einzelnen Analogsignal (A) zugeordnet werden.

30. Vorrichtung zum Erzeugen von x-, y- und z-Koordinatensignalen zur Darstellung von Analogsignalen (A) und Zeichensignalen (CA) in verschiedenen Bildabschnitten (I, II, III) eines x-, y-, z-Darstellungsgeräts (28, 29), das an eine Übertragungsleitung angeschlossen ist, wobei das x-Koordinatensignale die Zeitablenkung auf dem Bildschirm, also die dortige x-Achse, das y-Koordinatensignal die Höhe der Ablenkung auf dem Bildschirm, also die dortige y-Achse, und das z-Koordinatensignal die Helligkeit der im x-, y-Koordinatensystem dargestellten Information bestimmen, zur Durchführung des Verfahrens nach einem der Ansprüche 1 bis 29, gekennzeichnet durch

a. einen Startsignalgenerator (27) ausserhalb des Darstellungsgerätes (28, 29) zur wiederholten Erzeugung eines Startsignals (SP),

b. einen x-Spannungsgenerator (50) innerhalb des Darstellungsgerätes (28, 29) zur Erzeugung des x-Koordinatensignals ($X_R$) jeweils in zeitlicher Abhängigkeit vom Startsignal (SP),

c. einen y-Spannungsgenerator (46) innerhalb des Darstellungsgerätes (28, 29) zur Erzeugung des y-Koordinatensignals [Y(t)], das zeitabschnittsweise

c1. aus Signalen ($Y_R$) mit fest vorgegebener Form, die im Darstellungsgerät (28, 29) selbst erzeugt werden und die sich von der Form des x-Koordinatensignals [X(t)] unterscheiden, und

c2. aus Pausen zwischen diesen Signalen ($Y_R$) besteht,

d. einen z-Spannungsgenerator (45, 49) innerhalb des Darstellungsgerätes (28, 29) zur Erzeugung des z-Koordinatensignals [Z(t)], das zeitabschnittsweise

d1. aus Signalen mit fest vorgegebener Form, die im Darstellungsgerät (28, 29) selbst erzeugt werden und die sich von den Formen der x- und y-Koordinatensignale [X(t), Y(t)] unterscheiden, sowie

d2. aus Pausen zwischen diesen Signalen besteht,

e. einen ersten Signalgeber ausserhalb des Darstellungsgerätes (28, 29), der die Analogsignale (A) liefert,

f. einen zweiten Signalgeber ausserhalb des Darstellungsgerätes (28, 29), der die Zeichensignale (CA) liefert, und

g. eine Signalsteuereinrichtung (23, 24, 25),

g1. die in die Pausen (Feld II gemäss Figur 1) zwischen den im Darstellungsgerät (28, 29) selbst erzeugten Signalen ($Y_R$) des y-Koordinatensignals [Y(t)] die Analogsignale (A) in die Signaldarstellung eingibt, und

g2. die in den zu diesen Pausen zeitversetzten Pausen (Felder I und III gemäss Figur 1) zwischen den im Darstellungsgerät (28, 29) selbst erzeugten Signalen des z-Koordinatensignals [Z(t)] die Zeichensignale (CA) in die Signaldarstellung eingibt.

31. Vorrichtung nach Anspruch 30, dadurch gekennzeichnet, dass zwischen den Signalgebern (1 bis 24), die jene Signale (z.B. SP, A, CA) übermitteln, die im Darstellungsgerät (28, 29) selbst nicht erzeugt werden, und jenen Signalerzeugern (44 bis 50), die innerhalb des Darstellungsgerätes Signale ($X_R$, $Y_R$, Z = konstant, Helltastsignale für Zeichen) erzeugen, ein Abgriff (51 bis 53) für erstere Signale vorhanden ist, der zu einem speziellen Geräteausgang (Composite Video Output 30) führt.

32. Vorrichtung nach Anspruch 31, dadurch gekennzeichnet, dass der spezielle Geräteausgang (Composite Video Output 30) zu einem Bus (Composite Video Bus 64) führt, in den der am speziellen Geräteausgang (30) anfallende Video-Signalzug (Composite Video Signal) eingespeist werden kann.

33. Vorrichtung nach Anspruch 32, dadurch gekennzeichnet, dass bei einer Sternkonfiguration (Figur 8) mehrerer Bettseit-Einzelgeräte (84, 85, etc.) mit ständiger Zentrale (83), die einen zentralen Video-Signalzug erzeugt, sämtliche Video-Signalzüge (CVB 1 bis CVB n) der Einzelgeräte (84, 85, etc.) sternförmig über je einen geräteeigenen Bus (Composite Video Bus 90, 91, 92, etc.) zur Zentrale (83) geführt werden, so dass die Zentrale (83) auf einem zentralen x-, y-, z-Darstell- bzw. Anzeigegerät (96) den Video-Signalzug eines oder mehrerer der Einzelgeräte der Sternkonfiguration darstellen kann.

34. Vorrichtung nach Anspruch 33, dadurch gekennzeichnet, dass in der Sternkonfiguration (Figur 8) von der gemeinsamen Zentrale (83) ein zentraler Composite Video Bus (132) zu den Bettseit-Einzelgeräten (84, 85, etc.) zurückgeführt ist, so dass jedes Bettseit-Einzelgerät den zentralen Video-Signalzug (CVC) übernehmen und anstelle des eigenen Signalzuges am eigenen x-, y-, z-Anzeigegerät (86, 87, etc.) abbilden kann.

35. Vorrichtung nach Anspruch 32, dadurch gekennzeichnet, dass bei einer Gerätekonfiguration (Figur 7), in der mehrere Bettseit-Einzelgeräte (60 bis 63) ohne zusätzliche Zentrale in Kette geschaltet sind, die Video-Signalzüge einem einzigen, für alle Bettseit-Einzelgeräte (60 bis 63) gemeinsamen Composite Video Bus (64) zuführbar sind, und dass aus dem gemeinsamen Composite Video Bus (64) von einem beliebigen Einzelgerät (60, 61, 62 oder 63) oder von mehreren solcher Einzelgeräte der Video-Signalzug eines beliebigen anderen Einzelgerätes übernommen und anstelle des eigenen Video-Signalzuges am eigenen x-, y-, z-Anzeigegerät (79, 80, 81 oder 82) abgebildet werden kann.

36. Vorrichtung nach Anspruch 35, dadurch gekennzeichnet, dass zusätzlich zum gemeinsamen Composite Video Bus (64) sämtliche Bettseit-Einzelgeräte der Ketten-Konfiguration (Figur 7) auch noch über einen Alarm-Bus (65) miteinander verbunden oder verbindbar sind, der Alarmsignale aufnimmt und weiterleitet, die von einem Einzelgerät oder mehreren Einzelgeräten erzeugt werden, wenn die Signale eines solchen Einzelgerätes wenigstens einen kritischen Zustand eines angeschlossenen Patienten signalisieren.

37. Vorrichtung nach Anspruch 35 oder 36, dadurch gekennzeichnet, dass sämtliche Einzelgeräte (60 bis 63) auch über einen gemeinsamen Synchronisier-Bus (66) miteinander verbunden oder verbindbar sind, in den die Einzelgeräte jeweils das Startsignal (SP) zum Starten des x-Koordinatensignals [X(t)] einspeisen.

38. Vorrichtung nach Anspruch 37, dadurch gekennzeichnet, dass alle Einzelgeräte in der Erzeugung ihres x-Koordinatensignals [X(t)] durch jenes Startsignal (SP) gleichzeitig angestossen werden, das von allen eingespeisten Startsignalen zuerst auftritt.

39. Vorrichtung nach einem der Ansprüche 32 bis 38, dadurch gekennzeichnet, dass jedes Einzelgerät (60 bis 63; 84, 85, etc.) einer beliebigen Gerätekonfiguration (Figur 7; Figur 8) einen speziellen Geräteausgang (Composite Video Output 30) für den geräteeigenen Video-Signalzug und einen speziellen Geräteeingang (Composite Video Input 31) für einen gerätefremden Video-Signalzug besitzt.

40. Vorrichtung nach Anspruch 39, dadurch gekennzeichnet, dass dem speziellen Geräteausgang (30) und dem speziellen Geräteeingang (31) eines jeden Einzelgerätes gegensinnig arbeitende Schalter (71 bis 78; 133, 134, etc.) zugeordnet sind, die so steuerbar sind, dass wenigstens in jenem Falle, in dem ein Einzelgerät seinen Video-Signalzug in den Composite Video Bus einspeisen soll, der betreffende Video-Ausgangs-Schalter geschlossen ist, während der betreffende Video-Eingangs-Schalter geöffnet ist.

41. Vorrichtung nach Anspruch 40, dadurch gekennzeichnet, dass bei Kettenschaltung der Einzelgeräte (60 bis 63) ohne eigene Zentrale (Figur 7) bei einer Alarmgabe an einem Einzelgerät (z.B. 63) der Video-Ausgangs-Schalter (74) des betreffenden Einzelgerätes geschlossen wird, so dass der Video-Signalzug des alarmgebenden Einzelgerätes (63) in den Composite Video Bus (64) eingespeist wird.

42. Vorrichtung nach Anspruch 40 oder 41, dadurch gekennzeichnet, dass wenigstens für den Fall, dass mindestens eines der Einzelgeräte (z.B. 63) einer Kettenschaltung Alarm gibt, nur der Video-Ausgangs-Schalter (74) dieses Einzelgerätes (63) geschlossen ist, während die Video-Ausgangs-Schalter (71, 72, 73) aller anderen Einzelgeräte geöffnet sind.

**Claims**

1. A process for producing signals representing x, y and z coordinates of analogue signals (A) and characterising signals (CA) in different image sections (I, II, III) of an x, y and z coordinate display device (28, 29) connected to a transmission line, where the x coordinate signal determines the relative deflection period to position the x axis on the screen, the y coordinate signal determines the relative deflection to select the y axis on the screen, and the z coordinate signal determines the brightness of the information represented in the x and y coordinate system, characterised in that the process has the following steps:

(a) initially a start signal (SP) is transmitted to the display device (28, 29) via the transmission line;

(b) the x coordinate signal [X(t)] with a well defined shape ($X_R$) is subsequently produced within the display device (28, 29) in time-related dependence upon said start signal (SP);

(c) following the occurrence of the start signal (SP) the y coordinate signal [Y(t)] is produced in time-related dependence upon said start signal (SP), which y coordinate signal is a periodic signal consisting of:

(c1) well-defined signals ($Y_R$) produced within the display device (28, 29) which differ in shape from the x coordinate signals [X(t)], and

(c2) pauses between said signals ($Y_R$), into which pauses the analogue signals (A) are injected via the transmission line;

(d) following the occurrence of the start signal (SP) a periodic z coordinate signal [Z(t)] is produced in time-related dependence upon the start signal (SP), consisting of:

(d1) well-defined signals produced within the display device (28, 29) and differ in shape from the x and y coordinate signals [X(t)] and [Y(t)]; and

(d2) pauses between said signals, into which the characterising signals (CA) are injected via the transmission line, the pauses and signals of the z coordinate signal [Z(t)] being staggered in time relative to the pauses and signals of the y coordinate signal [Y(t)].

2. A process as claimed in Claim 1, characterised in that the signals (Z = constant) and pauses of the z coordinate signal [Z(t)] are staggered in time relative to the signals ($Y_R$) and pauses of the y coordinate signal [Y(t)] in such a manner that in the duration (e.g. field I and field III in accordance with Figure 1), wherein the well-defined shape signals ($Y_R$) of the y coordinate signal [Y(t)], are produced within the display device (28, 29), a pause in the z coordinate signal [Z(t)] occurring during which the characterising signals (CA) are injected via the transmission line.

3. A process as claimed in Claim 2, characterised in that within the period in which the well-defined signals (Z = constant) of the z coordinate signal [Z(t)], are produced in the display device (28, 29), (e.g. field II in accordance with Figure 1), a pause occurs in the y coordinate signal [Y(t)], during which the analogue signals (A) are injected via the transmission line.

4. A process as claimed in one of Claims 1 to 3, characterised in that the x, y and z coordinate signals, [X(t)], [Y(t)] and [Z(t)] are produced for an x, y and z display device (28, 29) which is accommodated in a common casing (e.g. 179 in accordance with Figure 12), together with the signal generators (23 to 27) for the signals which are not produced in the display device (28, 29) itself.

5. A process as claimed in one of Claims 1 to 3, characterised in that the x, y and z coordinate signals [X(t)], [Y(t)] and [Z(t)] are produced for an x, y and z coordinate display device (28, 29) positioned in a first casing arranged at a distance from a second casing, in which the signal generators (23 to 27) for the signals not produced in the display device (28, 29) itself are positioned.

6. A process as claimed in Claim 4 and 5, characterised in that the x, y and z coordinate signals are produced both for an x, y and z coordinate display device accommodated in a common casing together with the signal generators (1 to 27) and also for any number of further x, y and z display devices accommodated in other spatially separated casings.

7. A process as claimed in one of Claims 4 to 6, characterised in that all signals not produced in an x, y and z coordinate display device are constantly fed as a continuous signal train (composite video signal) to a specific signal output (composite video output 30).

8. A process as claimed in Claim 7, characterised in that the video signal train (composite video signal) is fed into a bus (composite video bus 64) from the specific signal output (composite video output 30).

9. A process as claimed in Claim 7 or 8, characterised in that for each individual display device (28, 29) a specific signal input is arranged, into which external video signal trains (composite video signals) are fed from a bus (composite video bus 64).

10. A process as claimed in Claim 8 or 9, characterised in that the video signal trains of any display devices (60 to 63) can be transmitted to one another via a common composite video bus (64) (chain circuit of Figure 7).

11. A process as claimed in Claim 8 or 9, characterised in that the video signal trains (CVB 1 to CVB n) of any display devices (84, 85 etc) can be transmitted via a separate composite video bus (90, 91, 92 etc) to a central unit (83) which produces a central video signal train (CVC) (star circuit of Figure 8).

12. A process as claimed in Claim 11, characterised in that the central video signal train (CVC) can be refed to the other display devices (84, 85 etc) via a central composite video bus (132).

13. A process as claimed in one of Claims 1 to 12, characterised in that the start signal (SP) is a synchronising pulse which triggers the x coordinate signal [X(t)] in the display device (28, 29) by its two pulse flanks.

14. A process as claimed in Claim 13, characterised in that the rear flank of the synchronising pulse triggers the x coordinate signal [X(t)].

15. A process as claimed in one of Claims 1 to 14, characterised in that the start signal (SP) in the x, y and z coordinate display device triggers an x-voltage generator (50) to produce an x-ramp voltage ($X_R$) as an x coordinate signal [X(t)].

16. A process as claimed in one of Claims 1 to 15, characterised in that the y coordinate signal [Y(t)] is produced delayed by a predeterminable period ($t_1$–$t_0$) in relation to the start signal (SP).

17. A process as claimed in Claim 16, characterised in that the y coordinate signal [Y(t)] is produced delayed by a predeterminable period in relation to the time ($t_0$) at which the pulse-shaped start signal (SP) triggers the x coordinate signal [X(t)] in the display device (28, 29) by one of its two flanks.

18. A process as claimed in Claim 16 or 17, characterised in that the y coordinate signal [Y(t)] is produced at a time ($t_1$) 80 µs later than the time ($t_0$) at which the pulse-shaped start signal (SP) triggers the x coordinate signal ($X_R$) by its rear flank.

19. A process as claimed in one of Claims 1 to 18, characterised in that the z coordinate signal [Z(t)] is produced delayed by a predeterminable period ($t_1$–$t_0$) relative to the time of occurrence of the start signal (SP).

20. A process as claimed in Claim 16 and 19, characterised in that the predeterminable period corresponds to the period ($t_1$–$t_0$) by which the y coordinate signal [Y(t)] is delayed.

21. A process as claimed in one of Claims 1 to 20, characterised in that the signals ($Y = Y_R$) of the y coordinate signal [Y(t)] produced in the display device (28, 29) are rapid y-rasters.

22. A process as claimed in Claim 21, characterised in that the rapid y-rasters ($Y = Y_R$) in combination with key signals of a character generator (45) positioned in the display device (28, 29) form the basis for the representation of alphanumerical characters.

23. A process as claimed in Claim 22, characterised in that the key signals of the character generators (45) are converted into unblanking pulses in an unblanking device (49) of the x, y and z display device (28, 29).

24. A process as claimed in Claim 16, or in one of Claims 17 to 23 when dependent upon Claim 16, characterised in that during the period ($t_1$–$t_0$) between the emission of the start signal (SP) and the production of the y coordinate signal [Y(t)] a y configuration word is fed to the display device via the transmission line, which y configuration word serves as a model for the correct location, shape and time positioning of y components.

25. A process as claimed in Claim 24, characterised in that the model is a signal image of a first display device (e.g. 82 within 53 or 8 within 84) which can be transferred to a second display device (e.g. 79 within 60 or 96 within 83) separate therefrom, or any further display device.

26. A process as claimed in one of Claims 1 to 25, characterised in that the analogue signals (A) are input into the transmission line so as to be adjacent between the characterising signals (CA) (Figure 1).

27. A process as claimed in one of Claims 1 to 26, characterised in that the analogue signals (A) are physiological signals of a patient, in particular ECG signals, blood pressure signals, breathing signals, $CO_2$-signals or the like.

28. A process as claimed in one of Claims 21 to 27, characterised in that the characterising signals (CA) are digital address signals for a character generator (45) in the display device (28, 29), which generator effects Z-key signals on an unblanking generator (49) in accordance with said address signals in conformity with the rapid y-rasters.

29. A process as claimed in Claim 28, characterised in that by an alternate address control of a character generator (45) per channel in an individual character field (field I and/or III in Figure 1) one or more characters, preferably up to two characters, are simultaneously assigned to one individual analogue signal (A).

30. Apparatus for the production of x, y and z coordinate signals for the representation of analogue signals (A) and characterising signals (CA) in different image sections (I, II, III) of an x, y and z coordinate display device (28, 29) connected to a transmission line, where the x coordinate signal determines the time deflection on the screen, namely the x-axis thereon, the y coordinate signal determines the level of the deflection on the screen, namely the y-axis thereon, and the z coordinate signal determines the brightness of the information represented in the x and y coordinate system, for the implementation of the process as claimed in one of Claims 1 to 29, characterised by:

(a) a start signal generator (27) outside the display device (28, 29) for the repeated production of a start signal (SP);

(b) an x-voltage generator (50) within the display device (28, 29) for the production of the x coordinate signal ($X_R$) in a time dependence upon the start signal (SP);

(c) a y-voltage generator (46) within the display device (28, 29) for the production of the y coordinate signal [Y(t)] which ist periodic and consists of:

(c1) signals ($Y_R$) of a well-defined shape produced within the display device (28, 29) and different from the shape of the x coordinate signal [X(t)]; and

(c2) intervals between said signals ($Y_R$);

(d) a z-voltage generator (45, 49) within the display device (28, 29) for the production of the z coordinate signal [Z(t)] which is periodic and consists of:

(d1) signals of a well-defined shape produced within the display device (28, 29) and differing from the shapes of the x and y coordinate signals [X(t)], [Y(t)]; and

(d2) intervals between said signals;

(e) a first signal generator outside the display device (28, 29) which supplies the analogue signals (A);

(f) a second signal generator outside the display device (28, 29) which supplies the characterising signals (CA); and

(g) a signal control device (23, 24, 25) which:

(g1) injects the analogue signals (A) into the signal display during the intervals between the signals ($Y_R$) of the y coordinate signals [Y(t)] produced in the display device (28, 29) (field II in accordance with Figure 1); and

(g2) injects the characterising signals (CA) into the signal display during the pauses (fields I and III in accordance with Figure 1), staggered in time relative to said intervals between the signals of the z coordinate signal [Z(t)] produced in the display device (28, 29).

31. Apparatus as claimed in Claim 30, characterised in that between signal generators (1 to 24) which transmit the signals (e.g. SP, A, CA) not produced in the display device (28, 29), and the signal producers (44 to 50) which produce signals within the display device ($X_R$, $Y_R$, Z = constant, unblanking signals for characters), there is arranged a tap (51 to 53) for earlier signals, which tap leads to a specific device output (composite video output 30).

32. Apparatus as claimed in Claim 31, characterised in that the specific output (composite video output 30) leads to a bus (composite video bus 64), into which the video signal train (composite video signal) which occurs at the specific device output (30) is fed.

33. Apparatus as claimed in Claim 32, characterised in that for a plurality of individual bedside devices (84, 85 etc) in a star configuration (Figure 8) with a constant central unit (83) which produces a central video signal train, all video signal trains (CVB 1 to CVB n) of the individual devices (84, 85 etc) are fed to the central unit (83) in a star-shaped fashion via a bus (composite video bus 90, 91, 92 etc) inherent to the apparatus, so that the central unit (83) can display the video signal train of one or more individual devices of the star configuration on a central x, y and z representation or display device (96).

34. Apparatus as claimed in Claim 33, characterised in that in the star configuration (Figure 8) a central composite video bus (132) is returned from the common central unit (83) to the individual bedside devices (84, 85 etc), so that each individual bedside device can take over the central video signal train (CVC) and represent it in place of the own signal train on the own x, y and z display device (86, 87 etc).

35. Apparatus as claimed in Claim 32, characterised in that in a device configuration (Figure 7) wherein a plurality of individual bedside devices (60 to 63) are connected in a chain without an additional central unit, the video signal trains can be fed to one single composite video bus (64) common to all individual bedside devices (60 to 63), and that the video signal train of any other individual device can be taken over from the common composite video bus (64) of any individual device (60, 61, 62 or 63) or a plurality of such individual devices and displayed in place of the own video signal train on the own x, y and z display device (79, 80, 81 or 82).

36. Apparatus as claimed in Claim 35, characterised in that in addition to the common composite video bus (64) all individual bedside devices of the chain configuration (Figure 7) are or can be connected to one another by means of an alarm bus (65) which receives alarm signals and transfers them, which alarm signals are produced by one individual device or a plurality thereof if an individual device signals one critical condition of a connected patient.

37. Apparatus as claimed in Claim 35 or 36, characterised in that all individual devices (60 to 63) are connected or can be connected to one another by means of a common synchronising bus (66), into which the individual devices respectively feed the start signal (SP) in order to start the x coordinate signal [X(t)].

38. Apparatus as claimed in Claim 37, characterised in that for production of their x coordinate signal [X(t)] all individual devices are simultaneously started by the first occurring input start signal (SP).

39. Apparatus as claimed in one of Claims 32 to 38, characterised in that each individual device (60 to 63; 84, 85 etc) of any device configuration (Figure 7; Figure 8) has a specific device output (composite video output 30) for the device-inherent video signal train and a specific device input (composite video input 31) for an external video signal train.

40. Apparatus as claimed in Claim 39, characterised in that the specific device output (30) and the specific device input (31) of each individual device are assigned opposingly operating switches (71 to 78; 133, 134 etc) controllable such that at least in each case in which an individual device is to feed its video signal train into the composite video bus, the respective video output switch is closed, whereas the respective video input switch is open.

41. Apparatus as claimed in Claim 40, characterised in that in the case of a chain connection of the individual devices (60 to 63) without a separate central unit (Figure 7), during the generation of an alarm on an individual device (e.g. 63) the video output switch (74) of the respective individual device is closed, so that the video signal train of the alarm-generating individual device (63) is fed into the composite video bus (64).

42. Apparatus as claimed in Claim 40 or 41, characterised in that at least for the case that at least one of the individual devices (e.g. 63) of a chain connection raises an alarm, only the video output switch (74) of said individual device (63) is closed, whereas the video output switches (71, 72, 73) of all other individual devices are open.

**Revendications**

1. Procédé pour produire des signaux de coordonnées en x-, y- et z- pour représenter des signaux analogiques (A) et des signaux de signes (CA) dans différentes sections (I, II, III) dans l'appareil de représentation en x-, y-, z- (28, 29) qui est relié à une ligne de transmission, du type selon lequel le signal de coordonnée en x- détermine la déviation du temps sur l'écran d'image, donc son axe x, le signal de coordonnée en y détermine la hauteur de la déviation sur l'écran d'image, donc son axe y et le signal de coordonnée z détermine la luminosité de l'information représentée dans le système de coordonnées x, y, caractérisé en ce que ledit procédé comporte les phases opératoires suivantes:

a. tout d'abord on applique par l'intermédiaire de la ligne de transmission, un signal de démarrage (SP) à l'appareil de représentation,

b. ensuite, et en fonction du temps de ce signal de démarrage (SP), le signal de coordonnée en x, [X(t)], est produit avec une forme prédéterminée et fixe ($X_R$) dans l'appareil de représentation (28, 29) lui-même,

c. après l'apparition du signal de démarrage (SP), on produit, en outre, et en fonction du temps, de ce signal de démarrage (SP), le signal de coordonnée en y, [Y(t)], qui est constitué, par intervalles de temps,

c1. de signaux ($Y_R$), de forme prédéterminée et fixe, qui sont produits dans l'appareil de représentation lui-même (28, 29) et qui se distinguent de la forme du signal de coordonnée en x, [X(t)], et

c2. d'intervalles entre ces signaux ($Y_R$), les signaux analogiques (A) étant introduits pendant ces intervalles, par l'intermédiaire de la ligne de transmission,

d. après l'apparition du signal de démarrage (SP) on produit, en plus, et en fonction du temps de ce signal de démarrage (SP), le signal de coordonnée en z, [Z(t)], qui est constitué par des intervalles de temps,

d1. de signaux de forme prédéterminée et fixe qui sont produits dans l'appareil de reproduction lui-même (28, 29), et qui se distinguent des formes des signaux de coordonnées en x et en y, [X(t)], [Y(t)], ainsi que

d2. d'intervalles entre ces signaux, les signaux de signe (CA) étant introduits pendant ces intervalles, par l'intermédiaire de la ligne de transmission, et lesdits intervalles et signaux du signal de coordonnée en z [Z(t)], étant décalés dans le temps par rapport aux intervalles et signaux du signal de coordonnée en y, [Y(t)].

2. Procédé selon la revendication 1, caractérisé par le fait que les signaux (Z = constant) et les intervalles du signal de coordonnée en z, [Z(t)], sont décalés dans le temps par rapport aux signaux ($Y_R$) et aux intervalles du signal de coordonnée en y, [Y(t)], de façon que pendant la durée (par exemple champs I et champs III selon la figure 1), dans laquelle sont produits dans l'appareil de reproduction (28, 29) lui-même, les signaux ($Y_R$) du signal de coordonnée en y, [Y(t)], avec leur forme prédéterminée et fixe, un intervalle est présent dans le signal de coordonnée en z, [Z(t)], pendant lequel les signaux de signe (CA) sont introduits par l'intermédiaire de la ligne de transmission.

3. Procédé selon la revendication 2, caractérisé par le fait que pendant la durée (par exemple champs II selon la figure 1), durant laquelle on produit dans l'appareil de représentation (28, 29) lui-même les signaux de forme fixe et prédéterminée (Z = constant), du signal de coordonnée en z, [Z(t)], un intervalle est présent dans le signal de coordonnée en y, [Y(t)], pendant lequel les signaux analogiques (A) sont introduits par l'intermédiaire de la ligne de transmission.

4. Procédé selon l'une des revendications 1 à 3, caractérisé par le fait que les signaux de coordonnées en x, en y et en z, [X(t)], [Y(t)], [Z(t)] sont produits pour un appareil de représentation en x, y, z (28, 29) qui est logé, dans un boîtier d'appareil commun (par exemple 179 selon la figure 12), avec les générateurs de signaux (23 à 27) pour les signaux qui ne sont pas produits dans l'appareil de représentation (28, 29) lui-même.

5. Procédé selon l'une des revendications 1 à 3, caractérisé par le fait que les signaux de coordonnées en x, en y et en z, [X(t)], [Y(t)], [Z(t)], sont produits pour un appareil de représentation en x, y, z (28, 29) qui est logé dans un premier boîtier d'appareil qui est disposé à une distance spatiale par rapport à un deuxième boîtier d'appareil dans lequel sont logés les générateurs de signaux (23 à 27) pour les signaux qui ne sont pas produits dans l'appareil de représentation (28, 29).

6. Procédé selon les revendications 4 et 5, caractérisé par le fait que les signaux de coordonnées x, y et z sont produits aussi bien pour un appareil de représentation en x, en y et en z, qui est logé, avec les générateurs de signaux (1 à 27) dans un boîtier d'appareil commun que pour un nombre supplémentaire quelconque d'autres appareils de représentation en x, y, z qui sont logés dans d'autres boîtiers d'appareils qui en sont éloignés spatialement.

7. Procédé selon l'une des revendications 4 à 6, caractérisé par le fait que tous les signaux qui ne sont pas produits dans un appareil de représentation en x, y, z lui-même, sont appliqués, en permanence, également à une sortie spéciale de signaux (Composite Video Output 30) sous la forme d'un train continu de signaux vidéo (Composite Video Output Signal).

8. Procédé selon la revendication 7, caractérisé par le fait que le train de signaux vidéo (Composite Video Signal) est susceptible d'être mémorisé par la sortie particulière de signaux (Composite Video Output 30) dans un bus (Composite Video Bus 64).

9. Procédé selon la revendication 7 ou 8, caractérisé par le fait que pour chaque appareil de représentation individuelle (28, 29) il est également prévu une entrée spéciale de signaux (Composite Video Input 31) dans lequel on peut mémoriser, à partir d'un bus (Composite Video Bus 64), des trains de vidéo signaux étrangers (Composite Video Signal).

10. Procédé selon la revendication 8 ou 9, caractérisé par le fait que les trains de signaux vidéo d'un nombre quelconque d'appareils de représentation (60 à 63) peuvent être transmis entre eux (circuit en chaîne de la figure 7), par l'intermédiaire d'un Composite Video Bus 64 commun.

11. Procédé selon la revendication 8 ou 9, caractérisé par le fait que les trains de signaux vidéo (CVB 1 à CVB n) d'un nombre quelconque d'appareils de représentation (84, 85, etc.) peuvent être retransmis, par respectivement un Composite Video Bus propre (90, 91, 92, etc.), à une centrale (83) qui produit un train central de signaux vidéo (CVC) (circuit en étoile de la figure 8).

12. Procédé selon la revendication 11, caractérisé par le fait que le train central de signaux vidéo (CVC) peut être renvoyé, par l'intermédiaire d'un Composite Video Bus central (132), aux autres appareils de représentation (84, 85, etc.).

13. Procédé selon l'une des revendications 1 à 12, caractérisé par le fait que le signal de démarrage (SP) est une impulsion de synchronisation qui déclenche, dans l'appareil de représentation (28, 29) avec l'un de ses deux flancs d'impulsion, le signal de coordonnée en x, [X(t)].

14. Procédé selon la revendication 13, caractérisé par le fait que l'impulsion de synchronisation déclenche le signal de coordonnée en x, [X(t)], avec son flanc arrière.

15. Procédé selon l'une des revendications 1 à 14, caractérisé par le fait que le signal de démarrage (SP) attaque dans l'appareil de représentation en x, y, z, un générateur de tension x (50) pour produire, en tant que signal de coordonnée en x, [X(t)], une tension x, ($X_R$), qui croit linéairement avec le temps.

16. Procédé selon l'une des revendications 1 à 15, caractérisé par le fait que le signal de coordonnée en y, [Y(t)], est produit avec un retard d'une durée prédéterminée ($t_1$–$t_0$), par rapport au signal de démarrage (SP).

17. Procédé selon la revendication 16, caractérisé par le fait que le signal de coordonnée en y, [Y(t)] est produit avec un retard d'une durée prédéterminée, par rapport à l'instant ($t_0$) auquel le signal de démarrage (SP) de forme impulsionnelle, déclenche avec l'un de ses deux flancs, dans l'appareil de représentation (28, 29), le signal de coordonnée, en x, [X(t)].

18. Procédé selon la revendication 17 ou 18, caractérisé par le fait que le signal de coordonnée en y, [Y(t)] est produit à un instant ($t_1$) qui se situe 80 µs après l'instant ($t_0$) auquel le signal de démarrage (SP) de forme impulsionnelle, déclenche, par son flanc postérieur, le signal de coordonnée x, ($Y_R$).

19. Procédé selon l'une des revendications 1 à 18, caractérisé par le fait que le signal de coordonnée en z, [Z(t)] est produit avec un retard de durée prédéterminé ($t_1$–$t_0$) par rapport à l'instant d'apparition du signal de démarrage (SP).

20. Procédé selon les revendications 16 et 19, caractérisé par le fait que cette durée prédéterminée correspond à la durée ($t_1$–$t_0$) dont est produit avec retard le signal de coordonnée y, [Y(t)].

21. Procédé selon l'une des revendications 1 à 20, caractérisé par le fait que les signaux ($Y=Y_R$) du signal de coordonnée en y, [Y(t)], qui sont produits dans l'appareil de représentation (28, 29) lui-même, sont des trames rapides en y.

22. Procédé selon la revendication 21, caractérisé par le fait que les trames rapides en y ($Y=Y_R$) sont, en liaison avec les signaux de balayage d'un générateur de signaux (45) qui est monté dans l'appareil de représentation (28, 29), la base pour la représentation de signes alphanumériques.

23. Procédé selon la revendication 22, caractérisé par le fait que les signaux de balayage du générateur de signaux (45) sont convertis en impulsions de balayage à spot allumé, au niveau d'un dispositif de balayage à spot allumé (49) de l'appareil de représentation en x, y et z.

24. Procédé selon la revendication 16, ou selon l'une des revendications 17 à 23 avec référence à la revendication 16, caractérisé par le fait que dans l'intervalle de temps ($t_1$–$t_0$) entre l'émission du signal de démarrage (SP) et la production du signal de coordonnée en y, [Y(t)], on transmet, par l'intermédiaire de la ligne de transmission, à l'appareil de représentation, un mot de configuration en y qui sert pour le positionnement correct du point de vue de l'emplacement, de la forme et du temps, de composantes en y, suivant un modèle.

25. Procédé selon la revendication 24, caractérisé par le fait que le modèle est une image de signal d'un premier appareil de représentation (par exemple 82 à l'intérieur de 63 ou 8 à l'intérieur de 24), qui peut être transmis à un second appareil de représentation qui en est éloigné spatialement (par exemple 79 dans 60 ou 96 dans 83), ou qui peut être retransmis à tout autre appareil de représentation.

26. Procédé selon l'une des revendications 1 à 25, caractérisé par le fait que les signaux analogiques (A) sont introduits dans la ligne de transmission de façon contiguë entre les signaux de signes (CA) (figure 1).

27. Procédé selon l'une des revendications 1 à 26, caractérisé par le fait que les signaux analogiques (A) sont des signaux physiologiques d'un patient, en particulier des signaux d'un électrocardiogramme, des signaux de la pression sanguine, des signaux respiratoires, des signaux de $CO_2$ ou similaires.

28. Procédé selon l'une des revendications 21 à 27, caractérisé par le fait que les signaux de signes (CA) sont des signaux numériques d'adressage pour un générateur de signaux (45) prévus dans l'appareil de représentation (28, 29), lesquels provoquent, en fonction de ces signaux d'adressage en coïncidence avec les trames rapides en y, des signaux de balayage en z au niveau d'un générateur de balayage à spot allumé (49).

29. Procédé selon la revendication 28, caractérisé par le fait que par l'attaque alternée de l'adressage d'un générateur de signes (45) par canal, dans une plage unique de signes (champs I et/ou III, dans la figure 1), un ou plusieurs signes, de préférence jusqu'à deux signes, sont simultanément associés à un signal analogique unique (A).

30. Dispositif pour produire des signaux de coordonnées en x, y et z pour représenter des signaux analogiques (A) et des signaux de signe (CA) dans différentes sections (I, II, III) dans l'appareil de représentation en x, y, z (28, 29) qui est relié à une ligne de transmission, du type dans lequel le signal de coordonnée en x détermine la déviation du temps sur l'écran d'image, donc son axe x, le signal de coordonnée en y détermine la hauteur de la déviation sur l'écran d'image, donc son axe y et le signal de coordonnée z détermine la luminosité de l'information représentée dans le système de coordonnées x, y, pour la mise en œuvre du procédé selon l'une des revendications 1 à 29, caractérisé par

a. un générateur de signal de démarrage (27) à l'extérieur de l'appareil de représentation (28, 29) pour la production répétitive d'un signal de démarrage (SP),

b. un générateur de tension x (50) à l'intérieur de l'appareil de représentation (28, 29) pour produire le signal de coordonnée en x, ($X_R$), respectivement en dépendance temporaire du signal de démarrage (SP),

c. un générateur de tension y (46) à l'intérieur de l'appareil de représentation (28, 29) pour produire le signal de coordonnée en y [Y(t)], qui est constitué, par intervalles de temps,

c1. de signaux ($Y_R$) de forme prédéterminée et fixe, qui sont produits dans l'appareil de représentation (28, 29) lui-même et qui se distinguent de la forme de signaux de coordonnées x [X(t)], et

c2. d'intervalles entre ces signaux ($Y_R$),

d. un générateur de tension z (45, 49) à l'intérieur de l'appareil de représentation (28, 29) pour produire le signal de coordonnée z, [Z(t)], qui, par intervalles de temps,

d1. est constitué de signaux de forme prédéterminée qui sont produits dans l'appareil de représentation (28, 29) lui-même et qui se distinguent des formes des signaux de coordonnées en x et en y, [X(t)], [Y(t)], ainsi que

d2. d'intervalles entre ces signaux,

e. un premier générateur de signaux à l'extérieur de l'appareil de représentation (28, 29) qui fournit les signaux analogiques (A),

f. un second générateur de signaux à l'extérieur de l'appareil de représentation (28, 29) qui fournit les signaux de signes (CA), et

g. un dispositif de commande de signaux (23, 24, 25),

g1. qui introduit les signaux analogiques (A) dans la représentation des signaux, pendant les intervalles (champs II selon la figure 1) entre les signaux ($Y_R$), produits dans l'appareil de représentation (28, 29) lui-même du signal de coordonnée en y, [Y(t)], et

g2. qui introduit les signaux de signes (CA) dans la représentation des signaux, dans les intervalles (champs I et III, selon la figure 1), qui sont décalés par rapport aux précédentes, entre les signaux, produits dans l'appareil de représentation lui-même (28, 29), du signal de coordonnée en z, [Z(t)].

31. Dispositif selon la revendication 30, caractérisé par le fait qu'entre les générateurs de signaux (1 à 24) qui transmettent les signaux qui ne sont pas produits dans l'appareil de représentation (28, 29) lui-même et les générateurs de signaux (44 à 50) qui produisent à l'intérieur de l'appareil de représentation, des signaux ($X_R$, $Y_R$, $Z=$constant, signaux de balayage à spots allumés pour les signes), est prévue une prise (51 à 53) pour les premiers signaux, laquelle prise mène à une sortie particulière de l'appareil (Composite Video Output 30).

32. Dispositif selon la revendication 31, caractérisé par le fait que la sortie particulière de l'appareil (Composite Video Output 30) mène à un bus (Composite Video Bus 64) dans lequel on peut introduire le train de signaux vidéo (Composite Video Signal) qui se présente à la sortie particulière de l'appareil (30).

33. Dispositif selon la revendication 32, caractérisé par le fait que dans le cas d'une configuration en étoile (figure 8) de plusieurs appareils individuels (84, 85, etc.) associés à des lits, avec une centrale permanente (43) qui produit un train de signaux vidéo central, tous les trains de signaux vidéo (CVB 1 à CVB n) des appareils individuels (84, 85, etc.) sont reliés, en étoile et respectivement par un bus propre à chaque appareil (Composite Video Bus 90, 91, 92, etc.) à la centrale (83), en sorte que celle-ci peut représenter sur un appareil central de représentation ou d'affichage en x, y, z (96), le train de signaux vidéo d'un ou de plusieurs des appareils individuels de la configuration en étoile.

34. Dispositif selon la revendication 33, caractérisé par le fait que dans la configuration en étoile (figure 8) un Composite Video Bus central (32) mène de la centrale commune (83) aux appareils individuels (84, 85, etc.) associés respectivement aux lits, en sorte que chaque appareil individuel associé à un lit peut prendre en charge le train vidéo central (CVC) et ne représenter, à la place du train de signaux propre sur l'appareil d'affichage en x, y et z (86, 87, etc.).

35. Dispositif selon la revendication 32, caractérisé par le fait que dans le cas d'une configuration d'appareils (figure 5), dans laquelle plusieurs appareils individuels (60 à 63) associés à des lits sont reliés en chaîne, sans centrale supplémentaire, les trains de signaux vidéo sont susceptibles d'être appliqués à un Composite Video Bus (64) qui est commun à tous les appareils individuels (60 à 63) associés respectivement à des lits, et qu'à partir du Composite Video Bus commun (64), l'un quelconque des appareils individuels (60, 61, 62, 63) ou plusieurs appareils individuels de ce genre, peut prendre en charge le train de signaux vidéo d'un quelconque autre appareil individuel et peut être reproduit, à la place du train de signaux vidéo qui lui est propre, sur l'appareil d'affichage propre en x, y et z (79, 80, 81 ou 82).

36. Dispositif selon la revendication 35, caractérisé par le fait qu'en plus du Composite Video Bus commun (64), tous les appareils individuels associés à des lits, et appartenant à la configuration en chaîne (figure 7) sont également reliés ou sont susceptibles d'être reliés entre eux par l'intermédiaire d'un bus d'alarme (65) qui accepte des signaux d'alarme et les retransmet, lesquels sont produits par un appareil individuel ou par plusieurs appareils individuels, lorsque les signaux d'un tel appareil individuel signalent au moins un état critique d'un patient qui y est relié.

37. Dispositif selon la revendication 35 ou 36, caractérisé par le fait que tous les appareils individuels (60 à 63) sont également reliés ou sont susceptibles d'être reliés par l'intermédiaire d'un bus commun de synchronisation (66), dans lequel des appareils individuels peuvent respectivement introduire le signal de démarrage (SP) pour le démarrage du signal de coordonnée en x, [X(t)].

38. Dispositif selon la revendication 37, caractérisé par le fait que tous les appareils individuels sont, pour la production de leurs signaux de coordonnées en x, [X(t)], attaqués simultanément par le signal de démarrage (SP) qui apparaît en premier parmi tous les signaux de démarrage mémorisés.

39. Dispositif selon l'une des revendications 32 à 38, caractérisé par le fait que chaque appareil individuel (60 à 63; 84, 85, etc.) d'une configuration d'appareils quelconques (figure 7; figure 8) possède une sortie particulière d'appareil (Composite Video Output 30) pour le train de signaux vidéo propre à l'appareil et une entrée particulière d'appareils (Composite Video Input 31) pour un train de signaux vidéo étranger à l'appareil.

40. Dispositif selon la revendication 39, caractérisé par le fait qu'à la sortie spéciale de l'appareil (30) et à l'entrée spéciale de l'appareil (31) de chacun des appareils individuels sont associés des interrupteurs (71 à 78; 133, 134, etc.) opérant en sens contraire l'un de l'autre, lesquels interrupteurs sont susceptibles d'être commandés de telle façon qu'au moins dans le cas auquel un appareil individuel doit recevoir son train de signaux vidéo dans le Composite Video Bus, l'interrupteur de sortie vidéo, alors que l'interrupteur d'entrée vidéo concerné est ouvert.

41. Dispositif selon la revendication 40, caractérisé par le fait que dans le cas d'un circuit en chaîne des appareils individuels (60 à 63), sans central propre (figure 7) et lors de l'émission d'une alarme à un appareil individuel (par exemple 63), l'interrupteur de sortie vidéo (74) de l'appareil individuel concerné est fermé, en sorte que le train de signaux vidéo de l'appareil individuel (63) qui émet l'alarme est introduit dans le Composite Video Bus (64).

42. Dispositif selon la revendication 40 ou 41, caractérisé par le fait qu'au moins pour le cas ou au moins l'un des appareils individuels (par exemple 63) d'un circuit en chaîne émet une alarme, seul l'interrupteur de sortie vidéo (74) de cet appareil individuel (63) est fermé, alors que les interrupteurs de sortie vidéo (71, 72, 73) de tous les autres appareils individuels sont ouverts.

X
I'
FIELD I
FIELD II
FIELD III
IV
XR
t0
t1
t2
t3
t4
t5
t
Y
YR
A
YR
Z
CA
CA

FIG. 1

FIELD III
FIELD II
FIELD I
123 ⁑HR
16,7 PS
9,2 PD
18,3 PS
13,7 PM
6,3 CO2
36 RR
R
B
ANALOG Y SIGNAL
ANALOG Y SIGNAL
CHARACTER

FIG. 2

FIELD III
FIELD II
FIELD I
40 /160
123 ⁑HR
12 / 20
8 / 10
16,7 PS
9,2 PD
15 / 20
10 / 15
18,3 PS
13,7 PM
4,5/ 9,5
15 / 60
6,3 CO2
36 RR
B
CHARACTER
ANALOG Y SIGNAL
CHARACTER

FIG. 3

FIELD I
FIELD II
FIELD III
RETRACE FIELD IV
I'
3μs
80μs
1280μs
1280μs
1280μs
960μs
CHARACTER DATA
ANALOG Y SIGNAL
ANALOG Y SIGNAL OR CHARACTER DATA
DELAYED DATA
SYNC-PULSE
t0
t1
t2
t3
t4
t5
t6
TIME FOR SWEEP CONFIGURATION WORD
T = 4880μs
COMPLETE SINGLE SWEEP


FIG. 4

MODULE CONTROL INTERFACE COPPLER
CENTRAL UNIT
UART
PREPROCESSOR AND MEMORY
DMA
SHARED MEMORY
ROM RAM
CENTRAL PROCESSOR
ALARM
TO ALARM BUS
MEMORY/ADDRESS
CENTRAL SHIFT REGISTER
DISPLAY MEMORY DYNAMIC RAM
CYCLE CONTROL TIMING COUNTER
COMPOSITE VIDEO PROCESSING UNIT
y
z
x
MONITOR
CRT
COMPOSITE VIDEO OUTPUT
TO COMPOSITE VIDEO BUS (CVB)
COMPOSITE VIDEO INPUT
FROM COMPOSITE VIDEO BUS (CVB)
KEYBOARD
SENSE
LED DISPLAY
DRIVE
LOUDSPEAKER
AMPLIFIER

FIG.5

16
25
MEMORY ADDRESS
24
DISPLAY MEMORY RAM
27
CYCLE CONTROL TIMING COUNTER
23
22
CENTRAL SHIFT-REGISTER
43
47
D
A
29
41
42
51
52
53
COMPOSITE VIDEO OUTPUT
30
COMPOSITE VIDEO INPUT
57
54
58
55
59
56
31
SWEEP CONFIGURATION REGENERATION
44
CHARACTER GENERATOR AND PROM
45
y-RAMP GENERATOR
46
48
VERTICAL PROCESSING
49
z-INTENSITY PROCESSING AND CONTROL
50
x-AXIS SWEEP GENERATION
y
z
x


FIG. 6

60
79
33
67
61
80
68
62
81
69
63
82
70
CVI
CVO
75
71
76
72
77
73
78
74
31
30
64
COMPOSITE
VIDEO BUS
(CVB)
65
ALARM BUS
66
SYNCH PULSE

FIG. 7

BEDSIDE UNITS
CENTRAL STATION
83
BEDSIDE DISPLAY B
87
85
134
CVC
CVB 2
CVB 2
132
MEMORY 4 CHANNELS
89
BEDSIDE DISPLAY A
86
84
133
CVC
CVB 1
CVB 1
MEMORY 4 CHANNELS
88
CENTRAL DISPLAY
96
129
112
CVC
CENTRAL PROCESSOR
98
131
130
110
108
128
132
MEMORY 4 CHANNELS
97
109
107
ADDRESS
DATA
DATA AND ADDRESS CONTROL
101
102
105
106
111
132
SELECTOR CVB
A
B
C
D
CH
ALARM MULTIPLEXER
100
AL1
AL2
ALn
95
93
94
104
CENTRAL MULTIPLEXER
103
CVB 1
CVB2
90
91
99
CVBn
92
RECORDER 1
116
RECORDER 2
117
118
125
126
127
122
123
124
113
114
115
S1
S2
S3
119
120
121
REC 1
REC 2
REC 3
SYNCH 1
SYNCH2
SYNCH 3

FIG. 8

FROM 166
91
90
CVB 1
CVB 2
CVB 3
CVB 4
135
111
ANALOG BUS CVB
105
104
103
102
A
B
C
D
136
106
113
114
115
CHARACTER DATA
REC 1
REC 2
REC 3
137
119
120
121
SYNCH 1
SYNCH 2
SYNCH 3
138
CVB5
CVB6
CVB7
CVB8
139
140
99
141
142
CVB13
CVB14
CVB15
CVB16
92
143
144
145
146


FIG. 9

DATA BUS
107, 108
ADDRESS BUS
109, 110
156
157
159
161
158
160
DATA WORD SHIFT REGISTER
151
147
148
149
150
WORD COUNTER
STROBE COUNTER
152
WORD COUNTER
155
153
CLOCK
4 CYCLE SYNCHRONISATION AND CONTROL
162
SYNCHRONIZER
154
106
163
START CHARACTER READ
164
165
TIMING FROM DISPLAY CONTROL
DMA REQUEST
A
102
B
103
C
104
D
105
CH
TO 99
TO 100
130
166
TO PROCESSOR TIMING AND DMA HANDSHAKE
DMA CONTROL ARBITRATOR AND MUX CONTROL ALARM MUX CONTROL
131

FIG. 10

SYNCH-PULSE
I'
FIELD I
FIELD II
FIELD III
RETRACE FIELD IV
SYNCH-PULSE
Y CONFIGURATION WORD
$t_0$
$t_1$
$t_2$
$t_3$
$t_4$
$t_5$
$t_6$=$t_0$
80µs
1280µs
CHARACTER
1280µs
ANALOG
1280µs
ANALOG
960µs
+
−
169
168
2µs
"0"
+0.75V
t
"1"
−1.0V
167
LBS
170 171 172 173 174 175
MSB
176
START BIT2 µs
TREND WORD
177
INDEX WORD
CH1
CH2
CH3
CH4
CH1'
CH2'
CH3'
CH4'
178
7
6
5
4
3
2
1
0

FIG. 11

179
181
191
192
1
187
186
194
2
190
182
3
193
189
195
4
185
188
193
180
184

FIG. 12

LIGHT EMITTER
LIGHT RECEIVER
MIXER STAGE
ANALOG DIGITAL CONVERTER
A
D
AUTO ZERO
SAMPLE AND HOLD
FILTER
FILTER
FILTER
CONTROL
MODULE AUXILIARY
8 BIT – REGISTER
8 BIT – SHIFT REGISTER
8 BIT – SHIFT REGISTER
AUXILIARY WORD
IDENTIFICATION MODUL
INTERN
KEY BOARD
E11
E12
1H
1A
1B
196
197
198
199
200
201
202
203
204
205
206
207
209
210
211
212
213
214
215
216
217
218
219
220
220a
220b
221
222
222a
223
223a
8'
11

FIG. 13

FIG. 14
MODULE
MODULE
MODULE
MODULE
AUX 8 BIT
8 BIT
6 BIT
CONTROL
CLOCK
MULTI-
PLEXER
MIXER
STAGE
RECIRCULATION
FOR HIGH SPEED
PROCESSOR

TO MODULE
CL1
CL2
CL3
CL4
CL5
CL6
CL7
CL8
CL9
CL10
CL11
CL12
CL13
CL14
AZ
CC1
CC2
CC3.
CC4
CC5
CC6
CC7
CC8
12.5µs
12 5µs
12µs
2µs
NEXT CYCLE BEGIN
BACK FROM MODULE
D1
D2
D3
D4
D5
D6
D7
D8
D9
D10
D11
D12
D13
D14
A1
A2
A3
A4
A5
A6
A7
A8
8µs
FIELD III
ST
FIELD II
FIELD I
123 XHR
B
R
16,7 PS
9,2 PD
18,3 PS
13,7 PM
6,3 CO2
36 RR

FIG. 15

FIG. 17

14
16 BIT ADDRESS
DMA ENABLE
CENTRAL PROCESSOR
DMA REQUEST
15
21
SHARED MEMORY RAM
8 BIT DATA
1 BIT READ/WRITE
MODULES
FROM
TO
12
18
13
275
16 BIT
BUFFER
19
UART
16
PRE-PROCESSOR
CLOCK
3 BIT
276
8 BIT
BUFFER
269
RAM
1 BIT
BUFFER
277
274
263
264
271
DECODE
DMA-ENABLE
268
265
270
266
272
DELAYED CLOCK
20
267
273

FIG. 16

FIXED MODE KEY
279
26
280
FIRED MODE
MEMORY ADDRESS
25
PAPER MODE
24
27
CYCLE-CONTROL TIMING
19
CENTRAL PROCESSOR
14
22
CENTRAL SHIFT REGISTER
278
PAPER MODE KEY
47
D
A
282
51
52
53
30
COMPOSITE VIDEO OUTPUT
54
55
56
284
57
58
59
COMPARATOR
U REF
283
SWEEP CONFIGURATION REGENERATION
44
CHARACTER GENERATOR AND PROM
45
46
Y-RAMP
48
VERTICAL PROCESSING
49
50
y
z
x
28
31
COMPOSITE VIDEO INPUT

FIG. 18